(19) Europäisches Patentamt
European Patent Office
Office européen des brevets

(11) EP 1 782 337 B1

(12) EUROPEAN PATENT SPECIFICATION

(45) Date of publication and mention of the grant of the patent:
**12.08.2015 Bulletin 2015/33**

(21) Application number: **05759253.7**

(22) Date of filing: **08.06.2005**

(51) Int Cl.:
***H04N 19/91*** *(2014.01)* ***H04N 19/93*** *(2014.01)*
***H03M 7/40*** *(2006.01)*

(86) International application number:
**PCT/US2005/020110**

(87) International publication number:
**WO 2006/001994 (05.01.2006 Gazette 2006/01)**

# (54) HYBRID VARIABLE LENGTH CODING FOR VIDEO COMPRESSION

HYBRIDE CODIERUNG MIT VARIABLER LÄNGE FÜR DIE VIDEOKOMPRIMIERUNG

CODAGE HYBRIDE A LONGUEUR VARIABLE POUR LA COMPRESSION DE DONNEES VIDEO

(84) Designated Contracting States:
**AT BE BG CH CY CZ DE DK EE ES FI FR GB GR HU IE IS IT LI LT LU MC NL PL PT RO SE SI SK TR**

(30) Priority:
**15.06.2004 US 869229**
**22.07.2004 US 898654**
**03.08.2004 US 910712**
**18.08.2004 US 922508**
**18.08.2004 US 922507**
**28.02.2005 US 69622**
**28.02.2005 US 69621**
**28.02.2005 US 69620**

(43) Date of publication of application:
**09.05.2007 Bulletin 2007/19**

(73) Proprietor: **Cisco Technology, Inc.**
**San Jose, CA 95134 (US)**

(72) Inventors:
- **CHEN, Wen-Hsiung**
  **Sunnyvale, CA 94087 (US)**
- **WU, Fang**
  **Pleasanton, CA 94566 (US)**
- **PELTON, Gregory, D.**
  **Raleigh, NC 27615 (US)**
- **TOEBES, John, A.**
  **Cary, NC 27513-2916 (US)**
- **ROSENFELD, Dov**
  **Oakland, CA 94618 (US)**

(74) Representative: **Kazi, Ilya**
**Mathys & Squire LLP**
**The Shard**
**32 London Bridge Street**
**London SE1 9SG (GB)**

(56) References cited:
**US-A- 4 821 119 US-A- 5 640 420**
**US-A- 5 751 232**

- **HARTUNG F ET AL: "Improved encoding of DCT coefficients for low bit-rate video coding using multiple VLC tables", IMAGE PROCESSING, 1999. ICIP 99. PROCEEDINGS. 1999 INTERNATIONAL CONFERENCE ON - KOBE, JAPAN 24-28 OCT. 1999, IEEE, PISCATAWAY, NJ, USA, vol. 2, 24 October 1999 (1999-10-24), pages 51-55, XP010368953, DOI: DOI:10.1109/ICIP.1999.822853 ISBN: 978-0-7803-5467-8**
- **APOSTOLOPOULOS J ET AL: "Position-dependent encoding", PROCEEDINGS OF THE INTERNATIONAL CONFERENCE ON ACOUSTICS, SPEECH, AND SIGNAL PROCESSING (ICASSP). SPEECH PROCESSING 1. ADELAIDE, APR. 19 - 22, 1994; [PROCEEDINGS OF THE INTERNATIONAL CONFERENCE ON ACOUSTICS, SPEECH, AND SIGNAL PROCESSING. (ICASSP)],, vol. v, 19 April 1994 (1994-04-19), pages V/573-V/576, XP010133681, DOI: DOI:10.1109/ICASSP.1994.389447 ISBN: 978-0-7803-1775-8**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



**(Cont. next page)**

- REED E C ET AL: "Efficient coding of DCT coefficients by joint position-dependent encoding", ACOUSTICS, SPEECH AND SIGNAL PROCESSING, 1998. PROCEEDINGS OF THE 1998 IEEE INTERNATIONAL CONFERENCE ON SEATTLE, WA, USA 12-15 MAY 1998, NEW YORK, NY, USA,IEEE, US, vol. 5, 12 May 1998 (1998-05-12), pages 2817-2820, XP010279416, DOI: DOI:10.1109/ICASSP.1998.678110 ISBN: 978-0-7803-4428-0
- JEON B ET AL: "Huffman coding of DCT coefficients using dynamic codeword assignment and adaptive codebook selection", SIGNAL PROCESSING. IMAGE COMMUNICATION, ELSEVIER SCIENCE PUBLISHERS, AMSTERDAM, NL, vol. 12, no. 3, 1 June 1998 (1998-06-01), pages 253-262, XP004122852, ISSN: 0923-5965, DOI: DOI: 10.1016/S0923-5965(97)00041-6

## Description

BACKGROUND

Two-dimensional variable length coding (2D-VLC) includes collecting or assuming the statistics of two dimensional block transform coefficient events that are each a run of the most likely-to-occur amplitude, e.g., 0, followed by another amplitude. The coding includes assigning variable length codes, e.g., optimal codes such as Huffman codes or Arithmetic codes, to each event. In the description herein, 0 is assumed to be the most likely-to-occur amplitude. The collecting or assuming statistics includes tracking the quantized non-zero-valued coefficient amplitudes and the number of zero-valued coefficients preceding the non-zero amplitude, i.e., tracking the runlengths of zeros which precedes any non-zero amplitude along a specified path, e.g., a zigzag scan path for a block of coefficients, e.g., an 8 by 8 or a 16 by 16 coefficient block. Table 1 below shows by example the statistics tabulated as a two dimensional table:

**Table 1: 2D-VLC statistics**

| | | Runlength of preceding 0's | | | | | | | | |
|---|---|---|---|---|---|---|---|---|---|---|
| | | 0 | 1 | 2 | 3 | 4 | 5 | 6 | . | . |
| | 1 | S10 | S11 | S12 | S13 | S14 | S15 | S16 | . | . |
| | 2 | S20 | S21 | S22 | S23 | S24 | S25 | S26 | . | . |
| | 3 | S30 | S31 | S32 | S33 | S34 | S35 | S36 | . | . |
| | 4 | S40 | S41 | S42 | S43 | S44 | S45 | S46 | . | . |
| Coeff. Amp. | 5 | S50 | S51 | S52 | S53 | S54 | S55 | S56 | . | . |
| | 6 | S60 | S61 | S62 | S63 | S64 | S65 | S66 | . | . |
| | 7 | S70 | S71 | S72 | 573 | S74 | 575 | S76 | . | . |
| | 8 | S80 | S81 | S82 | S83 | S84 | S85 | S86 | . | . |
| | 9 | S90 | S91 | S92 | S93 | S94 | S95 | S96 | . | . |
| | . | . | . | . | . | . | . | . | . | . |
| | . | . | . | . | . | . | . | . | . | . |
| | . | . | . | . | . | . | . | . | . | . |

In the table, Sij is the likelihood expressed, for example, as a relative number of occurrences of an amplitude of i, i=1, 2, ... occurring after a run of j 0's, j=0,1, 2, ....

A variable length code such as an optimal code is then assigned to each of the events that have an Sij above, with the most likely-to-occur element-typically S10 for the case of encoding a block of transform coefficients in transform coding-having the shortest number of bits, and the least occurring event coded using the longest number of bits. Table 2 below shows an example of a 2D-VLC table:

**Table 2: 2D-VLC codes**

| | | Runlength of preceding 0's | | | | | | | | |
|---|---|---|---|---|---|---|---|---|---|---|
| | | 0 | 1 | 2 | 3 | 4 | 5 | 6 | . | . |
| | 1 | C10 | C11 | C12 | C13 | C14 | C15 | C16 | . | . |
| | 2 | C20 | C21 | C22 | C23 | C24 | C25 | C26 | . | . |
| | 3 | C30 | C31 | C32 | C33 | C34 | C35 | C36 | . | . |
| | 4 | C40 | C41 | C42 | C43 | C44 | C45 | C46 | . | . |
| Coeff. Amp. | 5 | C50 | C51 | C52 | C53 | C54 | C55 | C56 | . | . |
| | 6 | C60 | C61 | C62 | C63 | C64 | C65 | C66 | . | . |
| | 7 | C70 | C71 | C72 | C73 | C74 | C75 | C76 | . | . |

(continued)

| | | Runlength of preceding 0's | | | | | | | | |
|---|---|---|---|---|---|---|---|---|---|---|
| | | 0 | 1 | 2 | 3 | 4 | 5 | 6 | . | . |
| | 8 | C80 | C81 | C82 | C83 | C84 | C85 | C86 | . | . |
| | 9 | C90 | C91 | C92 | C93 | C94 | C95 | C96 | . | . |
| | . | . | . | . | . | . | . | . | . | . |
| | . | . | . | . | . | . | . | . | . | . |
| | . | . | . | . | . | . | . | . | . | . |

where Cij is the codeword used to encode the event of the combination of j consecutive 0-valued coefficients followed by a single non-zero coefficient of amplitude i, j=0,1,... and i=1, 2, ....

2D-VLC is used in common transform coding methods such as JPEG, MPEG1, MPEG2, ITU-T-261, etc., as follows. For motion video, an image is divided into blocks, e.g., 8 by 8 or 16 by 16 blocks. Each image is classified as interframe or intraframe. Interframe images are typically post motion compensation. The blocks of the image are transformed and the transform coefficients are quantized. The quantized transform coefficients are then coded along a specified path according to a 2D-VLC table. Typically, interframe and intraframe images have different 2D-VLC tables. The DC component is typically separately encoded. Furthermore, the 2D-VLC table may be truncated so that the least frequently occurring events use an escape code followed by a fixed length code. A special "EOB" code is used to indicate the .end of a block when all remaining coefficients are zero.

Still images are similarly encoded, e.g., in the same manner as an intraframe image for motion video.

FIG. 1 shows how a table lookup may be used to implement a 2D-VLC scheme. Prior to the table look up, the runlength of zero amplitudes preceding any non-zero amplitude and the non-zero amplitude are determined. The table look up uses a 2D table for those likely events encoded using variable length encoding. An escape code together with a fixed length code is used for relatively less likely-to-occur combinations.

The advantage of 2D-VLC is that both the position of each non-zero-valued coefficient as indicated by the runlength, and the quantized amplitude value are coded simultaneously as a pair using one 2D-VLC table. This may result in shorter codes, i.e., codes that use fewer bits than using separate VLC tables for each non-zero-valued coefficient and for its amplitude.

Because of the widespread use of image coding, many patents have been issued on different forms of VLC. U.S. Patent 4,698,672 issued October 6, 1987 to Wen-hsiung Chen, one of the inventors of the present invention, for example described one form of a two-dimensional variable length coding method.

Extensions and variations to the common 2D-VLC method are known. For example, the ITU H.263 compression standard defines one such variation sometimes called three-dimensional VLC (3D-VLC). See PCT patent publication WO 9318616 published September 16, 1993 titled PICTURE DATA ENCODING METHOD and also the ITU-T H.263 standard. In 3D-VLC, each symbol ("event") is a triplet (LAST, RUN, LEVEL) that includes: LAST, a binary flag that indicates whether or not the current non-zero amplitude-value is the last non-zero coefficient in the block, RUN, the runlength of zero-value coefficients that precede the current non-zero amplitude, i.e., the number of zeroes since the last non-zero coefficient amplitude, and LEVEL, the current non-zero coefficient amplitude value. Thus, there is no need for a separate EOB codeword; whether or not the non-zero coefficient is the last one is incorporated into the event.

FIG. 2 shows how a table lookup may be used to implement 3D-VLC.

One deficiency of 2D-VLC is that every non-zero-valued coefficient needs to be accompanied by a runlength code to identify its position, in the form of the number of preceding zero-valued coefficients.

In block based transform coding, the inventors have observed that there often is a region, e.g., a low frequency region along the ordering in which non-zero-valued coefficients tend to cluster, i.e., there are often a number of consecutive non-zero-valued coefficients along the low frequency region of the pre-determined path. This may especially occur in intraframe coding and high bit rate interframe coding. Each one of a number of such consecutive non-zero-valued coefficients would require the same number of codewords representing the position and amplitude. That is, 2D-VLC requires a separate runlength code, e.g., C10, C20, C30...., etc., for each of the consecutive non-zero coefficients.

Thus there is a need in the art for a method that provides for efficiently encoding a sequence of consecutive non-zero coefficient values.

U.S. Patent Application No.10/342,537 to inventors Chen et al., filed January 15, 2003 and titled AN EXTENSION OF TWO-DIMENSIONAL VARIABLE LENGTH CODING FOR IMAGE COMPRESSION describes a method called the "Extended 2D-VLC Method" herein that includes encoding repetitions of some non-zero coefficient values. One variant of the Extended 2D-VLC method provides codes for all the possible amplitude variations of consecutive coefficients that follow a set of zero-valued coefficients. This effectively reduced the runlength to 1 for all cases. The difficulty of this approach is that there are enormous numbers of patterns that can be generated from the amplitudes of consecutive coefficients. For example, with 32 quantization levels as defined in many common video coding standards, there are in the order of $32^N$ patterns that can be generated from N consecutive coefficients. As such, in a practical implementation, only a limited number of the most likely-to-occur non-zero amplitude values, such as 1 and 2, and a limited number of lengths of consecutive non-zero-values, such as 3 or 4 consecutive values, are regrouped for pattern matching.

Furthermore, in coding, the inventors have noticed that while there may be a region where there are clusters of non-zero-valued coefficients, there is also likely to be a high frequency region where any non-zero-valued coefficients are likely to be scattered.

Thus, there still may be inefficiency in using the so-called "Extended 2D-VLC Method' in practice.

XP010368953 (IEEE publication titled "Improved Encoding of DCT Coefficients for Low Bit-rate Video Coding Using Multiple VLC Tables" by Hartung et al.) discloses that all current video compression standards employ motion compensated prediction and blockwise encoding of the prediction error using the discrete cosine transform (DCT). The DCT coefficients of each block are quantized, re-ordered into a vector, and each zero-run/coefficient pair is encoded as a single symbol, using a variable length code (VLC) table. It is also disclosed that the use of multiple instead of one VLC table yields significant bit-rate savings of the coded sequences, compared to H.263.

XP010133681 (IEEE publication titled "Position-dependent encoding" by Apostolopoulos J et al.) discloses a position-dependent encoding (PDE) approach for encoding the DCT coefficients. The method exploits the inherent differences in statistical properties of the run-lengths and amplitudes as a function of position.

XP010279416 (IEEE publication titled "Efficient coding of DCT coefficients by joint position-dependent encoding" by Reed et al.) discloses a joint position-dependent encoding (PDE) approach to encode the DCT coefficients, which exploits the variations in statistical properties of the runlengths and amplitudes as a function of position by introducing a set of 2-D codebooks in which each quantized DCT coefficient is assigned to one codebook in the set based on its location.

XP004122852 (IEEE publication titled "Huffman coding of DCT coefficients using dynamic codeword assignment and adaptive codebook selection" by Jeon et al.) discloses three Huffman coding methods in which pre-defined codebooks are effectively manipulated according to local symbol statistics. The first proposed method dynamically modifies the symbol-codeword association without rebuilding the Huffman tree itself. The encoder and decoder maintain identical symbol-codeword association by performing the same modifications to the Huffman table, thus eliminating extra transmission overhead. The second method adaptively selects a codebook from a set of given ones, which produces the minimum number of bits. The transmission overhead in this method is the codebook selection information, which is observed to be negligible compared with the bit saving attained. The third method combines the first and second methods to further improve compression efficiency.

US 5 640 420 A discloses a digital video signal encoder for coding a block of a digital video signal. The encoder first converts the block of the digital video signal into a set of quantized transform coefficients having a low and a high frequency zones and scans the set of quantized transform coefficients to produce a first and a second subsets of scanned coefficients. The scanned coefficients of the first and the second subsets are converted into a first and a second sets of one or more RLC codes, respectively. The digital video signal encoder performs the coding each RLC code of the first and the second sets to generate a first and a second sets of one or more variable length codewords.

Thus there still is a need in the art for a method that includes efficiently encoding runs of non-zero-valued coefficients that may occur in series of transform coefficients of blocks of an image.

One or more patents describing some existing 2D-VLC coding methods have recently been the subject of patent litigation. Thus, there is also a need in the art for alternate methods that can replace commonly used 2D-VLC methods that have been the subject of such litigation.

## SUMMARY

Aspects of the invention are disclosed in the appended independent claims. Optional, but advantageous features are disclosed in the appended dependent claims.

The description is written in terms of an ordered series of digital values that are quantized transform coefficients of a block of image data. Statistically, such quantized coefficients have a most likely-to-occur amplitude, and a next most likely-to-occur amplitude. The present description is written with zero-valued quantized coefficients being the most likely-to-occur, and quantized coefficients of value #1 being the next most likely-to-occur values. The invention is, in general, applicable to an ordered series of digital signals that each have an amplitude from a finite set of amplitudes consisting of the most likely-to-occur amplitude and at least one other amplitude.

In coding an ordered sequence of quantized transform coefficients of a block of image data, there may be a first region, e. g., a low frequency region along the ordering where there are clusters of non-zero-valued coefficients, and there is also likely to be a second region, e.g., a high frequency region where any non-zero-valued coefficients are likely to be scattered.

The Basic Hybrid VLC Method takes advantage of the nature of the distribution of the transform coefficients in the low frequency and high frequency regions. For example, the Basic Hybrid VLC Method takes into account the observed clustered nature of non-zero valued transform coefficients in the low frequency region and the relatively more scattered nature of transform coefficients in the high frequency region by using different runlength coding methods in the low frequency and high frequency regions. One embodiment of the Basic Hybrid VLC Method includes two independent types of coding schemes to code the quantized coefficients in the first and the second regions along the path. A boundary is established along the path to define two regions, e.g., a low frequency region and a high frequency region. In one version, the boundary is made adaptive to the video depending on one or more factors such as intraframe coding or interframe coding, standard definition television (SDTV) or high definition television (HDTV), complex scene or simple scene, high bit rate coding or low bit rate coding, and so forth. In one embodiment, the encoding of the quantized coefficients in the low frequency region includes coding the positions of consecutive non-zero-valued coefficients and the positions of consecutive zero-valued coefficients using a run-length coding method of a first type and a run-length coding method of a second type. The encoding further includes coding the amplitude values and sign of the non-zero-valued coefficients. In the high frequency region, in one embodiment, the encoding of coefficients in the high frequency region includes encoding the positions of either no consecutive zero-valued coefficients or runs of one or more consecutive zero-valued coefficients using a run-length coding method of a third type. The encoding further includes coding the amplitude values and sign of the non-zero-valued coefficients.

A single runlength code is used in the first region to encode the positions of runs of consecutive non-zero-valued coefficients. At most, five independent coding tables may be used: two runlength and a first amplitude table for low frequency coefficients and one runlength and a second amplitude table for the high frequency coefficients. The code lengths and code tables may then be shorter than that of typical 2D-VLC table.

Furthermore, when a relatively low breakpoint value is used, escape codes, common in 2D-VLC, may be avoided.

It should be noted that no overhead bits are needed to address the usage of the five independent tables.

In its general form, a method embodiment of the Basic Hybrid VLC Method is for processing an ordered series of digital signals that each have an amplitude from a finite set of amplitudes consisting of the most likely-to-occur amplitude and at least one other amplitude. The processing is to reduce the amount of data used to represent the digital signals and to form codewords such that the more likely-to-occur sequences of values of digital signals are represented by relatively short codewords and the less likely-to-occur sequences of values of digital signals are represented by relatively long codewords.

The general form of the Basic Hybrid VLC Method includes for each run of consecutive signals of value or values other than the most likely-to-occur value occurring in a first contiguous region defined by a breakpoint along the ordering of the series, encoding the runlength of the consecutive signals using a first runlength coding method, and forming a codeword that encodes the runlength using the first runlength coding method and further encodes the amplitudes and signs of each signal in the run, the breakpoint defining the first continuous region and a second contiguous region following the first contiguous region.

The general form of the Basic Hybrid VLC Method includes for each run of consecutive signals of the most likely-to-occur value occurring in the first region defined by the breakpoint, encoding the runlength of the consecutive signals of the most likely-to-occur value using a second runlength coding method.

The general form of the Basic Hybrid VLC Method further includes encoding the signals occurring in the second region defined by the breakpoint, the encoding using a second-region coding method, the second-region coding method including: identifying events that include runs of consecutive signals of the most likely-to-occur value in the second region and encoding said identified events in the second region using a third coding method.

The first, second, and third coding methods include variable length codes such that relatively short codewords are formed to represent sequences of values that are relatively more likely-to-occur, and relatively long codewords are formed to represent sequences of values that are relatively less likely-to-occur.

In one embodiment of the method, the series of digital signals is a series of quantized coefficients of a transformed block of image data, the transform such that the most likely-to-occur amplitude is 0.

An alternate coding method for the second, e.g., high frequency region along the ordering takes advantage of the very few amplitude values in the high frequency region, especially, for example, for low bit rate and interframe applications.

In one embodiment of the Extended Hybrid VLC Method, a coding method is used in the second region that takes into account that almost all non-zero-valued coefficients in the high frequency region are $\pm 1$. No amplitude coding is needed to encode runs of consecutive zeroes that end in a coefficient of amplitude 1. An exception (escape) code is included to encode those rare non-zero-valued coefficients that have values other than $\pm 1$.

In its general form, the Extended Hybrid VLC Method is for processing an ordered series of digital signals that each have an amplitude from a finite set of amplitudes consisting of the most likely-to-occur amplitude and at least one other amplitude. The processing is to reduce the amount of data used to represent the digital signals and to form codewords such that the more likely-to-occur sequences of values of digital signals are represented by relatively short codewords and the less likely-to-occur sequences of values of digital signals are represented by relatively long codewords.

The general form of the Extended Hybrid VLC Method includes for each run of consecutive signals of value or values other than the most likely-to-occur value occurring in a first contiguous region defined by a breakpoint along the ordering of the series, encoding the runlength of the consecutive signals using a first runlength coding method, and forming a codeword that encodes the runlength using the first runlength coding method and further encodes the amplitudes and signs of each signal in the run, the breakpoint defining the first continuous region and a second contiguous region following the first contiguous region.

The general form of the Extended Hybrid VLC Method further includes for each run of consecutive signals of the most likely-to-occur value occurring in the first region defined by the breakpoint, encoding the runlength of the consecutive signals of the most likely-to-occur value using a second runlength coding method.

The general form of the Extended Hybrid VLC Method further includes encoding the signals occurring in the second region defined by the breakpoint, the encoding using a second-region coding method, the second-region coding method including: identifying events that include runs of consecutive signals of the most likely-to-occur value in the second region that end in a value other than most likely-to-occur value, and encoding said identified events in the second region using a third coding method.

The first, second, and third coding methods include variable length codes such that relatively short codewords are formed to represent sequences of values that are relatively more likely-to-occur, and relatively long codewords are formed to represent sequences of values that are relatively less likely-to-occur.

In one embodiment of the method, the series of digital signals is a series of quantized coefficients of a transformed block of image data, the transform such that the most likely-to-occur amplitude is 0.

Although the Basic Hybrid VLC Method and the Extended Hybrid VLC Method provide potential improvement beyond using a single 2D-VLC technique for all quantized coefficients in a block, these methods may not take into account that the dynamic nature of the quantized block coefficients may not exactly match the model assumed in pre-determined coding techniques. By the dynamic nature we mean changed in block-to-block, and image to image in one or more of the cluster or scatter of the coefficients in a region, in whether a region has significant consecutive runs of non-zero-valued coefficients or mostly isolated non-zero-valued coefficients, in whether a region has coefficients with amplitudes dominated by a few values or even a single value, and so forth.

With this in mind, variants were developed applicable to quantized coefficients that include determining the nature of the coefficients themselves and using such determined nature information to select the coding method.

In one embodiment, the Multiple-Class VLC Method is for coding a series that includes a most likely-to-occur amplitude and at least one other amplitude. The Multiple-Class VLC Method is to reduce the amount of data used to represent the digital signals and to form codewords such that the more likely-to-occur values or sequences of values of digital signals are represented by relatively short codewords and the less likely-to-occur values or sequences of values of digital signals are represented by relatively long codewords.

In most applications, the series is of quantized transform coefficients of an image block. The most likely-to-occur value is usually 0, and the most likely-to-occur non-zero amplitude is usually 1.

In one embodiment, the Multiple-Class VLC Method includes classifying the series into a particular class of a plurality of classes according to the distribution of amplitudes of the digital signals, each class having a corresponding coding process of forming the codewords for the series. For the particular class of the series, the method includes applying the coding process corresponding to the class to form a set of codewords of the series. The method further includes adding an indication to the formed codewords to indicate the particular class.

In one implementation, the transformed block of image data includes a DC term, and the DC term is separately encoded, such that the series of digital signals is a set of non-DC quantized coefficients of a transformed block of image data.

In one embodiment, the classifying uses the series of coefficients. In a particular version, the classifying selects the class according to which corresponding coding process produces the most compressed bitstream.

The first region method first introduced in the Basic Hybrid VLC Method and the Extended Hybrid VLC Method, codes the consecutive non-zero-valued coefficients and the consecutive zero-valued coefficients in the low frequency region alternatively using two independent one-dimensional variable length coding methods, e.g., using two independent one-dimensional VLC tables. Thus, the position and amplitude of quantized transform coefficients are coded separately.

An observation was made that an improvement in coding efficiency can further be achieved by pairing the consecutive non-zero-valued coefficients and zero-valued coefficients in the first region as a pair and applying a single two-dimensional table to code the pair.

The 2-D Non-Zero/Zero Cluster VLC Method was introduced to improve the coding efficiency, for example for the low frequency region, and in other embodiments for more than the low frequency region. In one embodiment, the 2-D Non-Zero/Zero Cluster VLC Method includes, in a first contiguous region, identifying events that each include a run of zero-valued coefficients preceding a run of one or more non-zero-valued coefficients. The method includes for each such event, jointly encoding the runlengths of the preceding run of zero-valued coefficients and the following run of non-zero-valued coefficients with a codeword, such that for at least some events, relatively more likely-to-occur pairs of runlengths are encoded by a shorter codeword than relatively less likely-to-occur runlengths. The method further includes encoding each amplitude in the run of consecutive non-zero-valued coefficients, and encoding the signs of such coefficients. In an improved variation, each event includes a single zero-valued coefficient following the run of non-zero-valued coefficients.

In each of the 2-D Non-Zero/Zero Cluster VLC Method, the Basic Hybrid VLC Method, and the Extended Hybrid VLC Method, various variable length coding methods are introduced to encode the relative positions of the clustered or non-clustered transform coefficients. After each such encoding, a coding of the magnitude of each non-zero valued coefficient is included, as is a sign bit (+ or -).

It was also noticed that encoding the amplitudes takes up a significant part of the code in VLC coding of clusters of non-zero-valued coefficients. It was observed that, at least in theory, an improvement in amplitude code can be achieved by introducing a single multi-dimensional code, say an n-dimensional code, n an integer greater than 1, to encode n consecutive clustered non-zero coefficients, instead of using n separate one dimensional codes. With this in minds, another variant of hybrid coding was developed.

One embodiment of the Basic Multi-Dimensional Amplitude VLC Method includes, in a first region, identifying events that each includes a run of one or more non-zero-valued coefficients, and for each such event, encoding the event with a codeword such that for at least some events, relatively more likely-to-occur events are encoded by a shorter codeword than relatively less likely-to-occur events, and for each identified event, jointly encoding a plurality of consecutive values in the run of consecutive non-zero-valued coefficients, the joint encoding according to an amplitude coding method. The method is such that relatively short codewords are formed to represent values or sequences of values that are relatively more likely-to-occur, and relatively long codewords are formed to represent values or sequences of values that are relatively less likely-to-occur. The method is applicable to encoding a region in the series where there is likely to be a cluster of non-zero-valued coefficients.

While the Basic Multi-Dimensional Amplitude VLC Method appears to improve the overall coding efficiency, it was observed that the size of the n-dimensional table used for the joint encoding of n consecutive non-zero amplitude values can become rather large for a large "n." As a result, in practice, the size of n has to be limited to a low number of consecutive non-zero-amplitude values, such as 1, 2 and 3 for practical implementation.

Rather than using a single multidimensional coding table for a cluster of a number, say n consecutive non-zero-valued coefficients, in one embodiment of the Multi-Table Amplitude VLC Method, events are identified within the cluster that each include a run of consecutive amplitude-1 coefficients, followed by a single coefficient of amplitude greater than 1. Included are events of only a single coefficient of amplitude greater than 1 and runs of only amplitude 1. For each event, a codeword is assigned to the runlength of the preceding run of amplitude-1 coefficients combined with the amplitude of the ending coefficient. A two-dimensional coding table is used for each cluster length n, so that the multidimensional table of the Basic Multi-Dimensional Amplitude VLC Method is replaced by a number of increasingly large 2-D coding tables. The value of n can be as large as the position of the breakpoint.

The Multi-Table Amplitude VLC Method takes advantage of the observation that in the low frequency region of the sequence of transform coefficients, there is a dominance of amplitude-1 coefficients in the clusters of non-zero coefficients.

The inventions described in the Basic Hybrid VLC Method and the 2-D Non-Zero/Zero Cluster VLC Method introduced various variable length coding techniques to take care of only the positions of the clustered or scattered transform coefficients. The inventions described in the Basic Multi-Dimensional Amplitude VLC Method and in the Multi-Table Amplitude VLC Method introduce methods of encoding the amplitudes of the clusters.

With the above methods, what was still needed is a variant that combines encoding the positions of transform coefficients and the amplitude of transform coefficients.

In one embodiment, the Joint Position and Amplitude VLC Method includes, for a first contiguous region in the series, identifying clusters that each includes one or more consecutive signals having any amplitude other than the most likely-to-occur amplitude, and any intervening runs of consecutive coefficients having the most likely-to-occur value. The method further includes, for each identified cluster of signals having any amplitude other than the most likely-to-occur amplitude, identifying one or more position events to define the relative positions and runlengths of the of the identified cluster of signals having any amplitude other than the most likely-to-occur amplitude, and any intervening runs of consecutive coefficients having the most likely-to-occur value. The method further includes for each identified cluster of signals having any amplitude other than the most likely-to-occur amplitude, identifying one or more amplitude events that define amplitudes of the consecutive coefficients having amplitude other than the most likely-to-occur amplitude. The method further includes jointly encoding the identified position event or events and the identified amplitude event or events to produce a codeword for the cluster such that relatively short codewords are used to represent amplitude clusters that are more likely-to-occur, and relatively long codewords are used to represent amplitude clusters that are relatively less likely-to-occur.

In one embodiment described, the ordered series of digital signals is a series of quantized coefficients of a transformed block of image data. The transform is such that the most likely-to-occur amplitude is 0, and the next most likely-to-occur amplitude is 1.

In the case of quantized coefficients, the Joint Position and Amplitude VLC Method includes identifying clusters of at least one non-zero-valued coefficient, and for each such cluster, identifying at least one position event to identify the relative position and runlength of the cluster of non-zero coefficients, and identifying at least one amplitude event to define the non-zero amplitudes in the cluster of non-zero coefficients. The method further includes jointly coding the identified position event(s) and the identified amplitude event(s) such that relatively short codewords are formed to represent values or sequences of values that are relatively more likely-to-occur, and relatively long codewords are formed to represent values or sequences of values that are relatively less likely-to-occur. The method is applicable to encoding a region in the series where there is likely to be a cluster of non-zero-valued coefficients.

Some embodiments described herein use the position events that are as coded in the 2-D Non-Zero/Zero Cluster VLC Method. Some embodiments further use non-zero amplitudes as the amplitudes events as in the Basic Multi-Dimensional Amplitude VLC Method. Other embodiments identify amplitude events in the same manner as the Multi-Table Amplitude VLC Method. Yet other embodiments use the amplitude events of Basic Multi-Dimensional Amplitude VLC Method for some cluster lengths, and the amplitude events of the Multi-Table Amplitude VLC Method for other cluster lengths.

In each of these methods, a breakpoint is defined as the boundary between the low frequency and high frequency regions. The optimal breakpoint within the frequency spectrum of the transform used in the encoding varies from block to block and picture to picture. Pre-defined breakpoints may be used by pre-determining typical breakpoints by running experiments collecting statistics on a set of typical block coefficients. Typically, different breakpoints are determined for high resolution or high quality still image coding vs. low resolution or low quality still image coding; intraframe coding vs. interframe coding; high bit rate coding methods vs. low bit rate coding methods; DCT-based transform coding methods vs. non-DCT transform coding methods; and so forth.

Although a predetermined breakpoint can provide a satisfactory coding performance it is by no means optimum. The results of various experiments indicated that the performance of a hybrid coder can further be improved by using an optimal breakpoint. The improvement can be as large as 25% of the improvement that has been achieved using a pre-determined breakpoint.

Thus a method was invented to determine the optimal or near optimal breakpoint for the purpose of defining a first (low-frequency) region and a second (high frequency) region for hybrid coding according to one or another of the above-mentioned and herein described hybrid coding methods.

One method to find the optimal breakpoint, denoted y by N herein, is to conduct an exhaustive search over all possible breakpoints, that is, for example, to encode the picture 63 times for an 8x8 block transform, trying different breakpoints, i.e., trying N=1, 2, ..., 63. Comparing the length of the resulting codewords for the block provides the best N and also the codewords for such an optimal N. Such an approach is very time consuming, and thus not likely to be practical.

Thus there is a need for a more efficient method to determine the optimal or near optimal breakpoint.

One embodiment of the Adaptive Breakpoint Method includes establishing a breakpoint along the ordering of the series to define a first contiguous region and a second contiguous region, such that clusters of consecutive signals of any value other than the most likely-to-occur value occur mostly in the first contiguous region, the establishing using statistics calculated from at least a subset of the plurality, the statistics being of where along the ordering of the plurality of the series signals of any value other than the most likely-to-occur value occur in clusters of consecutive signals of any value other than the most likely-to-occur value. For each series in the plurality, the signals in the first region are encoded using a first region encoding method, and the signals in the second region are encoded using a second region encoding method. The first region and second region encoding methods include variable length codes such that relatively short codewords are formed to represent sequences of values that are relatively more likely-to-occur, and relatively long codewords are formed to represent sequences of values that are relatively less likely-to-occur.

In the description, each series of digital signals is a series of quantized coefficients of a transformed block of image data of an image, the transform such that the most likely-to-occur amplitude is 0.

In one version, the series is divided into more than two regions by the breakpoint and an additional breakpoint for each region in addition to the second region, and in this version, the signals occurring in each additional region defined by the corresponding additional breakpoint are encoded using a corresponding coding method different from the coding methods used in other regions.

In some embodiments, the establishing of the breakpoint includes counting, for each point along the ordering, the number of series in which the coefficient at the point is in a cluster.

In one embodiment, the establishing of the breakpoint includes determining a threshold point such that most coefficients that are in a cluster occur at a point prior to the threshold point, and searching for a near optimal breakpoint only up to the threshold point. As an example, the threshold point is the particular point along the ordering where the count of the number of series that have a coefficient at the point falls below a pre-selected fraction of the total number of series.

In one version the establishing of the near optimal breakpoint includes determining the length of the coded data for the plurality of series for breakpoints up to the threshold point, and selecting the breakpoint that produced the shortest coded data.

In another version, the establishing of the breakpoint includes determining the point along the ordering up to the threshold point wherein the slope in the count of the number of non-zero coefficients that are in a cluster is the maximum.

Other aspects, features, and variations will be clear from the Detailed Description and Claims.

BRIEF DESCRIPTION OF THE DRAWINGS

FIG. 1 shows how a prior art 2-D VLC method may be implemented by a table look-up.

FIG. 2 shows how a common prior art variation of 2-D VLC called 3D-VLC may be implemented by a table look-up.

FIG. 3 shows a simplified flowchart of one embodiment of a hybrid coding method.

FIG. 4 shows a flow chart of one embodiment of a hybrid variable length coding (VLC) method that includes in a first region coding the positions and lengths of clusters of non-zero coefficients and of zero-valued coefficients, and further that includes coding the amplitudes of the coefficients in the clusters of non-zero-valued coefficients.

FIG. 5 shows a simplified block diagram of one embodiment of an apparatus to code a series of quantized transform coefficients.

FIG. 6 shows a decoding apparatus according to an embodiment of the invention.

FIG. 7 shows a simplified block diagram of one embodiment of an apparatus to code a series of quantized transform coefficients.

FIG. 8 shows a decoding apparatus according to an embodiment of the invention.

FIG. 9 shows a coding apparatus that includes a processing system and a memory according to an embodiment of the invention.

FIG. 10 shows a decoding apparatus that includes a processing system and a memory according to an embodiment of the invention.

FIG. 11 shows a flow chart of a method embodiment of the invention.

FIG. 12 shows a flow chart of a method embodiment that includes as part of the classifying, coding the blocks by each corresponding coding process and comparing the results to select the method that provides the best compression.

FIG. 13 shows a flowchart of one implementation of the embodiment of FIG. 12 in which the applying of the corresponding encoding processes is carried out sequentially on the series of coefficients.

FIG. 14 shows a flowchart of an alternate implementation of the embodiment of FIG. 12 in which the applying of the corresponding encoding processes is carried out in parallel on the series of coefficients.

FIG. 15 shows a table of statistics of events according to a prior art 2-D VLC method.

FIG. 16 shows a code table for coding events according to a prior art 2-D VLC method.

FIGS. 17A-17D show tables that each show examples of events according to an embodiment of the invention. In the patterns, an "x" indicates a non-zero value.

FIG. 18 shows a table of statistics collected for events of runs of none or more zero-valued-coefficients followed by a run of non-zero-valued coefficients according to an embodiment of the invention.

FIG. 19 shows a table of variable length codes for events of runs of none or more zero-valued-coefficients followed by a run of non-zero-valued coefficients according to an embodiment of the invention.

FIGS. 20A-20F show tables that each show examples of events according to an improved embodiment of the invention in which events of runs of zero-valued coefficients followed by runs of non-zero-valued coefficients include a following zero-valued coefficient. The events are truncated to cover no more than 12 consecutive coefficients.

FIG. 21 shows a table of statistics collected or assumed for events of runs of none or more zero-valued-coefficients followed by a run of non-zero-valued coefficients followed by a single zero-valued-coefficient according to an embodiment of the invention.

FIG. 22 shows a table of variable length codes for events of runs of none or more zero-valued-coefficients followed by a run of non-zero-valued coefficients followed by a single zero-valued-coefficient according to an embodiment of the invention.

FIG. 23 shows a table of actual statistics for a sample image for a first region with a breakpoint of 12 that forms a soft boundary. Note that the event skip is the same as the event R(12,0).

FIG. 24 shows a flow chart of one embodiment of a hybrid variable length coding (VLC) method which does not include multidimensional amplitude encoding of a plurality of amplitudes in a run of non-zero-valued coefficients.

FIG. 25 shows a flow chart of one embodiment of a hybrid variable length coding (VLC) method, which includes joint multidimensional encoding of a plurality of amplitudes in a run of non-zero-valued coefficients.

FIGS. 26A, 26B, and 26C respectively show a one-dimensional amplitude code table for a single amplitude, a two-dimensional amplitude code table for the amplitudes two consecutive coefficients, and a three-dimensional amplitude code table for the amplitudes three consecutive coefficients, according to an aspect of the invention.

FIG. 26D shows a three-dimensional amplitude code table similar to FIG. 26C using an alternate arrangement of coefficients amplitudes for each 2D table.

FIG. 27 shows a flow chart of one embodiment of a hybrid variable length coding (VLC) method, which includes encoding of a plurality of amplitudes in a run of non-zero-valued coefficients according to an aspect of the invention.

FIG. 28 shows a table of relative likelihoods of occurrences for runs of 1's within a run of a number, denoted n, of non-zero amplitude coefficients.

FIG. 29 shows a code table for events of runs of 1 ending on an amplitude greater than 1 in a consecutive run of a number, n of consecutive non-zero amplitude coefficients.

FIG. 30 shows a sequence of code tables for events identified in different lengths of clusters of consecutive non-zero-valued coefficients, according to an aspect of the invention.

FIG. 31 shows a flow chart of one embodiment of a hybrid variable length coding (VLC) method, which includes encoding the positions and lengths of clusters of non-zero-valued coefficients and of zero-valued coefficients, encoding the amplitudes in the runs of non-zero-valued coefficients, and, according to an aspect of the invention, coding the positions and the amplitudes using a joint coding table of the position codes and the amplitude codes.

FIG. 32 shows a flow chart of one embodiment of a method of establishing a near optimal breakpoint according to one or more aspects of the present invention.

## DETAILED DESCRIPTION

Described herein are a variable length coding method and an apparatus for coding transform domain coefficients as encountered in video coding. The coding method is expected to be at least as good as traditional 2D-VLC coding. It can potentially be used to replace existing 2D-VLC coding methods. Also described herein are a decoding method for the variable length coding method and an apparatus for decoding the coded transform domain coefficients as encountered in video coding.

In general, the present invention relates to encoding an ordered series of digital signals that each has an amplitude from a finite set of amplitude values. Each signal may also have a sign, i.e., be either positive or negative). The set of amplitude values include one most likely-to-occur amplitude and at least one other amplitude. The application discussed herein is for the ordered series of signals being the ordered set of quantized coefficient values of a block of image data after transformation by a transform such as the DCT or some other common transform, then after quantization to a finite number of values, and then after ordering along a predefined path, e.g., a zigzag path. The ordering of the series is typically in order of increasing spatial frequency. In most image applications, the most likely-to-occur value, e.g., the most frequently occurring value is typically 0.

We have observed that there is an additional statistic that may have been overlooked in prior art variable length coding methods. Non-zero-valued quantized transform coefficients along the path tend to cluster more in the low frequency region and are more scattered in the high frequency region. That is, runs of non-zero values are more likely-to-occur in lower spatial frequencies than in higher spatial frequencies.

One aspect of the invention is that a breakpoint is used along the ordering of the series to define a first region, e.g., the region before the breakpoint, and a second region, e.g., the region after the breakpoint. Thus, for example, for an 8 by 8 block, there may be a breakpoint between 21 and 22, such that the first 21 coefficients in the ordered series are in the first region, and the last 43 coefficients starting with the 22nd coefficient in the ordered series are in the second region. The breakpoint itself may also be in the region. Thus, for example, for an 8 by 8 block, there may be a breakpoint at 22, such that the first 21 coefficients in the ordered series are in the first region, and the last 43 coefficient starting with the 22nd coefficient in the ordered series are in the second region. Furthermore, the breakpoint may define how the regions are formed, but may not correspond to the actual boundary between the first and second region. See below for a description of a soft vs. a hard boundary defined by the same breakpoint.

FIG. 3 shows a simplified flowchart of a hybrid coding method 300. In 301, a breakpoint is provided to define the first and second region along the ordering of the coefficients. One aspect of the invention is the selection of the breakpoint.

Another aspect of the invention is how the two regions defined by the breakpoint are coded. In 303, a first-region coding method is used to encode data that occurs in the first region, while in 305, another method, a second region coding method, is used to encode data in the second region.

In one version, the breakpoint defines a hard boundary between the first and second region, so that, for example, a sequence of consecutive non-zero-valued coefficients that crosses the breakpoint is regarded as a first sequence up to the breakpoint, and a second sequence after the breakpoint. In another version, the breakpoint defines a boundary that is soft, so that any sequence of consecutive values, e.g., consecutive zero-values, or consecutive non-zero-values that starts prior to the breakpoint and crosses the breakpoint is regarded as a sequence that occurs in the first region. For such a block that includes such a sequence that crosses the breakpoint, the effective boundary starts after the end of the sequence, so that the effective boundary defined by a breakpoint may change from sequence to sequence.

*The Basic Hybrid VLC Method*

Non-zero valued coefficients in the first region are likely to be clustered. Thus, runs are likely to appear. One aspect of first region coding method according to the Basic Hybrid VLC Method encodes each run of non-zero valued coefficients-in general, each run of coefficients having values other than the most likely-to-occur value. One aspect of the Basic Hybrid VLC Method for the first region encodes the runlength of the run using a first runlength encoding method, and also encodes the sequence of amplitudes in the run, including any signs. Each run of zero-valued coefficients-in general, each run of coefficients having the most likely-to-occur value-is encoded using a second runlength coding method. Thus, two types of runlength codes are alternately used in the first region.

FIG. 4 shows a flow chart of one embodiment of a hybrid variable length coding (VLC) method 400 that includes in 301 providing a breakpoint along the ordering of the series to define a first, e.g., low frequency region wherein non-zero-coefficients are likely to be clustered, and a second, e.g., high frequency region where non-zero coefficients are likely to be scattered, and in the version shown, likely to be dominated by amplitude-1 coefficients.

In 403, events are recognized, including events of the first kind being runs of consecutive non-zero-valued coefficients (called "clusters")and events of the second kind being runs of consecutive zero-valued coefficients, and each are identified. In one embodiment, in 405, different encoding methods are provided for encoding the positions of the zero and non-zero-valued coefficients. The Basic Hybrid VLC Method provides separate codewords for the runlengths of the zero-value coefficients, and for the runlengths of the clusters of non-zero-valued coefficients. The codes include variable length codes determined using assumed or actual statistics. Thus, step 403 identifies the runlengths of the consecutive zero-valued coefficients and of the non-zero-valued coefficients, and 405 encodes the runlengths of consecutive non-zero-values, and consecutive zero-values with a first and a second runlength coding method, respectively.

In 407, the amplitudes in each run of non-zero-amplitudes in the run of non-zeroes in the first region are encoded using a first amplitude coding method. In an embodiment of the Basic Hybrid VLC Method, each amplitude is separately encoded using the first amplitude coding method, e.g., using a variable length code obtained using a code table.

Denote by r(n) an identified run of a number, denoted n, of consecutive non-zero coefficients, and r'(z) an identified run of a number, denoted z of consecutive zero-valued coefficients in the first region, n,z=1,2,.... Consider a single event denoted by r(n), denote each of the non-zero amplitudes in r(n) by m(1), m(2), ..., m(n). Denote by C(n) the variable length codeword for the run length of non-zero-valued coefficients in the event r(n), n=1, 2, ... using the first runlength coding method, and denote by C'(z) the variable length codeword for the run length of zero-valued coefficients in the event r'(z), z=1, 2, ...using the second runlength coding method. Denote by A(m) the amplitude encoding of an amplitude m, m=1, 2, ..., in the run r(n) of non-zero-valued coefficients; and denote by S(1), S(s), ..., the sign bits for the first, second, ..., n'th non-zero-valued coefficient in r(n). Then according to embodiments described in the Basic Hybrid VLC Method, the encoding of the event and the corresponding non-zero amplitudes is:

$$C(n)+A(m(1))+S(1)+A(m(2))+S(2)+\ldots+A(m(n))+S(n)+C'(z),$$

where +denoted concatenation.

### The first region coding in the Basic Hybrid VLC Method

In more detail, in one embodiment, in 405, the codewords for the runs of consecutive coefficients in the first region start with a codeword of the first coding method and alternate between the first coding method and the second coding method. To provide for the case that the first run encountered is a run of zeroes, one of the codewords of the first coding method is a particular codeword to indicate that indeed the first run encountered is a run of zeroes such that a codewords of the second method follows the particular codeword of the first method.

Table 3 and Table 4 below respectively show two runlength code tables for runs of n consecutive non-zero-valued coefficients and runs of consecutive zero-valued coefficients, respectively, where C(n) and C'(z), respectively denote the codes for runs of a number, denoted n, of consecutive non-zero-valued coefficients and a number, denoted z, of consecutive zero-valued coefficients, respectively, using the first and second coding methods, where z is the runlength: z=1, 2, ....

Table 3

| Run length | 1 | 2 | 3 | 4 | 5 | 6 | . |
|---|---|---|---|---|---|---|---|
| Code | C(1) | C(2) | C(3) | C(4) | C(5) | C(6) | . |

Table 4

| Run length | 1 | 2 | 3 | 4 | 5 | 6 | . |
|---|---|---|---|---|---|---|---|
| Code | C'(1) | C'(2) | C'(3) | C'(4) | C'(5) | C'(6) | . |

As an example, assuming the ordered series of quantized coefficients along the ordering path in the first frequency region starts with:

$$2\ 3\ 2\ {-1}\ 0\ 1\ 2\ 0\ 0\ 1\ {-1}\ 1\ 0\ 0\ \ldots$$

To determine the runlengths, this series may be written as:

$$x\ x\ x\ x\ 0\ x\ x\ 0\ 0\ x\ x\ x\ 0\ 0\ \ldots$$

where x represents any non-zero-valued coefficient and 0 represents a zero-valued coefficient.

Denote by r(n)the run of n consecutive non-zero coefficients, and r'(z) the run of z consecutive zero-valued coefficients. The ordered sequence of the example then starts with:

$$r(4)\ r'(1)\ r(2)\ r'(2)\ r(3)\ r'(2)\ ...$$

The result of encoding the runlengths but not amplitudes of this pattern can then be written as:

$$C(4)\ C'(1)\ C(2)\ C'(2)\ C(3)\ C'(2)\ ...$$

In 407, to complete the first-region coding method, included with the codeword of each run of non-zero-valued coefficients are codewords for each amplitude in the run, and further bits for the sign of each coefficient for transforms whose coefficients can be positive or negative, e.g., the commonly used DCT transform. In one embodiment, the amplitudes are each encoded using a variable length code, and the signs are each encoded using a sign bit. Denote by A(i), i=1,2,3,... the variable length amplitude codes for amplitudes i=1, 2, ...respectively, denote by $S_+$ and $S_-$ the sign bit codes for positive and negative coefficients, respectively, and denote concatenation by +. The example sequence above is then encoded as follows:

$$[C(4) + A(2) + S_+ + A(3) + S_+ + A(2) + S_+ + A(1) + S_-] + C'(1) +$$
$$[C(2) + A(1) + S_+ + A(2) + S_+] + C'(2) +$$
$$[C(3) + A(1) + S_+ + A(1) + S_- + A(1) + S_+] + C'(2)\ ...$$

In one embodiment, it is assumed that the series starts with a run of one or more non-zero-valued coefficients. Therefore, the first codeword is always a codeword from the first runlength coding method. A code is included for when the series starts with a run of one or more zeros to indicate that the first code used is the code for runs of zeroes. In such an embodiment, the DC component is separately sent, such that the first coefficient in the first region is the first non-DC coefficient along the ordering.

Thus, for example, indicating by RP the codeword in the first runlength coding method that indicates that the first region starts with a run of one or more zero-valued coefficients, suppose the series of coefficients in the first region starts with:

$$0\ 2\ 3\ 2\ {-1}\ 0\ 1\ 2\ 0\ 0\ 1\ {-1}\ 1\ 0\ 0\ ...$$

In one embodiment, the codewords for this first region is:

$$RP + C'(1) + [C(4) + A(2) + S_+ + A(3) + S_+ + A(2) + S_+ + A(1) + S_-] + C'(1) +$$
$$[C(2) + A(1) + S_+ + A(2) + S_+] + C'(2) +$$
$$[C(3) + A(1) + S_+ + A(1) + S_- + A(1) + S_+] + C'(2)\ ...$$

In another embodiment, a codeword is included in the first runlength coding method that indicates that the series has no non-zero values. In another embodiment, such a codeword also is used to indicate that all remaining coefficients in the first region are zero. This codeword is called skip-to-boundary (SKP) herein.

The second region coding in the Basic Hybrid VLC Method

In the second region, 409 and 411 of method 400 describe the coding method to encode the remaining ordered series of coefficients.

In one embodiment, in the second region, a second-region coding method is used that takes into account the occurrence of runs of zero-valued coefficients. One embodiment of the second-region coding method of the Basic Hybrid VLC Method includes in 409 identifying events that include runs of consecutive signals of the most-likely-to-occur value, e.g., zero-valued coefficients in the second region and, in 409, encoding the identified events in the second region using a third coding method. In particular, 409 includes identifying the runs of zero-valued coefficients and 411 includes encoding the runlengths of each run of zero-valued coefficients using the third runlength coding method that provides a code for each run, such as a code represented by the runlength table shown in Table 5 below, where C"(z), z=0, 1, 2, ... represents the runlength code used to encode a runlength of z consecutive 0's, z=0, 1, ...

Table 5

| Run length | 0 | 1 | 2 | 3 | 4 | 5 | 6 | . |
|---|---|---|---|---|---|---|---|---|
| Code | C"(0) | C"(1) | C"(2) | C"(3) | C"(4) | C"(5) | C"(6) | . |

One aspect of the invention is that an end code, denoted EOB herein, is used to indicate that the remaining coefficients in the second region are all zero.

Furthermore, in 409, the non-zero-amplitude coefficients in the second region in between the identified events of runs of zeroes are identified. In 411, the amplitudes of each such non-zero-valued coefficient is encoded using a second amplitude coding method, and furthermore, the sign of such non-zero-valued coefficient is encoded.

As an example, suppose the ordered series quantized coefficients along the pre-determined path for the second region is:

$$0\,0\,0\,1\,0\,0\,1\,{-1}\,0\,0\,0\,0\,0\,1\,0\,0 \ldots 0.$$

This series may be written as:

$$0\,0\,0\,x\,0\,0\,x\,x\,0\,0\,0\,0\,0\,x\,0\,0 \ldots 0$$

where x represents any non-zero-valued coefficient and 0 represents a zero-valued coefficient.

Denote by r"(z) the runs of z consecutive zero-valued coefficients in the second region, z=0, 1, 2, .... In one embodiment, each non-zero valued coefficient in the series of the second region is assumed to be preceded by a no zero-valued coefficients, or a run of one or more zero-valued coefficients-in general, "a run of none or more consecutive zero-valued coefficeints," -so that the second of two consecutive non-zero-valued coefficients is preceded by a run of no zero-valued-coefficients (i=0). The above example ordered sequence of runs of zeroes in the second regions may then be written as:

$$r''(3)\ r''(2)\ r''(0)\ r''(5)\ \mathrm{EOB}$$

where EOB is used to indicate that the remaining coefficients are all 0, and in which it is understood that there is exactly one non-zero-valued coefficient between each run of 0's. Using the codes of Table 5 for the runlengths, the result of encoding the runs in the series of the second region is then:

$$C''(3)\ C''(2)\ C''(0)\ C''(5)\ \mathrm{EOB}$$

If quantized coefficients along a specified path in the second region are of values greater or equal to one then in one embodiment, the encoding process includes a variable length amplitude code after the runlength code to encode the amplitude of the non-zero-valued coefficient, and a sign code for the non-zero-valued coefficient that follows the run of 0's. Denote by A"(k), k=1,2,3,... the variable length amplitude codes for amplitudes 1, 2, ...respectively, denote by $S_+$ and $S_-$the sign bit codes for positive and negative coefficients, respectively, and denote concatenation by +. The above example sequence of the second region is then encoded as follows:

$$[C''(3)+A''(1)+S_+) + (C''(2)+A''(1)+S_+) + [C''(0)+A''(1)+S_-]$$
$$+ [C''(5)+A''(1)+S_+] + \mathrm{EOB}.$$

Note that in one embodiment, the second amplitude coding method (the A"(k) values, k=1, 2, ...) for quantized coefficient amplitudes that occur in the second region is different from the first amplitude coding (the A(i) values, i=1, 2, ...) for quantized coefficient amplitudes that occur in the first region. It is expected, for example, that the amplitudes in the second region, e.g., the high-frequency region, would be dominated by lower values than the amplitudes that occur in the first region, e.g., the low frequency region, for typical images.

**Alternate codes for the second region in the Basic Hybrid VLC Method**

The coding method used in the second region includes identifying events that include a run of zero-valued coefficients, and encoding the event using the third coding method. One embodiment above uses a third runlength coding method to separately encode the runs of zero-valued coefficients in the series in the second region, and then additionally encodes the values of the amplitudes. In an alternate embodiment, traditional 2D-VLC is used to identify events that include a run of zero-valued coefficients with a single non-zero-valued coefficient and encode such events using 2D-VLC, e.g., using the 2D coding table such as Table 2 above derived using statistics, e.g., in the form of Table 1, of amplitudes and runs of preceding zeroes in the second region. In yet another embodiment, the 2D-VLC table is truncated in that long runs and/or large amplitudes following a run of zeroes uses fixed length rather than variable length codes. In one such version, an escape code followed by a fixed code for the runlength of preceding zero-valued coefficients, followed by a fixed code for the amplitude and sign is used in place of the variable length code in a complete variable length code.

Other variations also are possible. For example, a variation sometimes called three-dimensional VLC (3D-VLC) may be used. See PCT patent publication WO 9318616 published September 16, 1993 titled PICTURE DATA ENCODING METHOD. In 3D-VLC, each symbol ("event") is a triplet that includes a binary input flag that indicates whether or not the current non-zero amplitude-value is the last non-zero coefficient in the block.

**Sample code tables for the Basic Hybrid VLC Method: the runlength codes**

The runlength codes for the first runlength coding method, the second runlength coding method, and the third runlength coding method for runlengths can be arithmetic codes or Huffman variable length codes. Different types of images may be examined experimentally and statistics collected for such images on the different runlengths to be encoded. The codes can then be assigned based on such statistics.

Table 6 below shows one embodiment of the codes according to the first runlength coding method for runs of non-zero-valued coefficients that occur in the first region for still images and for intraframe images. This table assumes a breakpoint at 11 (excluding the DC coefficient) so that only 11 consecutive non-zero values are included. Note that the table includes a particular code for an event called RP that indicates that the table starts with a run of one or more zero-valued coefficients rather than a non-zero-valued coefficient. Note further that Table 6 assumes, as is common with many tables, that the DC component (the first entry) of the series is encoded separately, as is common in many VLC methods. Therefore, implied is that the first element is the first non-DC value.

Table 6: Codes for runs of non-zeroes in first region

| Custer Pattern | Huffman Code | Code Length |
|---|---|---|
| x | 0 | 1 |
| xx | 100 | 3 |
| xxx | 1010 | 4 |
| xxxx | 10111 | 5 |
| xxxxx | 110111 | 6 |
| xxxxxx | 1011001 | 7 |
| xxxxxxx | 10110000 | 8 |
| xxxxxxxx | 110101010 | 9 |
| xxxxxxxxx | 10110001 | 8 |
| xxxxxxxxxx | 1101010111 | 10 |
| xxxxxxxxxxx | 1101010110 | 10 |
| skip_MB | 1100 | 4 (block that has no info) |
| RP | 111 | 3 (use R’ from now on) |

In tables where the breakpoint can be more that 11, e.g., a breakpoint of 22, and for tables for the case of the breakpoint being what we call a "soft" breakpoint such that runs that extend beyond the breakpoint are allowed, in one embodiment, the first coding method uses a unique escape code denoted ESC1 herein, followed by a fixed length code for the length of the run, e.g., 5 bits for accommodating runs of up to 32 consecutive non-zero values, or 6-bits for accommodating runs of up to 64 consecutive non-zero values. Using 6 bits for the ESC1 code, the codewords for the length of the runs of non-zero coefficients in the first region are at most 11-bits long or 12-bits long, for using 5-bits and 6-bit codes, respectively, for the length of the codes.

Table 7 below shows one embodiment of the codes according to the second runlength coding method for runs of zeroes that occur in the first region for still images and for intraframe images. Again, the breakpoint is assumed to be a fixed breakpoint of 11.

As in the case for the tables corresponding to the first runlength coding method, in tables where the breakpoint can be more that 11, e.g., a breakpoint of 22, and for tables that accommodate a "soft" breakpoint such that runs that extend beyond the breakpoint are allowed, in one embodiment, the second coding method uses a unique escape code denoted ESC2 herein, followed by a fixed length code for the length of the run, e.g., 5 bits for accommodating runs of up to 32 consecutive zero values, or 6-bits for accommodating runs of up to 64 consecutive non-zero values.

Table 7: Codes for runs of zeroes in first region

| Cluster Pattern | Huffman Code | Code_length |
|---|---|---|
| 0 | 0 | 1 |
| 00 | 101 | 3 |
| 000 | 1001 | 4 |
| 0000 | 10001 | 5 |
| 00000 | 100001 | 6 |
| 000000 | 1000001 | 7 |
| 0000000 | 10000001 | 8 |
| 00000000 | 100000001 | 9 |
| 000000000 | 1000000001 | 10 |
| 0000000000 | 10000000001 | 11 |
| 00000000000 | 10000000000 | 11 |
| EOB | 111 | 3 |

Note that Table 7 includes an EOB code to indicate that the remainder of the series consists of only zeroes.

Table 8 below shows one embodiment of a code table according to the third runlength coding method applicable to runs of zero-amplitude coefficients that occur in the second region for still images and for intraframe images.

Table 8: Codes for runs of zeroes in second region

| Runlength | Code | Code Length |
|---|---|---|
| 0 | 111 | 3 |
| 1 | 101 | 3 |
| 2 | 1001 | 4 |
| 3 | 1100 | 4 |
| 4 | 0101 | 4 |
| 5 | 0100 | 4 |
| 6 | 100011 | 6 |
| 7 | 1000101 | 7 |
| 8 | 10000010 | 8 |

(continued)

| Runlength | Code | Code Length |
|---|---|---|
| 9 | 100010010 | 9 |
| 10 | 10000000 | 8 |
| 11 | 10000001 | 8 |
| 12 | 1000100110 | 10 |
| 13 | 1000001100 | 10 |
| 14 or more | ESC3+6-bit length | 12 |
| EOB | 00 | 2 |

where ESC3 is an escape code to indicate that what follows is a 6-bit code for the runlength for runs that are more than 13 long. In one embodiment, ESC3 is a 6-bit code, and 6-bits are used after the ESC3 code to encode the run-length of zeroes. Thus, no code is ever longer than 12 bits.

**Sample code tables for the Basic Hybrid VLC Method: the amplitude codes**

In one embodiment, the two amplitude codes A(i), i=1, 2, ... and A"(k), i=k, 2, ... are each codes that are determined experimentally for a set of typical images by determining statistics for the non-zero amplitudes that occur in the first and the second regions. One embodiment of each of the amplitude tables of the first and second regions, respectively, is shown below as Table 9 and Table 10, respectively. Each of these tables was determined using a typical still image. Each table includes the amplitude (as a symbol), the codeword for that amplitude, and the length of the codeword. Also shown are the frequency of occurrence and the total number of bits for a typical still image.

In Table 9, amplitudes of 16 or higher are encoded by a 6-bit escape code plus 7 bits for the amplitude and sign. An alternate embodiment uses a coding table with 63 entries that concurrently encodes the sign and amplitude.

In Table 10, there is almost no likelihood of an amplitude greater than 16 in the second region, so that no codes are included for such higher amplitudes. In an alternate embodiment, relatively long codes are included for amplitudes greater than 16 that can occur in pathological cases.

Table 9: Amplitude codes in first region

| Amplitude | Code | Code Len | Freq |
|---|---|---|---|
| 1 | 1 | 1 | 94552 |
| 2 | 00 | 2 | 16222 |
| 3 | 0111 | 4 | 7489 |
| 4 | 0100 | 4 | 3965 |
| 5 | 01011 | 5 | 2701 |
| 6 | 011011 | 6 | 1731 |
| 7 | 011000 | 6 | 1262 |
| 8 | 010100 | 6 | 843 |
| 9 | 0110010 | 7 | 613 |
| 10 | 0101010 | 7 | 515 |
| 11 | 01100111 | 8 | 442 |
| 12 | 01010111 | 8 | 322 |
| 13 | 01010110 | 8 | 268 |
| 14 | 011001101 | 9 | 221 |
| 15 | 011001100 | 9 | 179 |
| 16 or more | 011010+Ampl. | 6 | 1463 |

(continued)

| Amplitude | Code | Code Len | Freq |
|---|---|---|---|
| Total Bit Count | | | 237863 |

Table 10: Amplitude codes in second region

| Amplitude | Code | Code Len | Freq |
|---|---|---|---|
| 1 | 1 | 1 | 16297 |
| 2 | 01 | 2 | 1897 |
| 3 | 000 | 3 | 565 |
| 4 | 0010 | 4 | 271 |
| 5 | 00110 | 5 | 141 |
| 6 | 001110 | 6 | 77 |
| 7 | 0011110 | 7 | 45 |
| 8 | 001111111 | 9 | 24 |
| 9 | 001111100 | 9 | 15 |
| 10 | 0011111100 | 10 | 10 |
| 11 | 0011111010 | 10 | 8 |
| 12 | 00111110111 | 11 | 5 |
| 13 | 00111111010 | 11 | 5 |
| 14 | 001111110110 | 12 | 2 |
| 15 | 001111110111 | 12 | 3 |
| 16 | 00111110110 | 11 | 3 |
| Total Bit Count | | | 25086 |

**Apparatus for the Basic Hybrid VLC Method**

Another aspect of the Basic Hybrid VLC Method invention is an apparatus for coding a series of digital signals, e.g., an ordered series of quantized coefficients of a transformed block of image data.

FIG. 5 shows one embodiment of an apparatus for encoding according to the VLC tables described above. One embodiment uses three lookup tables such as Tables 6, 7, and 8 above that are stored in a memory 506. A counter 508 in an event recognizer 502 counts the coefficient number in the order of the series, and thus provides for the event recognizer 502 whether or not an event is in the first or the second region by determining whether or not the coefficient is before or after the breakpoint, also stored in the memory 506. The event recognizer 502 determines the runlength of consecutive zero amplitude coefficients, and the runlength of consecutive zero-length amplitudes when in the first region, and the runlength of zero amplitude coefficients when in the second region. For the first region, the runlength of zeroes (zeroes or non-zero) are passed together with the amplitudes (0 or non-zero). In one embodiment, a code is further passed to indicate when the values are in the second region. These output(s) of the event recognizer 502 are input to an encoder 504 that in one embodiment includes a lookup device to look up the appropriate one of the five code tables used.

While the embodiment shown in FIG. 5 has the memory 506 that stores the lookup tables separate from the lookup device, in another embodiment, the lookup device includes a memory for storing the code tables.

An alternate embodiment of FIG. 5 includes in the code generated by the event recognizer 502 an indication of whether or not the coefficient is the last coefficient in the block. This provides for an extension similar to that of traditional 3-D VLC as described in above-mentioned PCT patent publication WO 9318616.

Another aspect of the Basic Hybrid VLC Method invention is an apparatus for decoding a bitstream encoded by any of the novel methods described herein. FIG. 6 shows one embodiment of the apparatus. A codeword recognizer 602 accepts the bits of a bitstream and recognizes a codeword of a set of possible codewords that each represents an event. The codeword recognizer determines which of the five coding tables the codeword is from. A decoder 604 is coupled to the codeword recognizer 602 and determines the data for the codeword recognized by the codeword recognizer, e.g., the runlength of non-zeroes, the runlength of zeroes, the sign, etc.. In one embodiment, the decoder 604 includes a lookup device that looks up the appropriate decoding table stored in a memory 606. That table provides the event for at least some of the codewords of the set of codewords. Other codewords may include an escape code, so that decoding is by other than a table lookup method. In one embodiment, the bitstream is stored in a buffer 608, and the output of the buffer is coupled to the codeword recognizer.

While in the embodiment shown in FIG. 6, the memory is shown separate from the lookup device, those in the art will understand that in other embodiments, the lookup device includes memory for the tables, and such other embodiments are included herein.

Note that in FIG. 5, the event recognizer and also the lookup device may be each implemented on a computer as a set of instructions stored in a memory, e.g., the memory 506, that instructs one or more processors to carry out the operations of the recognition and of the lookup.

Note further that in FIG. 6, the codeword recognizer and also the lookup device may be each implemented on a computer as a set of instructions stored in a memory, e.g., the memory 606, that instructs one or more processors to carry out the operations of the recognition and of the lookup.

Another aspect of the Basic Hybrid VLC Method invention is a memory (such as memory 506 in FIG. 5) that stores coding data structures that provide the codewords for sets of one or more coefficients as described any one of the novel coding methods described herein. In one embodiment, the data structure is in the form of one or more tables.

Another aspect of the Basic Hybrid VLC Method invention is a memory (such as memory 606 in FIG. 6) that stores a decoding data structure that provides the data for any set of codewords recognized in a bitstream of compressed image data. The bitstream is coded by any one of the novel coding methods described herein. In one embodiment, the data structure is in the form of one or more tables.

Thus, a variable length coding method has been described suitable for encoding the quantized transform coefficients of blocks of images as occur in common image compression methods.

One embodiment of the Basic Hybrid VLC Method uses five independent tables: two runlength code tables for the first and second runlength coding methods, and a first amplitude code table for use in the first region, and another runlength code table for the third runlength coding method, and a second amplitude code table for use in the second region.

*The Extended Hybrid VLC Method for the Second Region.*

An aspect of the present invention described in the Extended Hybrid VLC Method that in the second region, a second-region coding method is used that takes into account the occurrence of runs of zero-valued coefficients that end in an amplitude 1 coefficient. In more general terms, this aspect takes into account the occurrence of runs of the most likely-to-occur values in the series followed by a single instance of the next- most likely-to-occur amplitude. The second-region coding method of the Extended Hybrid VLC Method includes identifying events that include runs of consecutive signals of the most likely-to-occur value, e.g., zero-valued coefficients in the second region that end in the next most likely-to-occur amplitude, e.g., one, and encoding the identified events in the second region using a third coding method.

One embodiment of the second-region coding method of the Extended Hybrid VLC Method includes, starting at the beginning of the second region, identifying the runs of zero-valued coefficients that end in a non-zero-amplitude coefficient, and encoding the runlengths of each run of zero-valued coefficients that end in the non-zero-amplitude using a third runlength coding method that provides a code for each run, such as a code represented by the runlength table shown below as Table 11, where C"'(i), i=0, 1,2, ... represents the runlength code used to encode a runlength of i consecutive 0's ending in 1.

Table 11

| Run length | 0 | 1 | 2 | 3 | 4 | 5 | 6 | ... | Esc |
|---|---|---|---|---|---|---|---|---|---|
| Code | C"'(0) | C'"(1) | C"'(2) | C"'(3) | C"'(4) | C'"(5) | C"'(6) | ... | ESC"' |

Table 11 also includes a code to indicate when the ending non-zero-amplitude is other than the next-most-likely-to-occur, e.g., whose amplitude is greater than 1, i.e., for the case of the run being of consecutive coefficients of the most-likely-to-occur amplitude, e.g., 0, that ends in a coefficient whose amplitude is other than the next-most-likely-to-occur, e.g., whose amplitude is greater than 1. Because such events are regarded as not very likely, we call them "exceptions." An exception is indicated as **Exc** in Table 11. Such an exception is encoded according to an aspect of the Extended Hybrid VLC Method by the codeword as if the run of 0's ended in 1 followed by a second escape code, denoted **ESC'''**, followed by an encoding of the amplitude.

Another aspect of the invention is that an end code, denoted EOB herein, is used to indicate that the remaining coefficients in the second region are all zero.

As an example, suppose the ordered series quantized coefficients along the pre-determined path for the second region is:

$$0\,0\,0\,1\,0\,0\,2\,{-1}\,0\,0\,0\,0\,0\,1\,0\,0\ldots 0.$$

Denote by r'''(i) the run of i consecutive zero-valued coefficients that end in amplitude 1, and by r'''(i)+**Exc** the run of i consecutive zero-valued coefficients that end in a non-zero amplitude greater than 1, with i=0,1,2,.... In one embodiment, each non-zero valued coefficient in the series of the second region is assumed to be preceded by a run of zero-valued coefficients, so that the second of two consecutive non-zero-valued coefficients is preceded by a run of non-zero-valued-coefficients (i=0). The runs of the series of the second region may then be written as:

$$r'''(3)\ (r'''(2)+\mathbf{Exc})\ r'''(0)\ r'''(5)\ \mathrm{EOB}.$$

where EOB is used to indicate that the remaining coefficients are all 0, and in which it is understood that there is exactly one non-zero-valued coefficient between each run of 0's. If quantized coefficients along a specified path in the second region are of values greater than one then in one embodiment, the encoding process includes a variable length amplitude code after the runlength code and the exception code to encode the amplitude of the non-zero-valued coefficient, and a sign code for the non-zero-valued coefficient that follows the run of 0's. Denote by A'''(k), k=2,3,... the variable length amplitude codes for amplitudes 2, 3,...respectively, denote by $S_+$ and $S_-$ the sign bit codes for positive and negative coefficients, respectively, and denote concatenation by +.

Using Table 11 that shows the codes for the runlengths in the second region that end in 1 according to the Extended Hybrid VLC method, the result of encoding the runs in the series of the second region is then:

$$[C'''(3)+S_+] + [C'''(2)+\mathbf{ESC}'''+A'''(2)+S_+] + [C'''(0)+S_-] + [C'''(5)+S_+] + \mathrm{EOB},$$

where EOB is also used here to denote the codeword to indicate the remaining coefficients are zero-valued, and **ESC'''** is the escape code for the exception in the second region.

The above-described Basic Hybrid VLC Method would have included an amplitude code for those non-zero-valued coefficients of amplitude 1. Therefore, so long as the non-zero quantized coefficient values in the second region are predominantly $\pm 1$, this performance of this embodiment of the Extended Hybrid VLC Method should be superior to the corresponding version of the Basic Hybrid VLC Method.

Note that in one embodiment, the amplitude coding method (the A'''(k) values, k= 2, 3,...) for quantized coefficient amplitudes that occur in the second region is different from the amplitude coding (the A(k) values, k=1, 2, ...) for quantized coefficient amplitudes that occur in the first region. It is expected, for example, that the amplitudes in the second region, e.g., the high frequency region, would be dominated by lower values than the amplitudes that occur in the first region, e.g., the low frequency region, for typical images.

The Extended Hybrid VLC Method is an improvement to the Basic Hybrid VLC Method and would likely be superior for low-bit-rate motion compensated coding. It may also be useful for higher bit-rate interframe coding as better motion compensation techniques are developed.

### The breakpoint defining the two regions for the Basic Hybrid VLC Method and for the Extended Hybrid VLC Method

One version uses a fixed breakpoint between the first, e.g., low frequency region, and the second, e.g., high frequency region. In one embodiment, the fixed breakpoint is pre-determined for each type of image and for each type of compression method by running experiments collecting statistics on a set of typical samples of such images. Typically, different breakpoints are determined for:

- intraframe and still image coding vs. interframe coding;

- standard definition television images (SDTV) vs. HDTV images;
- high bit rate coding methods vs. low bit rate coding methods;
- DCT vs. non-DCT transforms;

and so forth.

When fixed, e.g., pre-selected breakpoints are used, there is already an indication passed on to the decoder to indicate the type of image, e.g., whether interframe or intraframe, or the type of coding, high-bit-rate or low-bit-rate. Thus, there is typically no need to send a further indication to the decoder of the breakpoint. In one embodiment, a first breakpoint is used for interframe data that is for a first kind of interframe coding, e.g., relatively high-bit-rate interframe coding, and a second breakpoint is used for interframe data that is for a second kind of interframe coding, e.g., relatively low-bit-rate interframe coding.

The inventors performed experiments on typical still images-applicable also to intraframe images in motion coding- by performing variable length coding according to the Basic and the Extended Hybrid VLC Method embodiments of the present invention, and plotting the size of the compressed image for different breakpoint values for the case of 8 by 8 blocks quantized to 127 non-zero amplitudes using the DCT, and observed that a breakpoint of 22 worked for most images, although some images worked well with a breakpoint of about 10. Therefore, in one embodiment for intraframe and still images for DCT transform coding, a pre-selected fixed breakpoint of 22 was used.

In a first variation, the breakpoint is image dependent and selected from a finite set according to a breakpoint selection criterion. For example, from the above-described experiments, the compression using a first breakpoint of 22 was compared to the compression using a second breakpoint of 10, and the breakpoint that gave the higher compression used. Other breakpoint selection criteria are also possible, e.g., by looking at the statistics of runs of zero-valued coefficients and non-zero-valued coefficients.

When such an image-dependent breakpoint is used, an indication of the breakpoint is also sent with each set of coefficients. In one embodiment, a 2-bit indication is sent. This provides for each block to be encoded using one of 4 pre-defined breakpoints. In an alternate embodiment, the indication of which pre-defined breakpoint is sent as a variable length code such that more common breakpoints are encoded by a shorter code.

While typically, the set of possible breakpoints is a small subset of the possible positions in the series, in yet another variation, the image dependent breakpoint is selected from anywhere in the series, or, in an alternate variation, from anywhere along a sub-range.

When the breakpoint defines a fixed boundary between the first and second region, this boundary is called a "hard" boundary herein. Similarly, a set of breakpoints may define a set of hard boundaries. With a hard boundary, a sequence of consecutive non-zero values or a sequence of consecutive zero-valued coefficients that crossed the breakpoint would be regarded as a first sequence in the first region up to the breakpoint, and a second sequence in the second region from after the breakpoint.

In an alternate embodiment, the breakpoint defines what is called herein a "soft" boundary in that any sequence of consecutive zero, or non-zero values that started in the first region would be encoded in the first region even if it crossed the breakpoint. Thus, the actual boundary for a particular block of coefficients might extend beyond the breakpoint. For example, consider the following ordered series of digital signals of coefficients:

$$2\;3\;2\;{-1}\;{-1}\;1\;1\;1\;{-1}\;1\;0\;1\;2\;0\;0\;1\;{-1}\;1\;0\;0\;\ldots$$

And suppose a breakpoint of up to and including 7 is used.

In one embodiment, the breakpoint forms a hard boundary. In such a case, the first region is:

$$2\;3\;2\;{-1}\;{-1}\;1\;1$$

and the second region is:

$$1\;{-1}\;0\;1\;2\;0\;0\;1\;{-1}\;1\;0\;0\;\ldots$$

So that the coding of the first region using the Basic or Extended Hybrid VLC method is:

$$C(7) + A(2) + S_+ + A(3) + S_+ + A(2) + S_+ + A(1) + S_- + A(1) + S_- + A(1) + S_+ + A(1) + S_+,$$

the coding of the second region using the Basic Hybrid VLC method is:

$$C''(0) + [A''(1) + S_+] + C''(0) + [A''(1) + S] + C''(1) + [A''(1) + S_+] + C''(0) + [A''(2) + S_+] + C''(2) + [A''(1) + S_+] + C''(0) + [A''(1) + S_-] + C''(0) + [A''(1) + S_+] + \ldots,$$

and the coding of the second region using the Extended Hybrid VLC method is:

$$[C'''(0) + S_+] + [C'''(0) + S_-] + [C'''(1) + S_+] + [C'''(0) + ESC''' + A'''(2) + S_+] + [C'''(2) + S_+) + [C'''(0) + S_-) + [C'''(0) + S_+] + \ldots$$

In another embodiment, the breakpoint defines a soft boundary. In such a case, for this particular block, the first region is:

$$2\ 3\ 2\ -1\ -1\ 1\ 1\ 1\ -1$$

and the second region is:

$$0\ 1\ 2\ 0\ 0\ 1\ -1\ 1\ 0\ 0\ \ldots$$

So that the coding of the first region using the Basic or Extended Hybrid VLC method is:

$$C(9) + A(2) + S_+ + A(3) + S_+ + A(2) + S_+ + A(1) + S_- + A(1) + S_- + A(1) + S_+ + A(1) + S_+ + A(1) + S_+ + A(1) + S_-,$$

the coding of the second region using the Basic Hybrid VLC method is:

$$C''(1) + [A''(1) + S_+] + C''(0) + [A''(2) + S_+] + C''(2) + [A''(1) + S_+] + C''(0) + [A''(1) + S_-] + C''(0) + [A''(1) + S_+] + + C''(2) + \ldots$$

and the coding of the second region using the Extended Hybrid VLC method is:

$$[C'''(1) + S_+] + [C'''(0) + ESC''' + A'''(2) + S_+] + [C'''(2) + S_+] + [C'''(0) + S_-] + [C'''(0) + S_+] + \ldots$$

That is, for the second embodiment, the breakpoint of 7 corresponds to a boundary of 9 for this particular block.

**Sample code tables: the runlength codes and amplitude codes**

The runlength codes for each of the first runlength coding method, the second runlength coding method, and the third runlength coding method can be arithmetic codes or Huffman variable length codes. Different types of images may be examined experimentally and statistics collected for such images on the different runlengths to be encoded. The codes are then assigned based on such statistics.

Similarly, two amplitude codes according to the first and second amplitude coding methods, one for non-zero amplitudes in the first region, and another for amplitudes greater than 1 in the second region are constructed, e.g., as arithmetic codes or Huffman variable length codes.

Thus there are three runlength codes, and these may be presented in the form of three runlength coding tables. There further are two amplitude coding tables. Thus, one embodiment uses five tables.

**Multiple breakpoints and more than two regions**

The above embodiments are in terms of a single breakpoint, and two regions in the ordering. The idea may be extended to more than two regions, i.e., more than one breakpoint. For example, one embodiment includes a first, low frequency region where it is reasonably likely that there are runs of zero-valued coefficients and runs of non-zero coefficients of value one or more, a second, mid-frequency region where it is reasonably likely that there are runs of zero-valued coefficients, and runs of coefficients of value one, but where there is not likely to be runs of coefficients greater than one, and a third high-frequency region where it is reasonably likely that there are runs of zero-valued coefficients, but not many runs of non-zero-valued coefficients. Thus, one alternate run length coding method includes using two breakpoints to define a first, second, and third region. In the first region, runs of non-zero-valued coefficients and runs of zero-valued coefficients are identified, and the runlengths of the non-zero and zero-amplitude coefficients are encoded using a first runlength coding method and a second runlength coding method. In the second region, runs of coefficients of amplitude-one, and runs of zero-valued coefficients are identified, and the runlengths of the amplitude-one and zero-amplitude coefficients are encoded using a third runlength coding method and a fourth runlength coding method, respectively. In the third region, runs of zero-valued coefficients are identified, and the runlengths of such zero-valued-runs are encoded using a fifth runlength coding method.

Other schemes such as 2D-VLC and extended 2D-VLC also may be used in some of the regions.

**Apparatus for the Extended Hybrid VLC Method**

Another aspect of the Extended Hybrid VLC Method invention is an apparatus for coding a series of digital signals, e.g., an ordered series of quantized coefficients of a transformed block of image data.

FIG. 7 shows one embodiment of an apparatus for encoding according to the VLC tables described herein. One embodiment, uses three lookup tables such as a table for the codes for runs of non-zeroes in the first region, a table for the codes for runs of zeroes in the first region, and a table for the codes for runs of zeroes that end in an amplitude of 1 in the second region. These tables, e.g., the tables for the codes for the first region, and the table or tables for the codes in the second region are stored in a memory 706. A counter 708, in an event recognizer 702, counts the coefficient number in the order of the series, and thus provides for the event recognizer 702, whether or not an event is in the first or the second region by determining whether or not the coefficient is before or after the breakpoint, also stored in the memory 706. The event recognizer 702 determines the runlength of consecutive zero amplitude coefficients, and the runlength of consecutive zero-length amplitudes when in the first region, and the runlength of zero amplitude coefficients that end in amplitude 1, or in another amplitude when in the second region. For the first region, the runlength of zeroes (zeroes or non-zero) are passed together with the amplitudes (0 or non-zero). In one embodiment, a code is further passed to indicate when the values are in the second region. These output(s) of the event recognizer 702 are input to an encoder 704 that in one embodiment includes a lookup device to look up the appropriate one of the five code tables used.

While the embodiment shown in FIG. 7 has the memory 706 that stores the lookup tables separate from the lookup device, in another embodiment, the lookup device includes a memory for storing the code tables.

An alternate embodiment of FIG. 7 includes in the code generated by the event recognizer 702 an indication of whether or not the coefficient is the last coefficient in the block. This provides for an extension similar to that of traditional 3-D VLC as described in above-mentioned PCT patent publication WO 9318616.

Another aspect of the Extended Hybrid VLC Method invention is an apparatus for decoding a bitstream encoded by any of the novel methods described herein. FIG. 8 shows one embodiment of the apparatus. A codeword recognizer 802 accepts the bits of a bitstream and recognizes a codeword of a set of possible codewords that each represents an event. The codeword recognizer determines which of the five coding tables the codeword is from. A decoder 804 is coupled to the codeword recognizer 802 and determines the data for the codeword recognized by the codeword recognizer, e.g., the runlength of non-zeroes, the runlength of zeroes, the sign, etc.. In one embodiment, the decoder 804 includes a lookup device that looks up the appropriate decoding table stored in a memory 806. That table provides the events for at least some of the codewords of the set of codewords. Other codewords may include an escape code, so that decoding is by other than a table lookup method. In one embodiment, the bitstream is stored in a buffer 808, and the output of the buffer is coupled to the codeword recognizer.

While in the embodiment shown in FIG. 8, the memory is shown separate from the lookup device, those in the art will understand that in other embodiments, the lookup device includes memory for the tables, and such other embodiments are included herein.

Note that in FIG. 7, the event recognizer and also the lookup device may each be implemented on a computer as a set of instructions stored in a memory, e.g., the memory 706, that instruct one or more processors to carry out the operations of the recognition and of the lookup.

Note further that in FIG. 7, the codeword recognizer and also the lookup device may each be implemented on a computer as a set of instructions stored in a memory, e.g., the memory 706, that instruct one or more processors to carry out the operations of the recognition and of the lookup.

Yet another apparatus embodiment of an apparatus that implements the Extended Hybrid VLC Method is shown in FIG. 9 as apparatus 900 that includes processing system 902 that includes one or more processors 904 and a memory 906. A single processor is shown in FIG. 9 and those in the art will appreciate that this may represent several processors. Similarly, a single memory subsystem 906 is shown, and those in the art will appreciate that the memory subsystem may include different elements such as RAM, ROM, and so forth. In addition, the memory subsystem is meant to include any non-volatile memory storage such as a magnetic or optical storage component. A computer program 908 is included and is loaded into the memory 906. Note that at any time, some of the program may be in the different parts of the memory subsystem, as will be understood by those in the art. The program 908 includes instructions to instruct the processor to implement, in different versions, the different coding methods described herein, e.g., the Extended Hybrid VLC Method. FIG. 9 is explained in more detail below under the Section titled "*Coding and decoding apparatus including a processor*."

Yet another apparatus embodiment is shown in FIG. 10 as decoding apparatus 1000 that includes processing system 1002 that includes one or more processors 1004 and a memory 1006. A single processor is shown in FIG. 10 and those in the art will appreciate that this may represent several processors. Similarly, a single memory subsystem 1006 is shown, and those in the art will appreciate that the memory subsystem may include different elements such as RAM, ROM, and so forth. In addition, the memory subsystem is meant to include any non-volatile memory storage such as a magnetic or optical storage component. A computer program 1008 is included and is loaded into the memory 1006. Note that at any time, some of the program may be in the different parts of the memory subsystem, as will be understood by those in the art. The program 1008 includes instructions to instruct the processor to implement, in different versions, the decoding codewords generated using any of the different coding methods described herein, e.g., the Extended Hybrid VLC Method. FIG. 10 is explained in more detail below under the Section titled"*Coding and decoding apparatus including a processor*."

Another aspect of the invention is a memory (such as memory 706 in FIG. 7 or memory 906 in FIG. 9) that stores a coding data structure that provides the codewords for sets of one or more coefficients as described in any one of the novel coding methods described herein. In one embodiment, the data structure is in the form of one or more tables.

Another aspect of the invention is a memory (such as memory 806 in FIG. 8 or memory 1006 in FIG. 10) that stores a decoding data structure that provides the data for any set of codewords recognized in a bitstream of compressed image data. The bitstream is coded by any one of the novel coding methods described herein. In one embodiment, the data structure is in the form of one or more tables.

One embodiment of the Extended Hybrid VLC VLC Method invention uses five independent tables: two runlength code tables for the coding methods of the first and second kinds, and a first amplitude code table for use in the first region, and another runlength code table for the coding method of the third kind, and a second amplitude code table for use in the second region.

*The Multiple-Class VLC Method*

One aspect of the Multiple-Class VLC Method uses a plurality of coding processes for the ordered series of quantized coefficients of a transformed block of image data. By a coding process is meant a coding method or combination of methods. As in the Basic Hybrid VLC Method and the Extended Hybrid VLC Method, the series typically is obtained by scanning the quantized transform coefficients along a selected path on the transform domain. The series of quantized coefficients is classified into one of a plurality of classes according to how coefficients are distributed in the series. For each class, a corresponding set of one or more of the provided coding processes is used to code the series. Thus, the coding method or methods applied to the block of data depends on the determined distribution of quantized transform coefficients.

In one embodiment of the Multiple-Class VLC Method, the above-described Basic Hybrid VLC Method and Extended Hybrid VLC Method provide the types of coding methods.

The classification of the series of quantized coefficients into a plurality of classes will be illustrated by classification into four classes. The invention, however, is not restricted to such a number of classes.

The above-described Basic Hybrid VLC Method and Extended Hybrid VLC Method describe how a series may be divided into regions. For the purpose of illustration, the description below will be mostly in terms of two regions, which can be called a low frequency region, and a high frequency region. For classes that include two such regions, a breakpoint along the path of the ordering of the coefficients is established to identify a first, e.g., low frequency region and a second, e.g., high frequency region.

Blocks of image data in the form of an ordered sequence of quantized transform coefficients are scanned prior to coding ("pre-scanned") and classified into the following four classes, denoted here as class 1, class 2, class 3, and class 4.

***Class 1 (clustered and large):*** Many non-zero-valued coefficients along the ordering of the coefficients are of non-zero values, including a significant number that are not $\pm 1$. The non-zero valued coefficients are clustered throughout the ordering such that there is no clear breakpoint along the path of the ordering of the coefficients to identify a first region, e.g., low frequency region in which non-zero-valued coefficients are clustered and a second, e.g., high frequency region in which the non-zero-valued coefficients are scattered.

***Class 2 (a clustered and large region and a scattered region):*** A significant number, e.g., more than 4 non-zero-valued coefficients along the ordering of the coefficients are of non-zero-valued values, including a significant number, e.g., more than 2 that are not $\pm 1$. There is a breakpoint along the path of the ordering of the coefficients to identify a first, e.g., low-frequency region in which the non-zero valued coefficients are substantially clustered and a second, e.g., high frequency region in which the non-zero valued coefficients are scattered.

***Class 3 (a clustered and small region and a scattered and small region):*** The non-zero-valued coefficients along the ordering of the coefficients are essentially dominated by coefficients that are $\pm 1$. There is a breakpoint along the path of the ordering of the coefficients to identify a first, e.g., low-frequency region in which these non-zero valued coefficients are substantially clustered and a second, e.g., high frequency region in which these non-zero valued coefficients are scattered.

***Class 4 (small and scattered):*** The non-zero-valued coefficients along the ordering of the coefficients are essentially dominated by coefficients that are $\pm 1$. The non-zero valued coefficients are scattered throughout the ordering such that there is no clear breakpoint along the path of the ordering of the coefficients to identify a first region, e.g., low frequency region in which non-zero-valued coefficients are clustered, and a second, e.g., high frequency region in which these non-zero valued coefficients are scattered.

For each class, a corresponding coding process is used which may include using a combination of coding methods. The following are the coding methods used.

**An exemplary clustered and large-value region method.**

The following combination of encoding methods, in combination called "the clustered and large-value region method" is used for a region-which may be the complete block- in which the non-zero-valued coefficients-in general coefficients having other than the most likely-to-occur values-include a number having an amplitude larger than 1-in general, an amplitude other than the next to most likely-to-occur value, and in which the non-zero-valued coefficients-in general coefficients having other than the most likely-to-occur values-are clustered. The method includes identifying runs of non-zero-valued coefficients and runs of zero-valued coefficients. The lengths of the runs of non-zero-valued coefficients are encoded using a first runlength coding method. The amplitudes in the runs of non-zero-valued coefficients are encoded using a first amplitude coding method. The signs of the non-zero-valued coefficients are encoded using a sign bit. The lengths of the runs of zero-valued coefficients are encoded using a second runlength coding method. See the above-described Basic Hybrid VLC Method for more details of the first and second runlength coding methods and the first amplitude coding method.

In one embodiment, the first and second runlength coding methods are each implemented using runlength coding tables, e.g., such that encoding using the first runlength coding method includes looking up a first coding table, and encoding using the second runlength coding method includes looking up a second coding table.

Tables 3 and 4 above are exemplary runlength code tables for variable length coding runs of consecutive non-zero-valued coefficients and runs of consecutive zero-valued coefficients, respectively. C(n) and C'(z) denote the codes for runs of n consecutive non-zero-valued coefficients and z consecutive zero-valued coefficients, respectively, where n and z are the runlengths, n,z=1, 2, ....

As an example, assuming the ordered series of quantized coefficients along the ordering path in the first frequency region starts with:

$$2\ 3\ 2\ {-1}\ 0\ 1\ 2\ 0\ 0\ 1\ {-1}\ 1\ 0\ 0 \ldots$$

To determine the runlengths, this series may be written as:

$$x\ x\ x\ x\ 0\ x\ x\ 0\ 0\ x\ x\ x\ 0\ 0 \ldots$$

where x represents any non-zero-valued coefficient and 0 represents a zero-valued coefficient.

Denoting by r(n) the run of n consecutive non-zero-valued coefficients, and r'(z) the run of z consecutive zero-valued coefficients, the ordered sequence of the example then starts with:

$$r(4)\ r'(1)\ r(2)\ r'(2)\ r(3)\ r'(2) \ldots$$

The result of encoding the runlengths but not amplitudes of this pattern can then be written as:

$$C(4)\ C'(1)\ C(2)\ C'(2)\ C(3)\ C'(2) \ldots$$

To complete the coding method, included with the codeword of each run of non-zero-valued coefficients are codewords for each amplitude in the run, and further bits for the sign of each coefficient for transform whose coefficients can be positive or negative, e.g., the commonly used DCT transform. In one embodiment, the amplitudes are each encoded using a variable length code, and the signs are each encoded using a sign bit. Denote by A(k), k=1,2,3,... the amplitude codes for amplitudes 1, 2, ..., respectively, according to the first amplitude coding method, denote by $S_+$ and $S_-$ the sign bit codes for positive and negative coefficients, respectively, and denote concatenation by +. The example sequence above is then encoded as follows:

$$[c(4) + A(2) + S_+ + A(3) + S_+ + A(2) + S_+ + A(1) + S_-\} + c'(1) +$$
$$[c(2) + A(1) + S_+ + A(2) + S_+] + c'(2) +$$
$$[c(3) + A(1) + S_+ + A(1) + S_- + A(1) + S_+] + c'(2) \ldots$$

In one embodiment, the A(k), k=1, 2, ... are variable length codes such that the most likely-to-occur non-zero amplitude, typically 1, has a shorter codeword A(1) than the codewords for other less likely-to-occur amplitudes.

In one embodiment, it is assumed that the series-or region if the method is for a region of a series of coefficients-starts with a run of one or more non-zero-valued coefficients. Therefore, the first codeword is always a codeword from the runlength coding method of the first kind. A code is included for when the series (or region) starts with a run of one or more zeros to indicate that the first code used is the code for runs of zeroes. In one embodiment in which the first region of the series, or the whole series is encoded using the clustered and large-value region method, the DC component is separately sent, such that the first coefficient is the first non-DC coefficient along the ordering.

Thus, for example, indicating by RP the codeword in the coding method of the first kind that indicates starts with a run of one or more zero-valued coefficients, suppose the series (sub-series) of coefficients starts with:

$$0\ 2\ 3\ 2\ {-1}\ 0\ 1\ 2\ 0\ 0\ 1\ {-1}\ 1\ 0\ 0 \ldots$$

In one embodiment, the codewords for this series or sub-series part is:

$$RP + C'(1) + [C(4) + A(2) + S_+ + A(3) + S_+ + A(2) + S_+ + A(1) + S_-] + C'(1) +$$
$$[C(2) + A(1) + S_+ + A(2) + S_+] + C'(2) +$$
$$[C(3) + A(1) + S_+ + A(1) + S_- + A(1) + S_+] + C'(2) \ldots$$

In another embodiment, a codeword is included in the coding method that indicates that the series has no non-zero values. In another embodiment, in which the clustered and large-value region method is used for a first region, such a codeword is also used to indicate that all remaining coefficients in the first region are zero. This codeword is called skip-to-boundary (SKP) herein. Note that the SKP code equivalent to an end of block (EOB) code if there are no non-zero coefficient in the next region(s) or if there is no second region.

**An exemplary scattered region method**

The following combination of methods, in combination called "the scattered region method" is used for a region-which may be the complete block-in which the non-zero-valued coefficients-in general those having other than the most likely-to-occur values-include a significant number of larger than 1 amplitudes-in general amplitudes other than the next most likely to the most likely-to-occur amplitude, and in which the non-zero-valued coefficients are mostly scattered. The method includes identifying runs of none or more zero-valued coefficients-in general runs of none or more coefficients having the most likely-to-occur value. The lengths of the runs of zero-valued coefficients are encoded using a third runlength coding method. Each such run of none or more zero-valued coefficients ends in a single non-zero-valued coefficient. The amplitude of these non-zero-valued coefficients is encoded using a second amplitude encoding method. The signs of the non-zero-valued coefficients are encoded using a sign bit. See below, and also the above-described Basic Hybrid VLC Method for more details of the third runlength coding method and the second amplitude coding method.

In one embodiment, encoding using the third runlength coding method includes looking up a third runlength coding table.

Table 5 above is an exemplary coding table for variable length coding the runs of zero-valued coefficients in a region or series in which the non-zero-values are scattered and likely to include some coefficients of amplitude higher than 1. Table 5 describes a third runlength coding method that provides a code for each run of zero-valued coefficients. C"(z), z=0, 1,2, ... represents the runlength code used to encode a runlength of z consecutive 0's, where z = 0, 1, 2, ...

In one variant of the invention applicable to the final region when the series is divided into regions, or to a single region, an end code, denoted EOB herein, is used to indicate that the remaining coefficients in the final region or the series are all zero.

As an example, suppose that the scattered region is the second of two regions, and that the ordered series quantized coefficients along the pre-determined path for the scattered region is as follows:

$$0\,0\,0\,1\,0\,0\,1\,{-2}\,0\,0\,0\,0\,0\,1\,0\,0\ldots0.$$

This series may be written as:

$$0\,0\,0\,x\,0\,0\,x\,x\,0\,0\,0\,0\,0\,x\,0\,0\ldots0$$

where x represents any non-zero-valued coefficient and 0 represents a zero-valued coefficient.

Denote by r"(z) the runs of z consecutive zero-valued coefficients, z=0, 1, 2, .... In one embodiment, each non-zero valued coefficient in the series of the second region is assumed to be preceded by a run of zero-valued coefficients, so that the second of two consecutive non-zero-valued coefficients is preceded by a run of no zero-valued-coefficients (z=0). The above example ordered sequence of runs of zeroes in the second region may then be written as:

$$r''(3)\ r''(2)\ r''(0)\ r''(5)\ \mathrm{EOB}$$

where EOB is used to indicate that the remaining coefficients are all 0, and in which it is understood that there is exactly one non-zero-valued coefficient between each run of 0's. Using the codes of Table 5_for the runlengths, the result of encoding the runs in the series of the second region is then:

$$C''(3)\ C''(2)\ C''(0)\ C''(5)\ \mathrm{EOB}$$

If quantized coefficients along a specified path in the second region are of values greater than one then in one embodiment, the encoding process includes a variable length amplitude code after the runlength code to encode the amplitude of the non-zero-valued coefficient, and a sign code for the non-zero-valued coefficient that follows the run of 0's. Denote by A"(k), k=1,2,3,... the variable length amplitude codes according to the second amplitude coding method for amplitudes 1, 2, ...respectively, denote by $S_+$ and $S_-$the sign bit codes for positive and negative coefficients, respectively, and denote concatenation by +. The above example sequence of the second region is then encoded as follows:

$$[C''(3)+A''(1)+S] + [C''(2)+A''(1)+S_+] + [C''(0)+A''(2)+S_-] +$$

$$[C''(5)+A''(1) +S_+] + EOB.$$

In one embodiment, the A"(k), k=1, 2, ... are variable length codes such that the most likely-to-occur non-zero amplitude, typically 1, has a shorter codeword A"(1) than the codewords for other less likely-to-occur amplitudes.

Note that in one embodiment, the second amplitude coding method (the A" (k) values, k=1, 2, ...) for quantized coefficient amplitudes that occur in the second region is different from the first amplitude coding method (the A(k) values, k=1, 2, ...) for quantized coefficient amplitudes that occur in a clustered and large-value region. In an alternate embodiment, the same amplitude coding is used as the first and second amplitude codes A(k) and A"(k), respectively.

In another embodiment, the conventional 2D-VLC method is used for regions in which the non-zero-valued coefficients include a significant number of larger than 1 amplitudes, and in which the non-zero-valued coefficients are mostly scattered.

**An exemplary scattered and small-value region method**

The following combination of methods, in combination called "the scattered and small-value region method" is used for a region-which may be the complete block-in which the non-zero-valued coefficients are dominated by amplitude-1 coefficients, and in which the non-zero-valued coefficients are mostly scattered. The method includes identifying runs of none or more of zero-valued coefficients that end in a single non-zero-valued coefficient. The lengths of the runs of zero-valued coefficients that end in the non-zero-valued coefficient are encoded using a fourth runlength coding method as described for encoding the high-frequency region in the above-described Extended Hybrid VLC Method. The encoding assumes that the ending non-zero-valued coefficient has amplitude 1, and no further amplitude encoding is included for such events. Non-amplitude-one ending coefficients are assumed to be exceptions. Such exceptions are identified, and an exception code (also called an escape code) is used to indicate such exceptions. The amplitude of these non-zero-valued coefficients of amplitude greater than 1 is encoded using a third amplitude encoding method. The signs of the non-zero-valued coefficients are encoded using a sign bit. See below, and also the encoding of the high frequency region in the above-described Extended Hybrid VLC Method for more details of the fourth runlength coding method and the third amplitude coding method.

The codes according to the fourth runlength coding method may be represented in a table. Table 11 above shows a table for such codes. C'"(z), z=0, 1, 2, ... represents the runlength code used to encode a runlength of z consecutive 0's ending in a non-zero-valued coefficient in such region or the whole series. Tabel 11 also includes a code to indicate when the ending non-zero-amplitude is other than the most common non-zero amplitude, i.e., an amplitude greater than 1. Because such events are regarded as not very likely, we call them "'exceptions." An exception is indicated as Exc in Table 11. Such an exception is encoded according to an aspect of the invention by the codeword as if the run of 0's ended in 1 followed by an escape code, denoted ESC'", followed by an encoding of the amplitude according to the third amplitude encoding method.

Another aspect of the invention is that an end code, denoted EOB herein, is used to indicate that the remaining coefficients in the second region are all zero.

As an example, suppose the ordered series quantized coefficients along the pre-determined path for a scattered and small-value region is:

$$0\,0\,0\,1\,0\,0\,2\,{-1}\,0\,0\,0\,0\,0\,1\,0\,0 \ldots 0.$$

Denote by r'"(z) the run of z consecutive zero-valued coefficients that end in a non-zero amplitude of 1, and by r'"(z)+Esc the run of i consecutive zero-valued coefficients that end in a non-zero amplitude greater than 1, where zi=0,1, 2... In one embodiment, each non-zero valued coefficient in the series of the second region is assumed to be preceded by a run of zero-valued coefficients, so that the second of two consecutive non-zero-valued coefficients is preceded by a run of non-zero-valued-coefficients (z=0). The runs of the series of the scattered and small-value region may then be written as:

$$r'''(3)\ [r'''(2)+Exc''']\ r'''(0)\ r'''(5)\ EOB.$$

where EOB is used to indicate that the remaining coefficients are all 0, and in which it is understood that there is exactly one non-zero-valued coefficient between each run of 0's. If quantized coefficients along a specified path in the scattered and small-value region are of values greater than one then in one embodiment, the encoding process includes a amplitude code using the third amplitude coding method after the runlength code and the exception code to encode the amplitude of the non-zero-valued coefficient, and a sign code for the non-zero-valued coefficient that follows the run of 0's. Denote by A'''(k), k=2,3,... the amplitude codes for amplitudes 2, 3,...respectively, using the third amplitude encoding method, and denote by $S_+$ and $S_-$the sign bit codes for positive and negative coefficients, respectively, and denote concatenation by +. Using the codes of Table 11 for the runlengths, the result of encoding the runs in the series of the second region is then:

$$[C'''(3)+S_+] + [C'''(2)+ESC'''+A'''(2)+S_+] + [C'''(0)+S_-] +$$
$$[C'''(5)+S_+] + EOB,$$

where EOB is also used here to denote the codeword to indicate the remaining coefficients are zero-valued, and ESC'" is the escape code for the exception in the second region.

In one embodiment, the third amplitude coding method (the A'''(k) values, k= 2, 3,...) for quantized coefficient amplitudes uses a variable length code, such that, assuming an amplitude 2 is more likely-to-occur than larger amplitudes, the amplitude code A'"k is shorter than the code for amplitudes larger than 2.

Note further that that in one embodiment, the third amplitude coding method (the A"(k) values, k= 2, 3,...) for quantized coefficient amplitudes is different from the first amplitude coding method (the A(k) values, k=1, 2, ...) and the second amplitude coding method (the A"(k) values, k=1, 2, ...) for quantized coefficient amplitudes.

**An exemplary clustered and small-value region method**

The following combination of methods, in combination called "the clustered and small-value region method" is used for a region-which may be the complete block-in which the non-zero-valued coefficients are dominated by amplitude-1 coefficients, and in which the non-zero-valued coefficients include significant clusters. The method includes identifying runs of amplitude-1 coefficients and runs of zero-valued coefficients. The lengths of the runs of amplitude-1 coefficients are encoded using a fifth runlength coding method, which in one embodiment is the same as the first runlength coding method described for encoding the non-zero-valued coefficients in the low frequency region in the above description and in the above-described Basic and Extended Hybrid VLC Methods. In another embodiment, the fifth runlength coding method is different than the first. The signs of the amplitude-1 coefficients are encoded using a sign bit. The method further includes identifying each non-amplitude-one, non-zero-valued coefficient. The amplitudes of these non-zero-valued coefficients of amplitude greater than 1 are encoded using a fourth amplitude encoding method, which in one embodiment is the same as the third amplitude encoding method used in the scattered and small-value region method, and in another embodiment, is a different amplitude encoding method. The signs of the non-amplitude-1, non-zero-valued coefficients are encoded using a sign bit. The lengths of the runs of zero-valued coefficients are encoded using a sixth runlength coding method, which in one embodiment is the same as the second runlength coding method described above for encoding the runs of zero-valued coefficients in the low-frequency region, also described in the above-described Basic and Extended Hybrid VLC Methods. In another embodiment, the sixth runlength coding method is different from the second.

In an alternate embodiment of the clustered and small-value region method, the method includes identifying runs of non-zero-valued coefficients and runs of zero-valued coefficients. The lengths of the runs of non-zero-valued coefficients are encoded using the fifth runlength coding method. The encoding assumes that the non-zero-valued coefficient has amplitude 1, and no further amplitude encoding is included for such events. The signs of the non-zero-valued coefficients are encoded using a sign bit. The method further includes identifying each non-amplitude-one, non-zero-valued coefficient. Such coefficients are assumed to be rare ("exceptions"). Such exceptions are identified, and an exception code (also called an escape code) is used to indicate such exceptions. The amplitude of these non-zero-valued coefficients of amplitude greater than 1 is encoded using the fourth amplitude encoding method. The lengths of the runs of zero-valued coefficients are encoded using the sixth runlength coding method.

The above-described methods or combinations of methods are then used in the appropriate regions in each class of block as follows.

Note that how to determine the codes for the coding tables is straightforward according to the statistical distribution of the coefficients in the image blocks. In one embodiment, statistics are collected of typical images, and runlength code tables are constructed according to the statistics. See for example, above-described Basic Hybrid VLC Method and Extended Hybrid VLC Method for more description.

For a class 1 block, the corresponding coding process (method or combination of methods) is the clustered and large-value region method.

For a class 2 block, the corresponding encoding method or combination of methods includes establishing a breakpoint along the path of the ordering of the coefficients to identify a first, e.g., low-frequency region and a second, e.g., high frequency region. The encoding of low frequency coefficients uses the clustered and large-value region method, and the encoding of the second, e.g., high-frequency region includes using the scattered region method.

For a class 3 block, the corresponding encoding method or combination of methods includes establishing a breakpoint along the path of the ordering of the coefficients to identify a first, e.g., low-frequency region and a second, e.g., high frequency region. The encoding of low frequency coefficients uses the clustered and small-value region method, and the encoding of the second, e.g., high-frequency region includes using the scattered and small-value region method.

For a class 4 block, the corresponding encoding method or combination of methods is the scattered and small-value region method.

FIG. 11 shows a flow chart of a method embodiment of the invention. For an ordered sequence of quantized transform coefficients of a block of image data, step 1101 scans the ordered series of quantized coefficients to determine which class the coefficient block belongs to. According to the determined class, the next step is one of steps 1105-1, 1105-2, 1105-3, and 1105-4, which respectively carry out the coding processes corresponding to class 1, class 2, class 3, and class 4. The results are the encoded bitstreams for the coefficients of the block. According to the determined class, the next step is one of steps 1107-1, 1107-2, 1107-3, and 1107-4, which each applies a 2-bit prefix to the determined bitstream corresponding to the determined class of the block.

While in one embodiment, a fixed two-bit code is used to indicate the class, in another embodiment, in the case that some class or classes is/are more likely-to-occur than others, a variable length code with an average length of less than 2-bits is used to identify the class. Note also that the adding of the indication of the class can be carried out before, after, or even as part of the actual encoding process. Furthermore, if it is likely that blocks that follow each other, e.g., that correspond to a particular region in a region, have the same class, an indication is only added between blocks to indicate a change from one block class to another, rather than the indication used for each block.

In an alternate embodiment, rather than a code to indicate the class preceding each set of codewords for the block, a differential codeword indicating the difference in the class is be used. Such differential encoding is likely to require fewer bits because it is likely that blocks that follow each other are highly correlated.

Furthermore, for use in some types of coded data streams, e.g. MPEG, each video sequence may be grouped. In MPEG-1, for example, each video sequence is composed of a series of Groups of Pictures (GOP's). A GOP is composed of a sequence of pictures (frames). A frame is composed of a series of SLICEs. A SLICE is composed of a series of macroblocks, and a macroblock is composed of a small number of blocks, e.g., (4 for luminance and 2 for chrominance) and possibly a motion vector. For such an embodiment, the classification may be made at the higher level, e.g., macroblocks, or at the level of a SLICE, or at the level of a GOP. This provides for less overhead to indicate the class.

In yet another embodiment, the class codes is sent separately. A first class is selected for the first block. A runlength code for the number of blocks to skip until the next change of class is sent, together with an indication of the next code. This is continued until the class of all codes is sent.

**The classification in the Multiple-Class VLC Method**

The classifications of a series of quantized coefficients in one embodiment includes different classifications according to the type of image block. In such an embodiment, the plurality of classes depends on one or more of whether the image block is for:

- still image coding vs. moving image coding;
- intraframe image coding vs. interframe coding;
- standard definition television (SDTV) images vs. high definition television (HDTV) images;
- high bit rate coding methods vs. low bit rate coding methods;
- DCT vs. non-DCT transforms;

and so forth.

Thus, different sets of classes, classifications, and corresponding coding processes exist for blocks according to on one or more of the above types of image blocks.

The classification process itself uses the data of the series of coefficients in the blocks, such that different classifications typically exist in the same image frame. Such classification is called data-dependent classification.

One version of the data-dependent classification process of step 1101 includes examining the statistical distribution of the coefficients in the blocks. The classification process uses one or more of the following set of statistical measures: the run lengths of consecutive non-zero-valued coefficients, the run lengths of consecutive zero-valued coefficients, the amplitude of the non-zero-valued coefficients, and the separability of the series into two contiguous sub-series, a first sub-series with clustered coefficients and a second sub-series with scattered non-zero-valued coefficients.

The preferred method classifies by calculating the results of applying the coding processes corresponding to the different classes, and compares the resulting compression achieved by applying the corresponding coding processes. FIG. 12 shows a flow chart of a method embodiment that includes as part of step 1101, scanning the ordered series of quantized coefficients to determine which class the coefficient block belongs and step 1103 of selecting the class, the steps of coding the blocks (steps 1105-1,..., 1105-4) by each corresponding coding process and comparing the result to select the method that provides the best compression, i.e., the least number of bits for the coded block. In step 1206, the selecting of the best class for a block is by selecting the code that leads to the fewest bits in the coded data. Following the selection, because the coding step would already have been carried out, step 1207 applies the indication, e.g., as a prefix code. In some embodiments, adding the prefix code may be carried out earlier.

FIG. 13 shows a flowchart of one implementation wherein the applying of the corresponding encoding processes is carried out sequentially on the series of coefficients. After each such processing by a corresponding process, a comparison is made and the set of codewords for that process that produces the least number of coded bits, i.e., the better compression is maintained, as well as an indication of the class selected. The coding by each of the class's corresponding process, of course, can be in any order, and is shown in FIG. 13 as the method of class 1, followed by that for classes 2, 3, and 4. As shown in FIG. 12, in steps 1205-1, ..., 1205-4, the series of quantized coefficients is coded by each of the four coding processes corresponding to the four different classes, and in step 1307-1 the first result is saved, then in steps 1307-2, 1307-3, and 1307-4, the previously saved result is compared with the newly calculated result of step 1205-2, 1205-3, and 1205-4, respectively, and if the new result is better than that saved, the better result is saved. Thus, after step 1205-4, the best result is saved. In step 1309, the code, e.g., 2-bit code indicating the class is added, e.g., as a prefix. In an alternate, the prefix is added whenever the first or better result is saved in steps 1307-1, 1307-2, 1307-3, and 1307-4 respectively. In such an embodiment, step 1309 is not carried out at the end.

FIG. 14 shows a flowchart of another implementation wherein the coding processes 1205-1, 1205-2, 1205-3, and 1205-4, respectively, that correspond to each respective class are carried out in parallel on the series of coefficients. At the end of the methods being applied, in step 1407, a comparison is made of the results and the class chosen according to which corresponding coding processes produced the least number of coded bits. In a step 1409, the code, e.g., 2-bit code indicating the class is added, e.g., as a prefix.

**The breakpoint defining the regions in the Multiple-Class VLC Method**

Some of the classes described above include a breakpoint that defines a first, e.g., low frequency, and a second, e.g., high frequency region for the series of quantized transform coefficients. The following discussion applies to such classes and the corresponding coding processes that include selecting a breakpoint to define the regions.

For such classes, one version uses a fixed breakpoint between the first and the second region. How to pre-select such a region is described above for the Hybrid VLC Method and the Extended Hybrid VLC Method.

The above discussion of breakpoints assumes a single breakpoint, and two regions in the ordering for those classes that include two regions.

More or fewer classes may be used, and some classes may include more than two regions, i.e., more than one breakpoint.

As another example, consider a method that includes classification into two classes as follows:

Class A: the ordered series of coefficients include coefficients of relatively large value, albeit with amplitude 1 being the most likely non-zero amplitude, amplitude 2 the next most likely amplitude, and so forth, with a breakpoint definable to divide the series into a low frequency region and a high frequency region, such that the non-zero-valued coefficients are clustered in the low frequency region and scattered in the high frequency region.

Class B: the non-zero-valued coefficients in the ordered series of coefficients are dominated by amplitude-1 coefficients, with a breakpoint definable to divide the series into a low frequency region and a high frequency region, such that the non-zero-valued coefficients are clustered in the low frequency region and scattered in the high frequency region.

In one embodiment that includes classes A and B, the following combinations of methods correspond to each class:

For a Class A blocks: the corresponding encoding method or combination of methods includes establishing a breakpoint along the path of the ordering of the coefficients to identify a first, e.g., low-frequency region and a second, e.g., high frequency region. The encoding of low frequency coefficients uses the clustered and large-value region method, and the encoding of the second, e.g., high-frequency region includes using the scattered region method.

For a class B block: the corresponding encoding method or combination of methods includes establishing a breakpoint along the path of the ordering of the coefficients to identify a first, e.g., low-frequency region and a second, e.g., high frequency region. The encoding of low frequency coefficients uses the clustered and small-value region method, and the encoding of the second, e.g., high-frequency region includes using the scattered and small-value region method.

In addition, a single overhead bit is used as an indication of the class of each block. In one embodiment, the one bit indication is used as a prefix before the encoded bits.

As yet another example, there may be more than two regions defined in one or more of the classes, one class may include a first, low frequency region where it is reasonably likely that there are runs of zero-valued coefficients and runs of non-zero-valued coefficients of value one or more, a second, mid-frequency region where it is reasonably likely that there are runs of zero-valued coefficients, and runs of coefficients of value one, but where there is not likely to be runs of coefficients greater than one, and a third high-frequency region where it is reasonably likely that there are runs of zero-valued coefficients, but not many runs of non-zero-valued coefficients. The corresponding coding process (method or combination of methods) for such a class includes using two breakpoints to define a first, second, and third region. In the first region, runs of non-zero-valued coefficients and runs of zero-valued coefficients are identified, and the run-lengths of the non-zero amplitude and zero-amplitude coefficients are encoded using a first runlength coding method and a second runlength coding method. In the second region, runs of coefficients of amplitude-one, and runs of zero-valued coefficients are identified, and the runlengths of the amplitude-one and zero-amplitude coefficients are encoded using a third runlength coding method and a fourth runlength coding method, respectively. In the third region, runs of zero-valued coefficients are identified, and the runlengths of such zero-valued-runs are encoded using a fifth runlength coding method.

The invention is not limited to any particular set of classes or to any particular corresponding coding processes for classes. Only some examples of classes and corresponding coding processes have been described. It is anticipated that other new coding processes may be invented in the future, and that other coding processes already exist, and such other coding processes may be used in different embodiments of the invention.

*The Joint Position and Amplitude VLC Method*

In the Basic Hybrid VLC Method and the Extended Hybrid VLC Method, the consecutive non-zero-valued coefficients and the consecutive zero-valued coefficients in the low frequency region are coded alternatively using two independent one-dimensional variable length coding methods. It is desirable to pair the consecutive non-zero-valued coefficients and zero-valued coefficients as a single event and apply a single variable length to the pair.

An aspect of the present invention encodes, using a variable length code, events of a run of consecutive zero-valued coefficients that are followed by a run of consecutive-non-zero-valued coefficients followed by single zero-value. The inventors believe this provides an efficient code for a series of coefficients, or a region of such a series wherein the non-zero-valued coefficients may cluster.

Consider first traditional 2D-VLC. FIG. 15 presents Table 1 above that presents, as an example, the statistics of events for traditional 2D-VLC tabulated as a two dimensional table. This version of Table 1 uses a slightly different notation than Table 1 above. In the table of FIG. 15, $S_{2D}(z,m)$ is the likelihood expressed, for example, as a relative number of occurrences of a run of i consecutive zero-valued-coefficients, z=0,1, 2, ... followed by an amplitude of m, m=1, 2, ...

In 2D-VLC, a variable length code such as an optimal code is assigned to each, or least some of the events that have an $S_{2D}(z,m)$ above, with the most likely-to-occur element having the shortest number of bits, and the least occurring event coded using the longest number of bits. FIG. 16 shows the same table as Table 2 above that presents, as an example, a 2D-VLC table, but with a slightly different notation. In FIG. 16, $C_{2D}(z,m)$ is the codeword used to encode the event of the combination of z consecutive 0-valued coefficients followed by a single non-zero coefficient of magnitude or amplitude m, z=0,1,... and m=1, 2, ....

Suppose the series of quantized transform coefficients is:

$$5100342000201030000000000000000000000100000000000001000000000000 0.$$

Such a series would be encoded in conventional 2D-VLC as:

$$C_{2D}(0,5)+C_{2D}(0,1)+C_{2D}(2,3)+C_{2D}(0,4)+C_{2D}(0,2)+C_{2D}(3,2)+C_{2D}(1,1)+$$
$$C_{2D}(1,3)+C_{2D}(21,1)+C_{2D}(13,1)+EOB$$

where + represents concatenation, and where $C_{2D}$(z,m) denotes the 2D-VLC code, z denotes the number of zero-value coefficients preceding a non-zero-amplitude value, and m represents the amplitude-also called magnitude ignoring the sign-value to be encoded, and where EOB represents a code that indicates the end of the block, i.e., all remaining coefficients are zero-valued. Note that the above does not include encoding the sign of the coefficients. Those in the art will understand that coefficients may be positive or negative, and that each non-zero coefficient value is therefore further encoded by a sign bit to indicate the sign, or, in an alternate embodiment, each non-zero coefficient is encoded in its entirety including the sign. Signs are not included in the discussion in order not to obscure the inventive aspect.

It is common to separately encode the DC term-the first transform coefficient-using a separate amplitude code. Let DC(m) indicate the codeword for the DC amplitude. In such a method, the above set of coefficients would be encoded using conventional 2D-VLC as:

$$DC(5)+C_{2D}(0,1)+C_{2D}(2,3)+C_{2D}(0,4)+C_{2D}(0,2)+C_{2D}(3,2)+C_{2D}(1,1)+C_{2D}(1,3)$$
$$+C_{2D}(21,1)+C_{2D}(13,1)+EOB$$

wherein EOB is the code indicating that the remainder of the series is a run of zero-valued coefficients and + represents concatenation. In practice, some of the less likely-to-occur events are coded with an escape code followed by a fixed length codeword.

The Basic Hybrid and Extended Hybrid VLC Methods use the observation that for many series of quantized transform coefficients, there is a breakpoint that defines a first region in which there are non-zero-valued coefficients that are clustered, and a second, e.g., high frequency region in which most non-zero-valued coefficients are scattered. In the first region, runs of zero-valued coefficients and runs of non-zero-valued coefficients are identified. A first variable length code is used for the runs of zero-valued coefficients, and a second runlength code is used for the runs of non-zero-valued coefficients. Thus, two one-dimensional runlength codes are alternately applied. The DC is separately encoded. It is assumed that the series starts with a run of non-zero-valued coefficients, and a particular codeword indicates that this is a null run, i.e., that the series starts with a zero-valued coefficient.

Consider the series above (excluding the DC term):

$$10034200020103000000000000000000000100000000000001000000000000.$$

Consider first the Basic Hybrid Method. Assume for simplicity that no sign bits are included in the coding. Suppose that a breakpoint is established at 15 that defines a first region up to 15 wherein the non-zero-coefficients tend to cluster, and a second region wherein the non-zero-valued coefficients tend to scatter. In such a case, denoting by x a non-zero-valued coefficient, the first region of the series (without a DC term) may be written as:

$$x00xxx000x0x0x$$

and the second region as:

$$0000000000000000000x0000000000000x000000000000.$$

Denote by r(n) the run of n consecutive non-zero coefficients, and r'(z) the run of z consecutive zero-valued coefficients in the first region, n,z=1,2,.... The ordered sequence of the example then starts with:

$$r(1)\ r'(2)\ r(3)\ r'(3)\ r(1)\ r'(1)\ r(1)\ r'(1)\ r(1)\ SKIP$$

For the second region, denote by r'' (z), z=0,1, ..., runs of consecutive zero-valued coefficients. Then, according to the Basic Hybrid method, the second region has the events:

$$r''(20)\ r''(13)\ \mathrm{End}$$

where SKIP denotes that the remainder of the coefficients to the breakpoint are zero and End denotes that the remainder of the coefficients are zero.

Denote by c(n) the variable length code according to a first variable length coding method for encoding the runlengths of the non-zero-valued coefficients. Similarly denote by c'(z) the variable length code according to a second variable length coding method for encoding the runlengths of the zero-valued coefficients in the first region. Further denote by A(m) the codeword used to encode the amplitude m, m=1, 2, ... of non-zero-valued coefficients in the first region according to a first amplitude coding method, and denote by A"(m) the codeword used to encode the amplitude m, m=1, 2, ... of non-zero-valued coefficients in the second region according to a second amplitude coding method.

Leaving out sign bits, the first region would then be encoded as:

$$c(1)+A(1)+c'(2)+c(3)+A(3)+A4+A(2)+c'(3)+c(1)+A(2)+c'(1)+c(1)$$
$$+A(1)+c'(1)+c(1)+A(3)+\mathrm{Skip}$$

and the second region would be encoded as:

$$c''(20)+A''(1)+r''(13)+A''(1)+\mathrm{EOB}$$

where Skip and EOB represent codewords indicating that the remainder of the series has only zero-valued coefficients, and + represents concatenation. Note that according to the Extended Hybrid VLC Method, coefficient amplitudes are assumed to be 1, such that runs of zero-valued-coefficients ending in a single amplitude-1-coefficient require no further amplitude encoding. Amplitudes greater than 1 are encoded by an exception code followed by an amplitude code for amplitudes greater than 1. Thus, the second region would not include the amplitude codes, since they are for amplitude 1.

In practical implementations of conventional 2D-VLC, in order to reduce the size of the coding tables, some of the less likely-to-occur events are encoded with fixed length codewords that are preceded with what are called escape codes.

One aspect of the present invention is avoiding using escape codes.

Another aspect of the present invention is a method that includes, for a first region of the series, identifying one or more events, each including a run of zero-valued coefficients followed by a run of non-zero-valued coefficients. The method further includes encoding each such identified event by a single variable length code, e.g., from a single table. With the Basic and Extended Hybrid Methods, such pair of events would be encoded by two codewords according to the first and the second one-dimensional runlength coding methods.

In one embodiment, the first region is the whole series of the quantized transform coefficients. For simplicity, this case will be the first considered.

Each identified event may be defined by the runlengths of the zero-valued and non-zero-valued coefficients. Denote by R'(z,n) a run of z consecutive zero-values coefficients followed by n non-zero-valued coefficients, with z=0,1, 2, ..., and n=1, 2, 3, ...., such that a "run" of no preceding zero-valued coefficients is included.

FIGS. 17A-17D show Tables 12A-12D that each show examples of events. In the patterns, an "x" indicates a non-zero value.

Consider again the series:

$$5100342000201030000000000000000000000100000000000001000000000000.$$

The events of the such a series, excluding the DC term (the amplitude 5) and not including any sign data, are:

$$R'(0,1),R'(2,3),R'(3,1),R'(1,1),R'(1,1),R'(21,1),R'(13,1),\mathrm{End}$$

where End indicates the remainder of the series consists of zero-valued-coefficients.

In one implementation, statistics are collected or assumed for each event, e.g., in a table such as Table 13 shown in FIG. 18, in which S'(z,n) denotes the assumed or measured relative likelihood for the event R'(z,n), z=0, 1, 2, ... and n=1, 2, ..... Table 14 shown in FIG. 19 is a variable length code table formed based on the assumed or collected statistics of Table 13. In Table 14, C'(z,n) denotes the variable length code for the event R'(z,n), z=0, 1,2, ... and n=1, 2, .... Note that in one implementation, such a table is used to encode only a region, e.g., the first low frequency region of a series of coefficients. For such a situation, a code is also needed to indicate that all coefficients are zero, in order to skip to the next region.

Further, any non-zero-valued coefficients are encoded by an amplitude code, which in one embodiment is implemented by using variable length code presented as a coding table according to the assumed or collected statistics. Let A(m), m=1, 2, ..., denote the code for the quantized value m according to the amplitude coding table.

Thus, for the above series, excluding the DC term and the sign of the coefficients, the series would be coded as follows:

$$C'(0,1)+A(1)+C'(2,3)+A(3)+A(4)+A(2)+C'(3,1)+A(2)+C'(1,1)+A(1)+C'(1,1)+$$
$$A(3)+C'(21,1)+A(1)+C'(13,1)+A(1)+EOB$$

where EOB is the codeword for End that indicates all the remaining codewords are 0, and where + indicated concatenation.

Since a run of non-zero-valued coefficients is followed by at least one zero-valued coefficient, or ends the series, in an improved implementation, events identified and encoded by the method include a run of zero-valued coefficients followed by a run of non-zero-valued-coefficients, followed by a single zero-valued coefficient. With such events, more coefficients are encoded by each event. The coding is expected to provide more compression.

The possible number of such events is rather large, so that the code table that results may be rather large. In conventional prior art 2D-VLC, the size of the table is restricted by adding Escape codes followed by fixed length codes for events that are less likely-to-occur. In one embodiment of the present invention, the size of the code table is also limited such that events up to a maximum total number of coefficients only are encoded, with an additional code provided for an event of all zeroes of the maximum length, and for maximal length events that end in a non-zero-coefficient. These special maximal-length events provide for avoiding using escape codes.

Thus denote by R(z,n) a run of z consecutive zero-values coefficients followed by n non-zero-valued coefficients followed by a single zero-valued coefficient, with z=0,1, 2, ..., and n=1, 2, 3, .... Suppose the events are truncated to no more than 12 coefficients. Then for those events of length less than 12, z+n=11. Some of the events of 12 coefficients for which z+n=12 are events that end in a non-zero-valued coefficient and can be considered "truncated" in that, if followed by an event that starts with a non-zero-valued coefficient, such events avoid using Escape codes. One event, R(12,0) of all zeroes is also a truncated event.

As an example, FIGS. 20A-20F show Tables 15A-15F, respectively, that each show examples of events. In the patterns, an "x" indicates a non-zero value. The events are truncated to cover no more than 12 consecutive coefficients. Events of length 12 for which z+n=12 are indicated by "No zero at end; avoids escape" in FIG. 20F. Also, the event R(12,0) is shown and marked "All zeroes."

FIG. 21 shows Table 16 of collected or assumed relative likelihoods for events of runs of none or more zero-valued-coefficients followed by a run of a number of non-zero-valued coefficients followed by a single zero-valued-coefficient, except that some length 12 events according to an embodiment of the invention, do not so end. Those length-12 events distinguished by having z+n=12 are shown in boldface, and may be used to avoid end or Escape codes.

FIG. 22 shows Table 17 of variable length codes for the events shown in FIG. 21 according to the statistics of FIG. 21. The codes are for runs of none or more zero-valued-coefficients followed by a run of non-zero-valued coefficients followed by a single zero-valued-coefficient according to an embodiment of the invention.

The amplitudes are encoded according an amplitude code, which in one embodiment is a variable length code described by a one dimensional amplitude table. Denote by A(m) the code for the amplitude m, m=1, 2, ...

Consider again the series:

5 10 03420 0020 10 30 000000000000 0000000010 000000000000
10 000000000000

where the first value is the DC value. The events of the such a series, excluding the DC term and not including any sign data, are:

R(0,1),R(1,3),R(2,1),R(0,1),R(0,1),R(12,0),R(8,1),R(12,0),R(0,1),End,

where End indicates the remaining coefficients are all zero-valued. The series is encoded using Table 17 of FIG. 22 as:

$$C(0,1)+A(1)+C(1,3)+A(3)+A4+A(2)+C(2,1)+A(2)+C(0,1)+A(1)+C(0,1)+A(3)$$
$$+C(12,0)+C(8,1)+A(1)+C(12,0)+C(0,1)+A(1)+EOB,$$

where EOB indicates the end of block, i.e., that the remainder of the series is zero-valued coefficients. Recall, again, that the above assumes no sign information and excludes the DC term.

**Regions in the 2-D Non-Zero/Zero Cluster VLC Method**

The inventors observed that in actual series of quantized transform coefficients of image blocks, there is typically at least one breakpoint that defines at least two regions such that non-zero coefficients cluster in one region, and tend to be scattered in the second region. This is the basis of the Basic and Extended Hybrid VLC Methods.

**Two regions and the 2-D Non-Zero/Zero Cluster VLC Method**

The variable length coding method described herein is suitable for coding the whole region or any region. For example, the variable length coding method described is applicable to any region where non-zero-valued coefficients are clustered. According to the above-described Basic Hybrid and Extended Hybrid VLC Methods, an event R'(z,n) would be encoded by two runlength coding tables and a single amplitude coding table. Using aspects of the 2-D Non-Zero/Zero Cluster VLC Method, such an event may be encoded by a single runlength coding table and a single amplitude coding table. Furthermore, there may be regions where the statistics for such events are significantly different. For example, the inventors observed that at the start of a block, the first cluster of quantized coefficients has larger amplitudes than the later clusters.

In a first embodiment, the coding method includes establishing a breakpoint along the path of the ordering of the coefficients to identify a first, e.g., low frequency region and a second, e.g., high frequency region. The encoding of the coefficients in the first region includes identifying a joint event that includes a first run of one or more consecutive zero-valued coefficients followed by a second run of consecutive none or more non-valued coefficients followed by a single zero-valued coefficient. Each such event is identified by the number of zero-valued coefficients in the first run and the number of zero-valued coefficients in the second run.

In one version, each identified event only includes up to a pre-determined number of coefficients, called the maximal length herein. In such a situation, there may be a need for encoding a sequence of consecutive zero-valued coefficients followed by a run of non-zero coefficients, with the two runlengths being greater than the maximal length. For example, if the maximal length is 12, there would be a need to encode the following:

$$000xxxxxxxxxxxxx0$$

If any length events would be allowed, this would correspond to R(3,13). However, if the maximal length is 12, one embodiment splits this up into a first event:

$$000xxxxxxxxx$$

and a second event:

$$xxxx0.$$

Thus, in one embodiment in which a maximal length is defined, possible events include sequences that have the maximal length, and that end in a sequence of one or more non-zero-valued coefficients without the ending zero-valued coefficient. Such events would typically be followed in a region. This provides for encoding an event with more than the pre-determined number of coefficients as a plurality of events of at most the maximal length without using escape codes. Two or more events that together define a run of less than the maximal length zero-valued coefficients followed by a run of any length of non-zero-valued coefficients is called a "generalized event" herein in that it is treated as a single event for some purposes, including, for example, establishing the first and second region using what is called a soft boundary. See below for more details.

Furthermore, when a maximal length id is defined for an event, an event of all zero-valued coefficients is also defined to provide for coding of a "generalized event" that includes more than the maximal length of zero-valued coefficients followed by one or more non-zero valued coefficients followed by a single zero-valued coefficient.

How to establish the breakpoint is described above with reference to the Basic Hybrid VLC Method and the Extended Hybrid VLC Method.

FIG. 23 shows a table, Table 18, of actual statistics for events in a first region for a sample image with a breakpoint of 12 that forms a soft boundary. Note that this table includes a "skip" code to indicate to skip to the breakpoint, and corresponds to the event R(12,0) with the breakpoint at 12. In one alternate embodiment, any event R(12,0) within less that 12 coefficients from the boundary is also a skip event to skip to the start of the second region-applicable to a hard boundary, while in a second alternate embodiment applicable to a soft boundary, such an event would be included in the next region, with the boundary moved to the start of such an event.

In the above description, it is assumed that the signs of the non-zero-valued coefficients in each event are encoded using individual sign bits.

The coefficients in the second, e.g., high frequency region also may be coded by a similar method, but using a different second coding table for the events matched to assumed or measured likelihoods of the events in the second region. Such a second coding table, for example, would take into account the more scattered nature of non-zero coefficients in the second region. For relatively low-bit rate interframe coded images, such a code table would also take into account that the non-zero-valued coefficients would likely be dominated by amplitude 1.

In one alternate embodiment, traditional 2D-VLC is used for the second region.

In yet another alternate embodiment, the coefficients in the second region are encoded by a second-region method described in the Basic Hybrid Method. That is, each run of none or more zero-valued coefficients in the second region followed by a single non-zero-valued coefficient is identified and encoded by a runlength code using a variable length coding table, and the amplitude of the non-zero-valued coefficient is encoded by an amplitude coding method typically different than the amplitude coding method used for coefficients in the first region. An EOB code is used to indicate all remaining coefficients are zero-valued. A sign bit is used to encode the sign of the non-zero-valued coefficient.

In yet another alternate embodiment, the coefficients in the second region are encoded by a second-region method described in the Extended Hybrid Method that assumes non-zero-valued coefficients are dominated by amplitide-1 coefficients, such that no amplitude coding is used to encode an amplitude-1 coefficient, and an exception code followed by a codeword is used to encode any non-amplitude-1 coefficient. That is, each run of none or more zero-valued coefficients in the second region followed by a single non-zero-valued coefficient is identified and encoded by a runlength code using a variable length coding table. Any non-amplitide-1, non-zero coefficient is identified by an exception code and, for example, encoded by an Escape code, and the amplitude of such non-zero-valued, non-amplitide-1 coefficient is encoded by an amplitude coding method typically different than the amplitude coding method used for coefficients in the first region. An EOB code is used to indicate all remaining coefficients are zero-valued. A sign bit is used to encode the sign of the non-zero-valued coefficient.

**More than two regions and the 2-D Non-Zero/Zero Cluster VLC Method**

An alternate embodiment includes more than two regions, i.e., more than one breakpoint defining the more than two regions. The inventors, for example, have observed that the first cluster of non-zero-valued coefficients often have larger amplitude values than later clusters of non-zero-valued coefficients. Therefore, in one embodiment, a first region is defined by the first event of a run of none or more zero-valued coefficients followed by a run of consecutive non-zero-valued coefficients followed by a single zero-valued coefficient. Such an event is coded using a first variable length code, e.g., a first variable length coding table. The amplitudes of the non-zero-valued coefficients are coded using a first amplitude coding method, e.g., a first variable length amplitude code. The signs of each non-zero coefficient also are encoded using a sign bit. The first variable length event code and the first amplitude coding method are constructed based on actual or assumed statistics for the first event in the series, ignoring the DC term.

A breakpoint is selected to define a second and a third region. The coding of the coefficients of the second region includes identifying events that include a first run of one or more consecutive non-zero-valued coefficients followed by a single zero-valued coefficient, followed by a second run of consecutive none or more zero-valued coefficients. Each such event is identified by the number of non-zero-valued coefficients in the first run and the number of zero-valued coefficients in the second run. Each identified event only includes up to the maximal length of coefficients. Each identified event is encoded by a second variable length code, e.g., using a second variable length coding table. Furthermore, the amplitudes of the non-zero-valued coefficients are coded using a second amplitude coding method, e.g., a second variable length amplitude code. The signs of the non-zero-valued coefficients are encoded by corresponding sign bits. The third region is encoded by the method described for the high frequency region in the Extended Hybrid Method that assumes non-zero-valued coefficients are dominated by amplitide-1 coefficients, such that no amplitude coding is used to encode an amplitude-1 coefficient, and an exception code followed by a codeword is used to encode any non-amplitude-1 coefficient.

Other alternate methods that include more than two regions are also included in the scope of the invention. One coding method includes using two breakpoints to define a first, second, and third region. In the first region, runs of non-zero-valued coefficients and runs of zero-valued coefficients are identified, and the runlengths of the non-zero-amplitude and zero-amplitude coefficients are encoded using a first runlength coding method and a second runlength coding method. In the second region, runs of coefficients of amplitude-one, and runs of zero-valued coefficients are identified, and the runlengths of the amplitude-one and zero-amplitude coefficients are encoded using a third runlength coding method and a fourth runlength coding method, respectively. In the third region, runs of zero-valued coefficients are identified, and the runlengths of such zero-valued-runs are encoded using a fifth runlength coding method.

Alternate coding methods may be used for the third, e.g., high-frequency region, as described above for the two-region methods. For example, the third region may use conventional 2D-VLC, or in another embodiment, the third region can use the high frequency coding method of the Basic Hybrid Method, or in yet another embodiment in which it may be assumed that any non-zero-valued coefficients in the third region are dominated by amplitide-1 coefficients, the third region can use the high frequency coding method of the Extended Hybrid Method.

As an example, consider the series of quantized coefficients:

$$5\ 00003420\ 00000030\ 000000 \mid 000000000000\ 0010\ 000000000000\ 10$$
$$000000000000.$$

Suppose the encoding is such that the first event defines the first region, and a breakpoint along the ordering defines the second and third regions. Suppose further that the first coefficient is the DC value, and let DC(a) be the codeword for a DC amplitude of quantized value a. Suppose further that the above-described variable length coding of zero-valued runs followed by non-zero-valued runs is used, with a maximal length defined for any event. Denote by C0(z,n), C1(z,n), and C2(z,n), z=0,1,..., n=1, 2,... the variable length codewords for the first region event, events in the second region, and events in the third region respectively, each event being of z zero-valued coefficients followed by n non-zero-valued coefficients followed by a single zero-valued coefficient, unless z+n=the maximal length. For this example, suppose the breakpoint to define the second and third region is at 22 and defines a soft boundary. Let A0(a), A1(a) and A2(a) denote the codewords of an amplitude in the first, the second, and the third regions, respectively, as determined by a first, second, and third amplitude coding method. In one embodiment, these amplitude coding methods are variable length coding methods that differ. For example, in the first region, a large amplitude is more likely-to-occur than in the second region. Such a relatively high amplitude is even less likely-to-occur in the third region.

Ignoring the signs of the amplitudes, the above series would be encoded as:

$$DC(5)+C0(4,3)+A0(3)+A0(4)+A0(2)+C1(6,1)+A1(3)+C1(12,0)+ C2(8,1)+$$
$$A2(1)+C2\ (12,0)+C2(0,1)+A2(1)+EOB$$

where EOB is a codeword indicating the end of table, and + denotes concatenation. Note that the run of six zero-valued coefficients before the breakpoint moves to the next region because the soft boundary moves to before the six zero-valued coefficients.

Note that in this implementation, C0(12,0), C1(12,0) and C2(12,0) are the codewords for events of 12 zero-valued coefficients, or, if within 12 coefficients of a breakpoint, the codewords to indicate skip-to-breakpoint in the case of a hard boundary, or the soft boundary moves to the start of the zero-valued coefficients of the event in the case of a soft boundary.

In an actual implementation, each amplitude would also have a sign, and the encoding would also include a sign bit. Let $S_+$ and $S_-$ denote the code bits for a positive and negative amplitude, respectively. Suppose the series of quantized coefficients to encode is:

$$5\ 0000{+}3{-}4{-}2{+}10\ 000000{+}30\ 000000 \mid 000000\ 000000\ 00{-}10$$
$$000000000000\ {+}10\ 000000000000.$$

The, with sign bits, according to the same embodiment, the series would be encoded as:

$$DC(5)+C0(4,4)+A0(3)+S_{+}+A0(4)+S_{-}+A0(2)+S_{-}+A0(1)+S_{+}+C1(6,1)+A1(3)+S_{+}$$
$$+C1(12,0)++C2(8,1)+A2(1)+S_{-}+C2(12,0)+C2(0,1)+A2(1)+S_{+}+EOB.$$

In another version the encoding of the non-zero-values includes the sign.

*The Basic Multi-Dimensional Amplitude VLC Method*

In each of the 2-D Non-Zero/Zero Cluster VLC Method, the Basic Hybrid VLC Method, and the Extended Hybrid VLC Method, various variable length coding methods are introduced to encode the relative positions of the clustered or non-clustered transform coefficients. After each such encoding, a coding of the magnitude of each non-zero valued coefficient is included, as is a sign bit (+ or -).

The inventors have noticed that encoding the amplitudes takes up a significant part of the code in VLC coding of clusters of non-zero-valued coefficients.

Thus even with the 2-D Non-Zero/Zero Cluster VLC Method, the Basic Hybrid VLC Method, and the Extended Hybrid VLC Method, there remains a need to improve the coding efficiency of the coefficient amplitudes of clusters of non-zero-valued coefficients.

An aspect of the Basic Multi-Dimensional Amplitude VLC Method invention introduced a multi-dimensional VLC to code multiple consecutive non-zero-valued coefficients that occur in runs of non-zero-valued coefficients ("clusters") in coding an ordered series of quantized coefficients of a transform of image data, as occurs in many image compression methods. Instead of using "m" one-dimensional VLC tables to code the amplitudes of "m" consecutive non-zero-valued coefficients, the invention uses a single "m" dimensional table to code the amplitudes of the entire "m" coefficients.

FIG. 24 shows a flow chart of one embodiment of a hybrid variable length coding (VLC) method 2400 that includes in 2401 providing a breakpoint along the ordering of the series to define a first, e.g., low frequency region wherein non-zero-coefficients are likely to be clustered, and a second, e.g., high frequency region where non-zero coefficients are likely to be scattered, and in the version shown, likely to be dominated by amplitude-1 coefficients. In 2403, each run of zero-valued coefficients that precedes a run of one or more non-zero-valued coefficients is identified. In the case that the first region coding is according to an embodiment of the 2-D Non-Zero/Zero Cluster VLC Method, the events include a zero-valued coefficient following the run of non-zero-valued coefficients, and furthermore, events that have no non-zero-valued coefficients preceding the non-zero coefficient(s) are included. In 2405, the identified events are encoded using joint encoding for each event of the runlength of the preceding zero-valued coefficient and the runlength of the one or more non-zero-valued coefficients. In one embodiment, 2405 includes using a two-dimensional lookup table of codes. In 2407, the individual amplitudes in each run of non-zero-amplitudes in the identified event is encoded using an amplitude code, which, in one embodiment is a variable length code obtained using a code table.

Note that in one variation, 2403 and 2405 are replaced by a first region coding method described in the Basic Hybrid VLC Method and the Extended Hybrid VLC Method.

In the version shown, the second, e.g., high frequency region is encoded as described in the Extended Hybrid Coding method. In 2409, events are defined that are each a run of none or more zero-valued coefficients followed by a single non-zero-valued coefficient. Any such non-zero coefficient is assumed to have amplitude 24 such that no amplitude encoding is required for such a coefficient. A non-amplitude-1, non-zero coefficient is marked as an exception. Furthermore, the remainder of the block being zero is also identified. In 2411, for each identified event in the second region, the runlength of the zero-valued coefficients preceding the single non-zero-valued coefficient is encoded using a variable length runlength coding method, implemented, e.g., as a coding table. The sign of the ending non-zero-value coefficient is encoded by a sign bit, and, in the case that the non-zero-valued coefficient is the exceptional case of not having amplitude 24, an exception code followed by an amplitude code is included. The amplitude code is obtained, e.g., using an amplitude coding table, which in general is different than the amplitude coding table used for encoding the non-zero-amplitudes in the first region, since the second region amplitudes are more likely to have lower value than the first region amplitudes.

In one variation, how to set up the codeword tables is described in the 2-D Non-Zero/Zero Cluster VLC Method, and includes either assuming or obtaining statistics for typical series of coefficient image blocks, or, in an adaptive system, by measurement of the relative frequencies of occurrence of events and amplitudes, depending on the coding method, e.g., code table. In another variation, how to set up the codes is described in the Basic Hybrid VLC Method and the Extended Hybrid VLC Method

FIG. 25 shows a flow chart of another embodiment of a hybrid VLC method 2500 that includes an aspect of the Basic Multi-Dimensional Amplitude VLC Method, in particular, that includes instead of block 2407, block 2507, a method that for each recognized event in the first region, jointly encodes a plurality of the non-zero-amplitudes in runs of non-zero-valued coefficients by a codeword, e.g., using a joint coding table. The signs also are encoded.

Note that 2503 and 2505 correspond to 2403 and 2405, respectively, of FIG. 24, but use different reference numbers to indicate that these steps need not be identical. For example, FIG. 24 may include recognizing events as described in the variation as described in the Basic Hybrid VLC Method and the Extended Hybrid VLC Method, while 2503 and 2505 may be as described in the 2-D Non-Zero/Zero Cluster VLC Method.

As an example, assuming a pair of "z" consecutive zero-valued coefficients and "n" consecutive non-zero-valued coefficients, followed by a single non-zero-value, is coded using the coding invention described in the 2-D Non-Zero/Zero Cluster VLC Method. Denote the positions of the zero-valued/non-zero valued coefficients by R(z,n) and denote each of the amplitudes by m(1), m(2), ..., m(n). Denote by C(z,n) the variable length codeword for the event R(z,n), z=0,1,..., n=1, 2, ...; denote by A(a) the amplitude encoding of an amplitude a, a=1, 2, ..., in the run of non-zero-valued coefficients in R(z,n); and denote by S(1), S(2), ..., the sign bits for the first, second, ..., n'th non-zero-valued coefficient in R(z,n). Then, according to one embodiment described in the 2-D Non-Zero/Zero Cluster VLC Method, the encoding of the event and the corresponding non-zero amplitudes is:

$$C(z,n)+A(m(1))+S(1)+A(m(2))+S(2)+\ldots+A(m(n))+S(n),$$

where +denoted concatenation.

Similarly, consider the Basic Hybrid VLC Method and the Extended Hybrid VLC Method. Denote by r(n) the run of n consecutive non-zero coefficients, and r'(z) the run of z consecutive zero-valued coefficients in the first region, n,z=1,2,.... Consider a single event denoted by r(n), denote each of the non-zero amplitudes in r(n) by m(1), m(2), ..., m(n). Denote by C(n) the variable length codeword for the run length of non-zero-valued coefficients in the event r(n), n=1, 2, ... and C'(z) the variable length codeword for the run length of zero-valued coefficients in the event r'(z), z=1, 2, ...; denote by A(a) the amplitude encoding of an amplitude a, a=1, 2, ..., in the run r(n) of non-zero-valued coefficients; and denote by S(1), S(s), ..., the sign bits for the first, second, ..., n'th non-zero-valued coefficient in r(n). Then according to embodiments described in the Basic Hybrid VLC Method and the Extended Hybrid VLC Method, the encoding of the event and the corresponding non-zero amplitudes is:

$$C(n)+A(m(1))+ S(1)+ A(m(2))+ S(2)+ \ldots+ A(m(n))+ S(n) + C'(z).$$

One aspect of the Basic Multi-Dimensional Amplitude VLC Method is to use a single codeword obtained by a multidimensional amplitude encoding method to encode the sequence of amplitudes

$$A(m(1)), A(m(2)), \ldots,A(m(n)).$$

Denote by $A_n$(m(1), m(2), ..., m(n)) the codeword for the sequence of n quantized amplitudes m(1), m(2), ..., m(n), n=1, 2, .... According to one embodiment of the Basic Multi-Dimensional Amplitude VLC Method, the event R(z,n) and associated amplitudes and signs is then, when using the 2-D Non-Zero/Zero Cluster VLC Method:

$$C(z,n)+ A_n(m(1), m(2), \ldots, m(n))+S(1)+S(2)+\ldots+S(n),$$

and in one embodiment when using the Basic Hybrid VLC Method or the Extended Hybrid VLC Method:

$$C(n)+ A_n(m(1), m(2), \ldots, m(n))+S(1)+S(2)+\ldots+S(n),$$

In one embodiment, the codeword for the sequence of n amplitudes is obtained using an n-dimensional code table, which in one embodiment, is an n-dimensional variable length code table.

In an alternate embodiment, the signs are incorporated into the multidimensional amplitude encoding method, which should then properly be called a multidimensional quantized coefficient encoding method. Thus, the sign bit can be either integrated with the magnitude to represent the true amplitude or encoded as a separate bit as illustrated in this example.

In order to make the size of the multi-dimensional tables manageable from a practical implementation point of view, the maximum length of the run of non-zero amplitudes jointly encoded is restricted to relatively low numbers such as 2 or 3. Suppose at most three coefficients are jointly encoded, and suppose multidimensional tables are used. One embodiment uses a one-dimensional amplitude coding table for events with a runlength of one non-zero-coefficient, a two-dimensional amplitude coding table for events with a runlength of two non-zero-coefficients, and a three-dimensional amplitude coding table for events with a runlength of three non-zero-coefficients.

The more likely-to-occur amplitude combinations use variable length codes. These codes are obtained by assuming or measuring statistics of combinations, and assigning variable length codewords according to the assumed or measured statistics, using code allocation methods known in the art, e.g., Huffman codes, non-Huffman Arithmetic codes, and so forth. Furthermore, in one embodiment, some of the less likely-to-occur amplitude combinations are assigned a fixed length code preceded by an escape code.

When at most three consecutive non-zero amplitudes are jointly encoded, in one embodiment, for longer runs, the remaining 4th, 5th, etc. non-zero coefficients' amplitudes are each encoded using one-dimensional tables as described in the 2-D Non-Zero/Zero Cluster VLC Method.

In an alternate implementation, further multidimensional tables are used for these later coefficients. In one version, the later multidimensional tables are the same as the first used table, and in another implementation, different tables are used for the later groups of coefficients to account for the likelihood that the amplitudes are usually smaller the later the coefficient is in the ordering of the series.

FIGS 26A, 26B, and 26C respectively show a one-dimensional amplitude code table 2601, a two-dimensional amplitude code table 2603, and a three-dimensional amplitude code table 2605. The three-dimensional amplitude code table 2605, in one embodiment, stores as a set of two-dimensional amplitude code tables 2607-1, 2607-2, 2607-3, ..., 2607-m, where m denotes the largest value of the each of the first, second, and third coefficients. Each 2D table stores a table for different third coefficient amplitudes providing the codes for different amplitudes of the first and second coefficients. When the three-dimensional code table is stored as a set of two-dimensional code tables, which coefficients' amplitudes are in each two-dimensional table may be different. FIG. 26D shows an alternate table 2609 using a different set: each 2D table stores a table for different first coefficient amplitudes providing the codes for different amplitudes of the second and third coefficients. Each coefficient value is restricted to m in this table.

Regarding the joint encoding of identified events according to the 2-D Non-Zero/Zero Cluster VLC Method, in one version, each identified event only includes up to a pre-determined number of coefficients, called the maximal length herein, such that some events of the maximal length include a first run of one or more consecutive non-zero-valued coefficients not followed by a single zero-valued coefficient, followed by a second run of consecutive none or more zero-valued coefficients. This provides for encoding an event with more than the pre-determined number of coefficients as a plurality of events of at most the maximal length without using escape codes. Two or more events that together define a run of less than the maximal length zero-valued coefficients followed by a run of any length of non-zero-valued coefficients is called a "generalized event" herein in that it is treated as a single event for some purposes, including, for example, establishing the first and second region using what is called a soft boundary.

**Example of the Basic Multi-Dimensional Amplitude VLC Method**

As an example, consider the following series.

5 0000+3–4–20 000000+30 000000 I 000000 000000 00–10
000000000000 +10 000000000000.

Suppose that a breakpoint exists at the point indicated by "I" and consider encoding the coefficients in the first region with an embodiment of the 2-D Non-Zero/Zero Cluster VLC Method, with a code provided for all zeroes. The first region is:

5 0000+3–4–20 000000+30 000000.

Denote by DC(m) the codeword for the DC amplitude, and denote by C(z,n) the variable length codeword for the event R(z,n), z=0,1,..., n=1, 2, ..., of z zero-valued-coefficients followed by n non-zero-valued coefficients followed by a single zero-valued coefficient. Further denote by C(skip) the codeword for "skip to boundary". Consider an embodiment in which the signs are separately encoded by a set of sign bits. Let $S_+$ and $S_-$ denote the code bits for a positive and negative amplitude, respectively. Further denote by $A_n(m(1), m(2), ..., m(n))$ the codeword for the sequence of n quantized amplitudes m(1), m(2), ..., m(n), n=1, 2, ....

Then according to an embodiment of the invention that includes the Basic Multi-Dimensional Amplitude VLC Method, the codewords for the first region are:

$$DC(5)+C(4,3)+A_3(3,4,2)+S_++S_-+S_-+C(6,1)+A_1(3)+S_++C(skip),$$

where + denotes concatenation.

How to establish the breakpoint is described above in the context of the Basic Hybrid VLC Method and the Extended Hybrid VLC Method.

Another aspect of the invention is an apparatus for coding a series of digital signals, e.g., an ordered series of quantized coefficients of a transformed block of image data, including using the Basic Multi-Dimensional Amplitude VLC Method. See FIG. 9 explained in more detail below under the Section titled "Coding and decoding apparatus including a processor."

Thus there still is a need in the art for a relatively efficient method of encoding clusters of amplitudes applicable to variable length coding.

*The Multi-Table Amplitude VLC Method*

While the Basic Multi-Dimensional Amplitude VLC Method invention appears to improve the overall coding efficiency, it was observed that the size of the n-dimensional table used for the joint encoding can become rather large for a large "n." As a result, in practice, the size of n has to be limited to a low number of consecutive non-zero-amplitude values, such as 1, 2 and 3 for practical implementation.

Thus, even with the Basic Multi-Dimensional Amplitude VLC Method, there remains a need in the art for a relatively efficient method of encoding clusters of amplitudes applicable to variable length coding, in particular, to hybrid variable length coding.

An aspect of the Multi-Table Amplitude VLC Method invention introduces a set of VLC methods to code multiple consecutive non-zero-valued coefficients that occur in runs of non-zero-valued coefficients ("clusters") in coding an ordered series of quantized coefficients of a transform of image data, as occurs in many image compression methods.

FIG. 27 shows a flow chart of another embodiment of a hybrid VLC method 2700 that includes an aspect of the present invention, and includes, instead of block 2407 of above-described FIG. 24 that shows a flow chart of one embodiment of a hybrid variable length coding (VLC) method 2400, block 2707 that for each recognized run of non-zero amplitudes in the first region, determines events that are within each run, such events including a run of amplitude-1 coefficients, and encodes each event a codeword, e.g., using a 2-D coding table for the particular run length of non-zero amplitudes. The signs also are encoded.

Note that 2703 and 2705 correspond to 2403 and 2405, respectively, of above-described FIG. 24, but 2703 and 2705 use different reference numbers to indicate that these steps need not be identical. For example, FIG. 24 may include recognizing events as described in the Basic Hybrid VLC Method and the Extended Hybrid VLC Method, while 2703 and 2705 may be as described in the 2-D Non-Zero/Zero Cluster VLC Method.

As in the Basic Multi-Dimensional Amplitude VLC Method, the inventors have noted that transform coefficients along a specified path, e.g., a zig-zag scan path, for a two dimensional block transform appear to be statistically distributed similarly to an exponential distribution, with the largest amplitude coefficients residing in the lowest frequency spectrum and the smallest amplitude coefficients residing in the highest frequency spectrum. When the coefficients are quantized, larger amplitude coefficients tend to be more clustered in lower frequencies and smaller coefficients tend to be more scattered in higher frequencies. Dividing the path into a low frequency region and a high frequency region, the inventors have noticed that most of the quantized coefficients along the high frequency region are dominated by amplitudes of zero and one, and most of the quantized coefficients along the low frequency region are dominated by smaller amplitude values such as 0, 1, 2, 3, ..., and so forth, with the appearance of amplitude 1 more likely than of amplitude 2, the appearance of amplitude 2 more likely than of amplitude 3, and so forth. It should be noted that the appearance of amplitude 0 can be more likely than of amplitude 1 for relatively low bit rate interframe coding, and the appearance of amplitude 0 can be less likely than of amplitude 1 for intraframe coding and high bit rate interframe coding.

Referring to FIG. 27, as an example, suppose a pair of "z" consecutive zero-valued coefficients and "n" consecutive non-zero-valued coefficients, followed by a single non-zero-value, is coded using the coding invention described in the 2-D Non-Zero/Zero Cluster VLC Method. Denote the positions of the zero-valued/non-zero valued coefficients by R(z,n) and denote each of the amplitudes by m(1), m(2), ..., m(n). Denote by C(z,n) the variable length codeword for the event R(z,n), z=0,1,..., n=1, 2, ...; denote by A(a) the amplitude encoding of an amplitude a, a=1, 2, ..., in the run of non-zero-valued coefficients in R(z,n); and denote by S(1), S(2), ..., the sign bits for the first, second, ..., n'th non-zero-valued coefficient in R(z,n). Then, according to one embodiment described in the 2-D Non-Zero/Zero Cluster VLC Method, the encoding of the event and the corresponding non-zero amplitudes is:

$$C(z,n)+A(m(1))+S(1)+A(m(2))+S(2)+\ldots+A(m(n))+S(n),$$

where +denoted concatenation.

Similarly, according to embodiments described in the Basic Hybrid VLC Method and the Extended Hybrid VLC Method, the encoding of the event and the corresponding non-zero amplitudes is:

$$C(n)+A(m(1))+ S(1)+ A(m(2))+ S(2)+ \ldots+ A(m(n))+ S(n) + C'(z).$$

One aspect of the Basic Multi-Dimensional Amplitude VLC Method is to use a single codeword obtained by a multidimensional amplitude encoding method to encode the sequence of amplitudes A(m(1)), A(m(2)), ...,A(m(n)) by $A_n$(m(1), m(2), ..., m(n)) the codeword for the sequence of n quantized amplitudes m(1), m(2), ..., m(n), n=1, 2, .... According to one embodiment of the Basic Multi-Dimensional Amplitude VLC Method, the event R(z,n) and associated amplitudes and signs is encoded, when using the 2-D Non-Zero/Zero Cluster VLC Method together with an embodiment of the Basic Multi-Dimensional Amplitude VLC Method as:

$$C(z,n)+ A_n(m(1), m(2), \ldots, m(n))+S(1)+S(2)+\ldots+S(n),$$

and in one embodiment when using the Basic Hybrid VLC Method or the Extended Hybrid VLC Method with the Basic Multi-Dimensional Amplitude VLC Method, as:

$$C(n)+ A_n(m(1), m(2), \ldots, m(n))+S(1)+S(2)+\ldots+S(n)+C'(z).$$

One embodiment of the Multi-Table Amplitude VLC Method uses an alternate to a multidimensional table to encode the cluster of n non-zero-amplitude coefficients in the first region.

The inventors notice that when runs of consecutive non-zero-amplitude coefficients, i.e., clusters of non-zero amplitudes are identified, the histogram of the coefficient amplitudes tends to be dominated by values of 1 and then 2, ..., and so forth. It is with these observations in mind that an efficient coding technique is described herein to take advantage of the dominance of ones.

One aspect of the Multi-Table Amplitude VLC Method includes in the first region, identifying clusters, i.e., runs of consecutive non-zero-amplitude coefficients, and in each such cluster, further identifying one or more events that each includes a run of consecutive amplitude 1 coefficients that ends with a coefficient of amplitude greater than 1.

Each such event of a run of amplitude 1 coefficients ending in a value greater than 1 has a probability-a likelihood-of occurrence. The likelihood of occurrence may be estimated by tabulating the relative frequency of occurrence to obtain a histogram, or may be assumed, either from histograms of typical images or otherwise.

FIG. 28 shows a table of relative likelihoods of occurrences for runs of 1's within a run of n non-zero amplitude coefficients. In FIG. 28, $P_n$(j,k) denotes the relative likelihood of a run of a number, denoted j, of amplitude-1 coefficients ending in a coefficients of amplitude greater than 1, such an amplitude denoted by k, k>1, with j=0,1,...n-1.

Since the runs of the non-zero values can be all amplitude 1, such events, called exceptions, have been denoted as "Exc" and the relative likelihood of such events denoted by $P_n$(Exc).

The table of FIG. 28 is for identified runs of amplitude 1 in a cluster of n consecutive non-zero-amplitude coefficients in the first region. There is such a table of likelihoods for each length of a run of consecutive non-zero amplitude coefficients. Therefore, there are n such tables.

One embodiment of the Multi-Table Amplitude VLC Method invention includes providing a codeword for each such identified event within each cluster. For example, in one embodiment, an optimal variable length code is assigned for each of the identified events according to the relative likelihoods $P_n$(j,k) and $P_n$(Exc), with the most likely-to-occur event assigned the code with the least number of bits and the least likely-to-occur event assigned the longest codeword. FIG. 29 shows a code table for events identified in a consecutive run of n non-zero amplitude coefficients. In FIG. 29, $C_n$(j,k) denotes the codeword for an identified run of j amplitude-1 coefficients ending in a coefficients of amplitude k greater than 1, and $C_n$(Exc) denotes the codeword for events in the cluster of n non-zero coefficients that end in amplitude 1.

Thus the more likely-to-occur events use variable length codes. These codes are obtained by assuming or measuring statistics of combinations, and assigning variable length codewords according to the assumed or measured statistics, using code allocation methods known in the art, e.g., Huffman codes, non-Huffman Arithmetic codes, and so forth. Furthermore, in one embodiment, some of the less likely-to-occur amplitude combinations are assigned a fixed length code preceded by an escape code.

FIG. 30 shows a sequence of code tables for events identified in different lengths of clusters of consecutive non-zero-valued coefficients, according to an aspect of the invention. Thus, FIG. 30 shows a table for a cluster of one non-zero-valued coefficients, a cluster of two non-zero-valued coefficients, ..., up to a cluster of a number n of non-zero-valued coefficients. Each table includes ending amplitudes up to a number denoted m. In one version, in each such table, fixed length codes may be used for those least likely-to-occur events.

As an example, suppose the following cluster-run of consecutive non-zero amplitudes-of length 10 is identified:

$$1\ -1\ \ 1\ \ 1\ \ 2\ \ 1\ -3\ -1\ \ 1\ -1.$$

Within this cluster are the three events:

$$1\ -1\ \ 1\ \ 1\ \ 2$$

$$1\ -3$$

$$-1\ \ 1\ -1.$$

According to one embodiment of the Multi-Table Amplitude VLC Method invention, the identified cluster is encoded as:

$$(C_{10}(4,2)+S_{+}+S_{-}+S_{+}+S_{+}+S_{+})+(C_{10}(1,3)+S_{+}+S_{-})+(C_{10}(Exc)+S_{-}+S_{+}+S_{-})$$

where + denoted concatenation, and $S_+$ and $S_-$ represent the codes for positive and negative signs, respectively.

Thus, compared to the Basic Multi-Dimensional Amplitude VLC Method, a single codeword obtained via a potentially large multidimensional coding table for coding a sequence of non-zero amplitudes is replaced by a number of codewords, each obtained by a simple 2-D coding table.

Consider as an example the following ordered sequence of quantized transform coefficients in the low frequency region, excluding the dc coefficient, for a soft break point at N = 18:

$$3\ -1\ \ 1\ \ 1\ -2\ \ 1\ \ 1\ \ 0\ \ 0\ -1\ \ 2\ \ 1\ \ 1\ -1\ \ 0\ \ 0\ \ 0\ \ 1\,|\,0.$$

The breakpoint is indicated by I. Consider encoding the coefficients in the first region using the 2-D Non-Zero/Zero Cluster VLC Method.

Assuming no DC coefficient, the first identified cluster followed by a single zero-valued coefficient is at position R(0,7) and is

$$3\ -1\ \ 1\ \ 1\ -2\ \ 1\ \ 1\ \ 0$$

Furthermore, this cluster includes the events
3
-1 1 1 -2, and
1 1

Thus, this first cluster is encoded by

$$C(0,7)+C_7(0,3)+S_{+}+C_7(3,2)+S_{-}+S_{+}+S_{+}+S_{-}+C_7(Exc)+S_{+}+S_{-}.$$

where C(0,7) is the codeword for positioning of the zero-valued runs and the non-zero clusters according to the 2-D Non-Zero/Zero Cluster VLC Method.

The next non-zero cluster followed by a single zero-valued coefficient is

$$-1\ 2\ 1\ 1\ -1\ 0$$

and is at position R(1,5). This non-zero cluster of length includes the events
-1 2 and
1 1-1.

Thus this second cluster is encoded by

$$C(1,5)+C_5(1,2) + S_- + S_+ + C_5(Exc) + S_+ + S_+ + S_-.$$

The next (and last) non-zero cluster in the first region is at position code R(2,1) and is 1 0 . This cluster is encoded by:

$$C(2,1)+C_1(Exc) + S_+.$$

Therefore, the whole first region is encoded by

$$C(0,7)+C_7(0,3)+ S_+ +C_7(3,2)+S_- + S_+ + S_+ + S_- + C_7(Exc) + S_+ + S_- +$$

$$C(1,5)+C_5(1,2) + S_- + S_+ +C_5(Exc)+ S_+ + S_+ + S_- +C(2,1)+C_1(Exc) + S_+.$$

Regarding the joint encoding of identified events according to the 2-D Non-Zero/Zero Cluster VLC Method, in one version, each identified event only includes up to a pre-determined number of coefficients, called the maximal length herein, such that some events of the maximal length include a first run of one or more consecutive non-zero-valued coefficients not followed by a single zero-valued coefficient, followed by either no consecutive zero-valued coefficients or by a second run of one or more consecutive zero-valued coefficients. This provides for encoding an event with more than the pre-determined number of coefficients as a plurality of events of at most the maximal length without using escape codes. Two or more events that together define a run of less than the maximal length zero-valued coefficients followed by a run of any length of non-zero-valued coefficients is called a "generalized event" herein in that it is treated as a single event for some purposes, including, for example, establishing the first and second region using what is called a soft boundary.

Note that the inventors have noted that for short clusters, e.g., n=2 or 3, the Basic Multi-Dimensional Amplitude VLC Method works well, while for longer clusters, e.g., n>3, the Multi-Table VLC Method described above is preferred. Thus, one embodiment of the invention uses both the Basic Multi-Dimensional Amplitude VLC Method and the Multi-Table Amplitude VLC Method depending on the length of the cluster of non-zero-valued coefficients.

For example, in the case that the Basic Multi-Dimensional Amplitude VLC Method is used for cluster lengths n≤3, and the Multi-Table Amplitude VLC Method is used for cluster lengths n>3, and the 2-D Non-Zero/Zero Cluster VLC Method is used for encoding the relative position of a cluster of non-zero-valued coefficients of length n, then the code for the cluster and position may be expressed as

$$\texttt{If}\ n\leq 3\ \texttt{then}\ C(z,n)+ A_n(m(1), m(2), \ldots, m(n))+S(1)+S(2)+\ldots+S(n),$$

$$\texttt{else if}\ n>3\ \texttt{then}\ C(z,n)+\sum_i\{C_n(j_i,k_i)+S_i(1) +\ldots+S_i(j_i+1)\}.$$

Another way of expressing this coding function is as:

$$\alpha\, V_{R(z,n),\, A_n}\, \{R(z,n),m(1),\ldots,m(n)\}+$$

$$(1-\alpha)\, V_{R(z,n),C_n}\{R(z,n), (j_1,k_1),(j_2,k_2), \ldots\},$$

where $\alpha$ = 1 for short clusters of non-zero-valued coefficients, for example, values of n=1, 2, or 3, and $\alpha$ = 0 for n>3.

Coding using the code of the 2-D Non-Zero/Zero Cluster VLC Method and the code of the Multi-Dimensional Amplitude VLC Method for short clusters, or the code of the Multi-Table Amplitude VLC Method for longer clusters to code the non-zero-valued coefficients in the first (low-frequency) region includes identifying runs of zero-valued coefficients preceding runs (cluster) of non-zero coefficients followed by a single zero-valued coefficient. The method further includes encoding the non-zero amplitudes with a multi-dimensional code for clusters of up to three non-zero coefficients, and, for any cluster of n>3 consecutive non-zero coefficients, identifying events of a run of consecutive amplitude 1 coefficients followed by a single coefficient of amplitude greater than 1.

Consider, as an example, coding the following sequence of quantized transform coefficients in the low frequency region, excluding the DC coefficient, and assuming a breakpoint N = 19:

$$3\ -1\ 1\ 1\ -2\ 1\ 1\ 0\ 0\ -1\ 2\ 1\ 0\ 1\ -1\ 0\ 0\ 0\ 1 \mid 0,$$

where I represents the breakpoint.

Using I to separate such runs of zero preceding clusters of non-zeroes followed by a single zero, the low frequency region consists of, assuming a soft boundary, the region is:

$$\mid 3\ -1\ 1\ 1\ -2\ 1\ 1\ 0 \mid 0\ -1\ 2\ 1\ 0 \mid 1\ -1\ 0 \mid 0\ 0\ 1\ 0.$$

The code using the combined method is:

$$C(0,7)+C_7(0,3)+S_+ +C_7(3,2)+S_- +S_+ +S_+ +S_- +C_7(Exc)+S_+ +S_+ +$$
$$C(1,3),\ A_3(1,2,1)+S_- +S_+ +S_+$$
$$+C(0,2)+\ A_2(1,1)+S_+ +S_- +C(2,1)+A_1(1)+S_+.$$

Note that for the first cluster of 7 non-zero coefficients, the Multi- Table Amplitude VLC Method is used to encode the non-zero valued coefficients, while for the other clusters of non-zero-valued coefficients, because the run-length of the cluster is three or less, the Basic Multi-Dimensional Amplitude VLC Method is used to encode the amplitudes in the cluster.

How to establish the breakpoint when using the Multi- Table Amplitude VLC Method alone or with the Basic Multi-Dimensional Amplitude VLC Method is described above with reference to the Basic Hybrid VLC Method and the Extended Hybrid VLC Method.

Thus, according to one method embodiment of the Multi- Table Amplitude VLC Method, one 2-D position code table is used to represent the runs of clustered zeros and clustered non-zero-valued coefficients that end in a single zero-valued coefficient, as described in the 2-D Non-Zero/Zero Cluster VLC Method, and a number of relatively short 2-D amplitude code tables, such a number denoted by "n," with the length of the tables ranging from 1 to n, are used to encode events that are each runs of amplitude-1 coefficients terminating in an amplitude greater than 1 within the cluster of n non-zero-valued coefficients.

The inventors have found that using such a method provides performance as good as or superior to the methods proposed in the Basic Hybrid VLC Method and the 2-D Non-Zero/Zero Cluster VLC Method. It is also comparable to the Basic Multi-Dimensional Amplitude VLC Method with the advantage of ease of implementation.

*The Joint Position and Amplitude VLC Method*

The inventions described in the Basic Hybrid VLC Method and the 2-D Non-Zero/Zero Cluster VLC Method introduced various variable length coding techniques to take care of only the positions of the clustered or scattered transform coefficients. The inventions described in the Basic Multi-Dimensional Amplitude VLC Method and in the Multi-Table Amplitude VLC Method introduce methods of encoding the amplitudes of the clusters. With these methods, what is still needed is a variant that combines encoding the positions of transform coefficients and the amplitude of transform coefficients.

An aspect of the Joint Position and Amplitude VLC Method invention combines the coding method used to code the position of consecutive non-zero-valued coefficients that occur in runs of non-zero-valued coefficients ("clusters") with the coding method used to code the amplitudes of the non-zero-valued coefficients in the clusters to produce a combined code for coding an ordered series of quantized coefficients of a transform of image data in a first region-the low frequency region-of the series. Such a series occurs in many image compression methods.

As in the descriptions of other coding methods herein, the description is written in terms of an ordered series of digital values that are quantized transform coefficients of a block of image data, with zero-valued quantized coefficients being the most likely-to-occur, and quantized coefficients of value $\pm 1$ being the next most likely-to-occur values, the invention is, in general, applicable to an ordered series of digital signals that each have an amplitude from a finite set of amplitudes consisting of the most likely-to-occur amplitude and at least one other amplitude.

FIG. 31 shows a flow chart of one embodiment 3100 of a hybrid variable length coding (VLC) method, which includes jointly encoding the relative positions and lengths of clusters of non-zero-valued coefficients and runs of zero-valued coefficients, and the amplitudes in the runs of non-zero-valued coefficients.

In 2401, a breakpoint is provided, as in FIG. 24, to define a first (low-frequency) region and a second (high-frequency) region along the ordering of a series of quantized transform coefficients.

In 3103, position events in the first region are identified. The position events are to provide the relative positions and runlengths of clusters of non-zero-valued coefficients and of intervening runs of zero-valued coefficients. In one version, identifying these position events includes recognizing events as described in the Basic Hybrid VLC Method and the Extended Hybrid VLC Method. When the idea of the 2-D Non-Zero/Zero Cluster VLC Method is used, the events are defined by the runlength of any run of consecutive zero-valued coefficients that precedes a cluster of non-zero values coefficients followed by a single zero-valued coefficient, and the runlength of the cluster of non-zero-valued coefficient.

In 3105 amplitude events in the first region are identified. When the joint coding includes the ideas behind the Basic Multi-Dimensional Amplitude VLC Method, the amplitude events are the amplitudes in the cluster of non-zero-valued coefficients. One embodiment further includes the signs of the non-zero-coefficients in the cluster. When the joint coding includes the ideas behind the Multi-Table Amplitude VLC Method, the events are, within each cluster, the run-lengths of any run of consecutive amplitude-1 coefficients that precedes any coefficient of amplitude greater than one, and the value of the ending amplitude. In one embodiment, the amplitude events include the signs of the non-zero coefficients in the cluster of non-zero-valued coefficients.

In 3107, the identified position events and amplitude events for each cluster of non-zero-valued coefficients and intervening zero-valued coefficients in the first region are jointly encoded. Assuming the position events use the ideas described in the 2-D Non-Zero/Zero Cluster VLC Method, denote by R(z,n) each recognized position event representing a cluster of n consecutive non-zero-valued coefficients preceded by a run of z zero-valued coefficients followed by a single zero-valued coefficient, z=0, 1, ..., n=1, 2, .... Further, assuming joint amplitude coding as in Basic Multi-Dimensional Amplitude VLC Method, denote by m(1),...,m(n) the n non-zero amplitudes in the cluster. Then, in accordance with one embodiment, instead of encoding position and amplitude independently and concatenating the results together as $C(z,n) + A_n(m(1),...,m(n))$, where C(z,n) is a position code for R(z,n), and $A_n(m(1),...,m(n))$ is the joint amplitude code for the non-zero amplitudes, one aspect of the Joint Position and Amplitude VLC Method invention is that 3109 carries out the encoding by a joint integrated coding function of the position events and of the amplitude events. That is, for the cluster at position R(z,n),

$$V_{R(z,n),\ A_n}\{R(z,n),m(1),\ldots,m(n)\}$$

where $V_{R(z,n),A_n}\{\ \}$ is the code for the combination of R(z,n) and amplitudes m(1),...,m(n). In one embodiment, $V_{R(z,n),A_n}\{.\}$ is also a function of the concatenated code bits used to encode the signs of the non-zero-valued coefficients in the cluster of non-zero coefficients.

Thus, to encode the region, the position events of clusters of non-zero-amplitude coefficients preceded by a run of zero-valued coefficients and followed by a single zero-valued coefficient R(z,n) are recognized as in the 2-D Non-Zero/Zero Cluster VLC Method, and the amplitude events of the cluster are identified as in the Basic Multi-Dimensional Amplitude VLC Method. The resulting position and amplitude events are used to look up a codeword using a multi-dimensional coding table $V_{R(z,n),A_n}\{R(z,n),m(1),...,m(n)\}$. The table $V_{R(z,n),A_n}$ is built up using assumed, or in an adaptive method, using measured statistics. Of course the dimensionality of the table is quite large: two more than the dimensionality of using the Basic Multi-Dimensional Amplitude VLC Method.

In another embodiment of 3107, the amplitude events of the Multi-Table Amplitude VLC Method are used together with the position events of 2-D Non-Zero/Zero Cluster VLC Method to jointly encode the position and amplitude of the cluster. The integrated code of step 3107 in such an embodiment can be described as:

$$V_{R(z,n),C_n}\{R(z,n),\ (j_1,k_1),\ j_2,k_2),\ \ldots\}$$

where $V_{R(z,n),C_n}\{.\}$ is a the joint code for the combination of the position event R(z,n) as defined in the 2-D Non-Zero/Zero Cluster VLC Method, each $(j_i,k_i)$ is the i'th amplitude events recognized in the cluster, i at least 1, such i'th event having a single non-zero amplitude, denoted $k_i$, with $k_i$ greater than 1, preceded by a run of $j_i$ consecutive amplitude-1 coefficients, $j_i \geq 0$, as defined in the Multi-Table Amplitude VLC Method. In one embodiment, the amplitude events $\{(j_i,k_i)\}$ are combined with the sign codes for each such event, such that $V_{R(z,n),C_n}\{.\}$ is also a function of the code bits used to encode the signs of the non-zero-valued coefficients of the amplitude events in the cluster of non-zero-valued coefficients.

In yet another embodiment, integration of the position and amplitude events in 3107 by a single joint encoding is extended to using position events according to at least one position coding method to include position encoding in the joint coding, and to using amplitude events according to at least one amplitude coding method to include position encoding in the joint coding.

In one embodiment, as an example, the position events of a cluster of non-zero coefficients are identified as in the 2-D Non-Zero/Zero Cluster VLC Method, for some cluster lengths, amplitude events as used in the Basic Multi-Dimensional Amplitude VLC Method are used, and for other cluster lengths, amplitude events as used in the Multi-Table Amplitude VLC Method are used. The resulting joint code for the cluster may be defined by the encoding function of the position event and the amplitude events for a cluster of non-zero-valued coefficients as:

$$\texttt{If } n \leq 3 \texttt{ then } V_{R(z,n),\,A_n}\{R(z,n),m(1),\ldots,m(n)\}$$

$$\texttt{else if } n>3 \texttt{ then } V_{R(z,n),C_n}\{R(z,n),(j_1,k_1),j_2,k_2),\ldots\}.$$

Another way of expressing this coding function is as:

$$\alpha\, V_{R(z,n),\,A_n}\{R(z,n),m(1),\ldots,m(n)\}+$$
$$(1-\alpha)\; V_{R(z,n),C_n}\{R(z,n),(j_1,k_1),j_2,k_2),\ldots\}.,$$

where $\alpha$ = 1 for short clusters of non-zero-valued coefficients, for example, values of n=1, 2, or 3, and $\alpha$ = 0 for n>3. Using such a combined code is based on the observation that the inventors made that the performance of using the Basic Multi-Dimensional Amplitude VLC Method reaches a diminishing return after a small dimension/cluster such as n=3, and the performance of the Multi-Table Amplitude VLC Method improves for larger clusters.

Of course such joint coding of both relative position, of runlength, and of the amplitudes of each cluster can lead to extremely complex and large coding tables. In practice, the inventors have found that because relatively low non-zero amplitude values such as 1 and 2 are so much more likely-to-occur than higher amplitude values such as 3, 4, 5, and so forth. Therefore, in a practical implementation, the amplitude values for clusters of non-zero-coefficients used in the joint encoding functions are restricted relatively low amplitude values such as 1 and 2. Clusters containing higher values such as 3, 4, 5, ... are encoded by separate position and amplitude codes as described, for example, in a combination of the 2-D Non-Zero/Zero Cluster VLC Method with the Basic Multi-Dimensional Amplitude VLC Method, or in a combination of the 2-D Non-Zero/Zero Cluster VLC Method with the Multi-Table Amplitude VLC Method, or in a combination of both methods. Because non-zero amplitude values of 1 and 2 are so much more likely-to-occur than the higher amplitudes, so limiting the amplitudes encoded by the joint encoding function should not affect the essential performance of the methods too much.

It should be noted that in each case, the joint coding function is different for each runlength of non-zero-valued coefficients.

*Example comparing various VLC codes described herein*

A comparison of coding using conventional 2D-VLC, the Basic Hybrid VLC Method, the 2-D Non-Zero/Zero Cluster VLC Method with conventional amplitude coding, the 2-D Non-Zero/Zero Cluster VLC Method with the Multi-Dimensional Amplitude VLC Method, and the 2-D Non-Zero/Zero Cluster VLC Method with the Multi-Table Amplitude VLC Method, and the Joint Position and Amplitude VLC Method are now compared.

Suppose a sequence of quantized transform coefficients in the low frequency region is as follows, excluding the DC coefficient, and assuming a breakpoint N = 19:

$$3\ -1\ 1\ 1\ -2\ 1\ 1\ 0\ 0\ -1\ 2\ 1\ 0\ 1\ -1\ 0\ 0\ 0\ 1 \mid 0,$$

where I represents the breakpoint.

**Coding using conventional 2D-VLC**

Coding using conventional 2D-VLC includes identifying events of a run of preceding zero-valued coefficients followed by a single non-zero coefficient. Using I to separate such events, the low frequency region consists of:

$$|3\ |-1\ |\ 1\ |\ 1\ |-2\ |\ 1\ |\ 1\ |\ 0\ \ 0-1\ |\ 2\ |\ 1\ |\ 0\ 1\ |-1\ |\ 0\ \ 0\ \ 0\ \ 1\ |$$

$$(C03+S_+) + (C01+S_-) + (C01+S_+) + (C01+S_+) + (C02+S_-) + (C01+S_+) +$$

$$(C01+S_+) + (C21+S_-) + (C02+S_+) + (C01+S_+) + (C11+S_+) + (C01+S_-) + (C31+S_+)$$

where Czj represents 2D-VLC code for an event of a runlength of z preceding zero-valued coefficients, z=0, 1, ..., followed by a single non-zero coefficient of amplitude j, j=1, 2, ..., and where $S_+$ and $S_-$ represents codes used to encode positive and negative signs, respectively.

**Coding using the Basic Hybrid VLC Method**

Coding using the Basic Hybrid VLC Method in the first (low frequency) region includes identifying events of a run of zero-valued coefficients and alternate runs (clusters) of non-zero coefficients. Using I to separate such events, the low frequency region consists of:

$$|3\ -1\ \ 1\ \ 1\ -2\ \ 1\ \ 1\ |\ 0\ \ 0\ |-1\ \ 2\ \ 1\ \ |\ 0|\ 1\ -1\ |\ 0\ \ 0\ \ 0\ |\ 1\ |$$

$$|C(7)+(A(3)+S_+)+(A(1)+S_-)+(A(1)+S_+)+(A(1)+S_+)+$$

$$(A(2)+S_-)+(A(1)+S_+)+(A(1)+S_+)| + |C'(2)| + |C(3)+(A(1)+S_-)+(A(2)+S_+)+$$

$$(A(1)+S_+)|+|\ C'(1)|\ +|C(2)+(A(1)+S_+)+(A(1)+S_-)| + |\ C'(3)| + |(C1)+(A(1)+S_+)|$$

where C(n) and C'(z) represent the codewords, e.g., the runlength codes for the runlength denoted n of non-zero coefficient clusters and for the runlength denoted z of consecutive zero-valued coefficients, respectively, and Ai represents the magnitude of non-zero amplitude.

**Coding using the 2-D Non-Zero/Zero Cluster VLC Method with conventional amplitude coding**

Coding using the 2-D Non-Zero/Zero Cluster VLC Method with separate amplitude coding of the non-zero-valued coefficients in the first (low frequency) region includes identifying events of a run of zero-valued coefficients preceding a run (cluster) of non-zero coefficients followed by a single zero-valued coefficient. Using I to separate such events, the low frequency region consists of, assuming a soft boundary:

$$|3\ -1\ \ 1\ \ 1\ -2\ \ 1\ \ 1\ \ 0\ |\ 0\ -1\ \ 2\ \ 1\ \ 0\ |\ 1\ -1\ \ 0\ |\ 0\ \ 0\ \ 1\ \ 0|.$$

The code is:

$$|C(0,7)+(A(3)+S_+)+(A(1)+S_-)+(A(1)+S_+)+(A(1)+S_+)+(A(2)+S_-)+$$

$$(A(1)+S_+)+(A(1)+S_+)| + |C(1,3)+(A(1)+S_-)+(A(2)+S_+)+ (A(1)+S_+)|+$$

$$|C(0,2)+(A(1)+S_+)+(A(1)+S_-)| + |C(2,1)+(A(1)+S_+)|$$

where C(z,n) represents position code for 2D non-zero/zero clusters.

**Coding using the 2-D Non-Zero/Zero Cluster VLC Method with the Multi-Dimensional Amplitude VLC Method**

Coding using the the 2-D Non-Zero/Zero Cluster VLC Method with the Multi-Dimensional Amplitude VLC Method to code the position and amplitudes of clusters non-zero-valued coefficients in the first (low-frequency) region includes identifying events of a run of zero-valued coefficients preceding a run (cluster) of non-zero coefficients followed by a single zero-valued coefficient. Using I to separate such events, the low frequency region consists of, assuming a soft boundary, the sequence can be written as:

$$|3\ {-1}\ \ 1\ \ 1\ {-2}\ \ 1\ \ 1\ \ 0\,|\,0\ {-1}\ \ 2\ \ 1\ \ 0\,|\,1\ {-1}\ \ 0\,|\,0\ \ 0\ \ 1\ \ 0.$$

The code is:

$$|C(0,7)+A_7(3,1,1,1,2,1,1)+S_++S_-+S_++S_++S_-+S_++S_+)| +$$

$$|C(1,3)+ A_3(1,2,1)+S_-+S_++S_+ | +|C(0,2)+A_2(1,1) +S_++S_-)| + |C(2,1)+A_1(1)+S_+)|$$

where $A_n(.)$ are n-dimensional functions of the amplitudes of the n-consecutive non-zero amplitudes in a cluster. Note that in practice, it is unlikely that the seven-dimensional codes $A_7$ would be used, and such a code is presented here for illustrative purposes only.

**Coding using the 2-D Non-Zero/Zero Cluster VLC Method with the Multi-Table Amplitude VLC Method**

Coding using the the 2-D Non-Zero/Zero Cluster VLC Method and the Multi-Table Amplitude VLC Method to code the positions and amplitudes of clusters of non-zero-valued coefficients in the first (low frequency) region identifying runs of zero-valued coefficients preceding runs (cluster) of non-zero coefficients followed by a single zero-valued coefficient, then within a cluster of n consecutive non-zero coefficients, identifying events of a run of consecutive amplitude 1 coefficients followed by a single coefficient of amplitude greater than 1. Using I to separate such runs of zero preceding clusters of non-zeroes followed by a single zero, the low frequency region consists of, assuming a soft boundary, the region is:

$$|3\ {-1}\ \ 1\ \ 1\ {-2}\ \ 1\ \ 1\ \ 0\,|\,0\ {-1}\ \ 2\ \ 1\ 0\,|\,1\ {-1}\ \ 0\,|\,0\ \ 0\ \ 1\ \ 0|.$$

The code is:

$$|C(0,7)+C_7(0,3)+S_++C_7(3,2)+S_-+S_++S_++S_-+C_7(Exc)+S_++S_+)|+|C(1,3)+$$

$$C_3(1,2)+S_-+S_++ C_3(Exc)+S_+|+|C(0,2)+C_2(Exc)+S_++S_-| + |C(2,1)+C_1(Exc)+S_+)|$$

where by $C_n(j,k)$ denotes the variable length codeword within a cluster of n non-zero-valued coefficients for a run of j amplitude-1 coefficients preceding a coefficient of value k>1, and $C_n(Esc)$ denotes codeword within a cluster of n non-zero-valued coefficients for a run of only amplitude-1 coefficients that is not followed by a coefficient of amplitude greater than 1.

**Coding using the code of the 2-D Non-Zero/Zero Cluster VLC Method and the code of the Multi-Dimensional Amplitude VLC Method for short clusters, or the code of the Multi-Table Amplitude VLC Method for longer clusters**

Coding using the code of the 2-D Non-Zero/Zero Cluster VLC Method and the code of the Multi-Dimensional Amplitude VLC Method for short clusters, or the code of the Multi-Table Amplitude VLC Method for longer clusters to code the non-zero-valued coefficients in the first (low-frequency) region includes identifying runs of zero-valued coefficients preceding runs (cluster) of non-zero coefficients followed by a single zero-valued coefficient. The method further includes encoding the non-zero amplitudes with a multi-dimensional code for clusters of up to three non-zero coefficients, and, for any cluster of n>3 consecutive non-zero coefficients, identifying events of a run of consecutive amplitude 1 coefficients followed by a single coefficient of amplitude greater than 1. Using I to separate such runs of zero preceding clusters of non-zeroes followed by a single zero, the low frequency region consists of, assuming a soft boundary, the region is:

$$|3\ -1\ \ 1\ \ 1\ -2\ \ 1\ \ 1\ \ 0\,|\,0\ -1\ \ 2\ \ 1\ \ 0\,|\,1\ -1\ \ 0\,|\,0\ \ 0\ \ 1\ \ 0.$$

The code is:

$$C(0,7)+C_7(0,3)+S_++C_7(3,2)+S_-+S_++S_++S_-+C_7(Exc)+S_++S_+)+$$
$$C(1,3),\ A_3(1,2,1)+S_-+S_++S_+\}$$
$$+C(0,2)+\ A_2(1,1)+S_++S_-+C(2,1)+A_1(1)+S_+.$$

Note that for the first cluster of 7 non-zero coefficients, the Multi-Table Amplitude VLC Method is used to encode the non-zero valued coefficients, while for the other clusters of non-zero-valued coefficients, because the runlength of the cluster is three or less, the Basic Multi-Dimensional Amplitude VLC Method is used to encode the amplitudes in the cluster.

**Coding using a combination code that combines the code of the 2-D Non-Zero/Zero Cluster VLC Method and the code of the Multi-Dimensional Amplitude VLC Method**

Coding using a combination code that jointly encodes the position events of the 2-D Non-Zero/Zero Cluster VLC Method and the amplitude events of the Multi-Dimensional Amplitude VLC Method to code the non-zero-valued coefficients in the first (low frequency) region includes identifying runs of zero-valued coefficients preceding runs (cluster) of non-zero coefficients followed by a single zero-valued coefficient, then jointly encoding these position events with the non-zero amplitudes, e.g., using a multi-dimensional code. Using I to separate such runs of zero preceding clusters of non-zeroes followed by a single zero, the low frequency region consists of, assuming a soft boundary, the region is:

$$|3\ -1\ \ 1\ \ 1\ -2\ \ 1\ \ 1\ \ 0\,|\,0\ -1\ \ 2\ \ 1\ \ 0\,|\,1\ -1\ \ 0\,|\,0\ \ 0\ \ 1\ \ 0.$$

The code is:

$$V_{R(z,n),A_7}\{R(0,7),\ 3,1,1,1,2,1,1\}+S_++S_-+S_++S_++S_-+S_++S_++$$
$$V_{R(z,n),A_3}\{R(1,3),\ 1,\ 2,\ 1\}+S_-+S_++S_++$$
$$V_{R(z,n),A_2}\{R(0,2),\ 1,1\}+S_++S_-+V_{R(z,n),A_2}\{R(2,1),1\}+S_+,$$

where the joint codes do not include the signs of each coefficient, such that sign codes are included separately. Note that in practice, it is unlikely that the seven-dimensional cluster would be so jointly encoded-the runlength is very high, and such a code is presented here for illustrative purposes only.

**Coding using a combination code that combines the code of the 2-D Non-Zero/Zero Cluster VLC Method and the code of the Multi-Table Amplitude VLC Method**

Coding using a combination code that combines the position events of the 2-D Non-Zero/Zero Cluster VLC Method and the amplitude events of the Multi-Table Amplitude VLC Method to jointly code the position and amplitudes of clusters of non-zero-valued coefficients in the first (low-frequency) region includes identifying runs of zero-valued coefficients preceding runs (cluster) of non-zero-valued coefficients followed by a single zero-valued coefficient, then within a cluster of n consecutive non-zero coefficients, identifying events of a run of consecutive amplitude 1 coefficients followed by a single coefficient of amplitude greater than 1. Using I to separate such runs of zero preceding clusters of non-zeroes followed by a single zero, the low frequency region consists of, assuming a soft boundary, the region is:

$$|3\ -1\ 1\ 1\ -2\ 1\ 1\ 0|0\ -1\ 2\ 1\ 0|1\ -1\ 0|0\ 0\ 1\ 0|.$$

The code is:

$$V_{R(z,n),C_7}\{R(0,7),(0,3),(3,2),Exc\} + S_+ + S_- + S_+ + S_+ + S_- + S_+ + S_+ +$$
$$V_{R(z,n),C_3}\{R(1,3),\ (1,2),Exc\} + S_- + S_+ + S_+ +$$
$$V_{R(z,n),C_2}\{R(0,2),Exc\} + S_+ + S_- + V_{R(z,n),C_1}\{R(2,1),\ Exc\} + S_+,$$

where again, the signs are coded separately.

It should be noted that the examples above that use the Basic Multi-Dimensional Amplitude VLC Method are for illustrative purposes only. In practice, the size of the dimension for clustered amplitudes need to be limited to lower numbers such as 1, 2 and 3 for practical implementation.

**Coding using a combination code that combines the code of the 2-D Non-Zero/Zero Cluster VLC Method with the code of the Multi-Dimensional Amplitude VLC Method for short clusters, and with the code of the Multi-Table Amplitude VLC Method for longer clusters**

Coding using a combination code that combines the position event identification of the 2-D Non-Zero/Zero Cluster VLC Method with the amplitude events of the Basic Multi-Dimensional Amplitude VLC Method for short clusters, and with the amplitude events of the Multi-Table Amplitude VLC Method for longer clusters to jointly code the relative position and non-zero amplitudes of clusters of non-zero-valued coefficients in the first (low-frequency) region includes identifying runs of zero-valued coefficients preceding runs (cluster) of non-zero coefficients followed by a single zero-valued coefficient. The method further includes jointly encoding the relative position and the non-zero amplitudes with a multi-dimensional code for clusters of up to three non-zero coefficients, and, for each cluster of n>3 consecutive non-zero coefficients, identifying events of a run of consecutive amplitude 1 coefficients followed by a single coefficient of amplitude greater than 1, then jointly encoding the position event with the identified amplitude events. Using I to separate such runs of zero preceding clusters of non-zeroes followed by a single zero, the low frequency region consists of, assuming a soft boundary, the region is:

$$|3\ -1\ 1\ 1\ -2\ 1\ 1\ 0|0\ -1\ 2\ 1\ 0|1\ -1\ 0|0\ 0\ 1\ 0.$$

The code is:

$$V_{R(z,n),C_7}\{R(0,7),(0,3),(3,2),Exc\} + S_+ + S_- + S_+ + S_+ + S_- + S_+ + S_+ +$$
$$V_{R(z,n),A_3}\{R(1,3),\ 1,\ 2,\ 1\} + S_- + S_+ + S_+ +$$
$$V_{R(z,n),A_2}\{R(0,2),\ 1,1\} + S_+ + S_- + V_{R(z,n),A_2}\{R(2,1),1\} + S_+,$$

where again, the signs are coded separately.

Note that for the first cluster of 7 non-zero coefficients, the amplitude event identifying of the Multi-Table Amplitude VLC Method is used, and then joint coding function of the position event and amplitude events is used, while for the other clusters of non-zero-valued coefficients, because the runlength of the cluster is three or less, the event identifying of the Basic Multi-Dimensional Amplitude VLC Method is used for the cluster, and a joint coding function of the position event and the amplitude event is used to obtain the complete codewords.

In an actual implementation, the inventors have noted that a maximal length can be defined for the clusters of non-zero amplitudes. Such use of maximal length is defined in the 2-D Non-Zero/Zero Cluster VLC Method.

Furthermore, in a practice, the inventors have found that because relatively low non-zero amplitude values such as 1 and 2 are so much more likely-to-occur than higher amplitude values such as 3, 4, 5, and so forth, and because the joint coding tables can become complex when there are many possible amplitude values, a practical implementation limits the amplitude values for clusters of non-zero-coefficients used in the joint encoding functions to relatively low amplitude values such as 1 and 2. Higher values such as 3, 4, 5, ... are then encoded by separate position and amplitude codes as described, for example, in a combination of the 2-D Non-Zero/Zero Cluster VLC Method with the Basic Multi-Dimensional Amplitude VLC Method, or in a combination of the 2-D Non-Zero/Zero Cluster VLC Method with the Multi-Table Amplitude VLC Method. Because non-zero amplitude values of 1 and 2 are so much more likely-to-occur than the higher amplitudes, so limiting the amplitudes encoded by the joint encoding function should not affect the essential performance of the method too much.

How to establish the breakpoint is described above in reference to the Basic Hybrid VLC Method and the Extended VLC Method, and below.

*The Adaptive Breakpoint Method for hybrid variable length coding*

In each of the above-described hybrid coding methods, in the case of two regions, e.g., a low frequency region and a high frequency region, a breakpoint is defined as the boundary between the low frequency and high frequency regions. The optimal breakpoint within the frequency spectrum of the transform used in the encoding varies from block to block and picture to picture. As described above, pre-defined breakpoints may be used by pre-determining typical breakpoints by running experiments collecting statistics on a set of typical block coefficients. Typically, different breakpoints are determined for high resolution or high quality still image coding vs. low resolution or low quality still image coding; intraframe coding vs. interframe coding; high bit rate coding methods vs. low bit rate coding methods; DCT-based transform coding methods vs. non-DCT transform coding methods; and so forth.

Although a predetermined breakpoint can provide a satisfactory coding performance it is by no means optimum. The results of various experiments indicated that the performance of a hybrid coder can further be improved by using an optimal breakpoint. The improvement can be as large as 25% of the improvement that has been achieved using a pre-determined breakpoint.

Thus there is a need in the art for a method to determine the optimal or near optimal breakpoint for the purpose of defining a first (low frequency) region and a second (high frequency) region for hybrid coding according to one or another of the above-mentioned hybrid coding methods.

Presented herein are a method, an apparatus, and a carrier medium to find a breakpoint denoted $N_0$ along the path of the ordering of an ordered series of quantized coefficients of a block of image data to identify a first, e.g., low frequency region and a second, e.g., high frequency region.

Referring to the flow chart of a hybrid method 2400 shown in FIG. 24, the Adaptive Breakpoint Method invention deals with block 2401 of establishing the breakpoint. As in describing all the methods herein, in this description, the Adaptive Breakpoint Method is described in terms of transform coefficients, the invention in general relates to encoding an ordered series of digital signals that each has an amplitude from a finite set of amplitude values. Each signal may also have a sign, i.e., be it either positive or negative. The set of amplitude values include one most likely-to- occur amplitude and at least one other amplitude. The application discussed herein is for the ordered series of signals being the ordered set of quantized coefficient values of a block of image data after transformation by a transform such as the DCT or some other common transform, after quantization to a finite number of values, and after ordering along a predefined path, e.g., a zigzag path. The ordering of the series is typically in order of increasing spatial frequency. The most likely-to-occur value, e.g., the most frequently occurring value is typically 0, and in some cases, 1.

Embodiments will be described herein for the case of each image being partitioned into 8 by 8 blocks, then each block, e.g., after motion compensation and interframe subtraction for the case of interframe motion compensated coding, or directly for the case of independent frames or of still frames, being transformed, e.g., by a DCT. The method, carrier medium, and apparatus described herein are not restricted to such block sizes or to the DCT. Other block sizes or transforms may be used.

The method described herein describes determining an image dependent breakpoint. When an image-dependent breakpoint is used, as described above, a code indicating the breakpoint is sent to the decoder with each set of encoded coefficients or images. The same method can be used for individual video frame in a video sequence.

One method to find the optimal breakpoint $N_0$ is to encode the picture 63 times for an 8x8 block transform, trying different breakpoints, i.e., trying $N_0$=1, 2, ..., 63. Comparing the length of the resulting codewords for the block provides the best No and also the codewords for such an optimal $N_0$. Such an approach may be very time consuming, and thus may not always be practical. The case of $N_0$=63 means that the second region is a null region such that there is only one non-null region-the first region-to apply the VLC coding method, and the coding method is the first region coding method. Similarly, the case of $N_0$=0 means that the second region is a null region such that there is only one non-null region-the first region-to apply the VLC coding method, and the coding method is the second region coding method.

The Adaptive Breakpoint Method invention provides a more practical method to use statistics of a set of coefficients of blocks of image data to find a near-optimal breakpoint. The near optimal break point is used for the hybrid coding method.

After an in-depth examination of the performance of the hybrid coder as a function of breakpoint $N_0$ and the statistics of the cluster coefficients within the transform block, we herein described fast method to determine a near optimal breakpoint No was invented. The fast method includes first finding the boundary that defines a region that has more clustered coefficients than isolated scattered coefficients. Once such a region is determined, the next part of the method includes determining the best breakpoint $N_0$ within the determined region. We have found that this determines a value of the breakpoint No that is near the optimum.

Finding the boundary that defines the region for clustered coefficients and then restricting the search for the best breakpoint to such a region can significantly reduce the search time for a near optimal breakpoint. Such a boundary for the clustered region can be as low as 0 to 2 for an interframe video picture that has been efficiently motion compensated, or a highly compressed still image. In such a situation, finding the near optimal breakpoint can be reduced to comparing the coding of a series of 3 or 4 coefficients for a relatively small number of possibilities, instead of encoding all 63 coefficients for a large number of possible values of No. The case that the breakpoint is 0 means that there the first region is a null region and that there is one non-null region to apply the VLC coding method, in this case the "second region" coding method.

A series of experiments indicated that the near optimal breakpoint determined by an embodiment of the present invention consistently brings the performance of the hybrid coder to within 0.2 % of the performance using the true optimal breakpoint which is obtained by conducting an exhaustive search.

FIG. 32 shows a flow chart of one method embodiment 3200 of determining the near optimal breakpoint. 3203 starts with a series of ordered quantized transform coefficients for each image block, e.g., each 8 x 8 image block, with the ordering obtained by traversing the transformed quantized image block along a pre-determined, e.g., zig-zag path. For example, for a color image of 704 by 480 pixels of a luminance component and two chrominance components, there are 5280 x 3 = 15840 series of 64 ordered quantized transform coefficients array. Ignoring the DC coefficients, each series has 63 coefficients.

Statistics are obtained of each frequency for all the sets of 63 coefficients for whether or not a cluster exists at a particular frequency. For this, in 3205, a set of 63 counters is set up, one counter for each frequency, e.g., as an array length 63, with each array location being for a count at a particular frequency. For example, the set up can be written in C code as: int counted[63] in which counter [5] denotes the counter of the number of clusters in position 6 of the zig-zag path, where position 0 is the first AC component.

In 3207, the number of non-zero coefficients that are in a cluster at each frequency location in the sets of series of coefficients is counted. For this, every non-zero-valued coefficient is treated the same. For each location, the count for that location is incremented by 1 if a non-zero coefficient is encountered that is in a cluster. In one embodiment, ascertaining if a particular non-zero coefficient location is in a cluster is according to whether or not the following location's coefficient is non-zero. Thus, a single non-zero coefficient whose next coefficient in the same series of coefficients is zero-valued is not in a cluster. Suppose for example that for a particular series of coefficients, locations 4 and 5 each contain a non-zero coefficient, and location 6 is zero-valued. Then location 4's coefficient is regarded as being in a cluster, and the count at position 4 would be incremented by 1 for this location 4, while location 5's coefficient is not considered to be in a cluster. As a further example, suppose that for a particular series, locations 4, 5, and 6 each have a non-zero-valued coefficient, while location 7 has a zero-valued coefficient. Then location 4's coefficient is ascertained as being in a cluster because the following coefficient is non-zero, and the count at position 4 would be incremented by 1 for this location 4. Similarly, location 5's coefficient is ascertained to be in a cluster, and the count at position 5 would be incremented by 1. Location 6's non-zero-valued coefficient, however, is not considered to be in a cluster because the next coefficient at location 7 is zero-valued.

In this manner, step 3207 is repeated for the complete set of series that make up the entire picture, e.g., for the 15840 series of 63 non-DC quantized transform coefficients for a color image of 704 by 480 pixels of a luminance component and two chrominance components.

Step 3209 selects a threshold at the location of the first count that is below a pre-selected fraction of the maximum count. In one embodiment, the pre-selected fraction is 1/the number of frequencies. For the particular version of such an embodiment for 8 by 8 blocks, the fraction is thus 1/63. So for a color image of three color components of 704 by 480, the first count starting with the lowest frequency location's count that is less than 15840/63, i.e., the location of the first count that is less than or equal to 251 is used as the threshold for the maximum value of the breakpoint.

This is the same as dividing each count by the total number of series and multiplying by the number of non-zero frequencies in the series, e.g., 63 for 8 by 8 blocks, and comparing to 1. The first counter location that is less than 1 is set to be the threshold for finding the near optimal breakpoint.

In 3211, for a frequency location from 2 through the threshold determined in 3209, the location that has the maximum slope in count is set as the near optimal breakpoint. Denoting the counter as counter [i], for i=1 to 63, the, slope is determined as:

$$slope[i]=-(counter[i]-counter[i-1])/counter[i], i=2, …,63.$$

The location i that has the maximum slope amplitude is set to be the value No of the near optimal breakpoint.

Note that variations are possible. In one variation, the threshold location is determined, such a threshold being the position along the series wherein the relative number of blocks in the image that have a coefficient that is in a cluster is first less than a pre-selected fraction of the total number of blocks. A search is then carried out for the optimal breakpoint within the subset of locations up to the threshold. In one version, the search is by comparing the actual code length for encoding the image or a color of the image. In another version, as described above, the location wherein the slope in the number of blocks that have a coefficient that is maximum has the highest magnitude. In yet another version, the location of the largest drop in the relative number of blocks that have a coefficient in a cluster is determined. That is, the near optimal breakpoint is determined as the location **i** such that **(counter[i]-counter[i-1]) /maxcount** is maximum is determined.

In yet another variation, the search is conducted up to a pre-selected fraction of the maximum number of non-DC coefficients. In one such version, the threshold is pre-defined as the max_location/3, where max_location denotes the number of non-DC coefficients, e.g., 63 for 8 by 8 blocks. In another such version, the threshold is pre-defined as the max_location/2. The search for the near optimal breakpoint is then conducted only up to the threshold.

In yet another embodiment, in the case of color frames, if the color information is not encoded at the same resolution as the intensity (luminance) information, different breakpoints are established for the color information and the luminance information. For example, for a color image of 704 by 480 pixels of a luminance component, the two chrominance components may be encoded as 352 by 480 pixel images. In such a case, for 8 by 8 blocks, there are 5280 luminance blocks, and a luminance image breakpoint is established based on these blocks. A possibly different chrominance image breakpoint is established based on the 2 x 2640= 5280 total chrominance blocks to encode each chrominance image.

Further note that although the description of the Adaptive Breakpoint Method is in terms of a breakpoint to define a first region where clusters of non-zero values are likely-to-occur, and a second region where any non-zero coefficients are likely to be scattered, once the first and second regions are established, each such region can be further divided into regions such that the overall ordering may be ultimately divided into more than two regions.

*Decoding*

Another aspect of the invention is a method to decode a bitstream in order to form a series of quantized coefficients of a transform of a block of image data, the transform such that 0 is the most likely coefficient amplitude and 1 is the next most likely coefficient amplitude. The bitstream is encoded by a hybrid coding method, e.g., including any of the version described above. One such coding method, for example, includes, for a first contiguous region in the series, identifying runs that each includes one or more consecutive coefficients having any non-zero amplitude. For each identified run, the coding method includes encoding the relative positions of the runs, and of any intervening consecutive zero-valued coefficients, and further, for each identified run, identifying events of at least one consecutive coefficient, an identified event including a sequence of at least one consecutive amplitude-1 coefficient ending in a coefficient of amplitude greater than 1, or including only a coefficient of amplitude greater than 1, or including of only a sequence of consecutive amplitude-1 coefficients. Each identified event for the runlength of the identified run is defined by the length of the sequence of at least one consecutive amplitude-1 coefficients, and by the amplitude of the ending coefficient. The coding method further includes encoding each identified event by at least one codeword such that for at least some identified events, relatively more likely-to-occur events are encoded by a shorter codeword than relatively less likely-to-occur events.

The decoding method includes recognizing a codeword, determining the event represented by the recognized codeword; and determining the sub-series of coefficients of each determined event, until all coefficients in the series are determined.

Another aspect of the invention is an apparatus for decoding a bitstream encoded by any of the methods described herein. As an example, FIG. 8 shows one embodiment of the apparatus for decoding a set of codewords coded by the Extended Hybrid VLC Method that uses five coding tables as described above. A codeword recognizer 802 accepts the bits of a bitstream and recognizes a codeword of a set of possible codewords that each represents an event. The codeword recognizer determines which of the five coding tables the codeword is from. A decoder 804 is coupled to the codeword recognizer 802 and determines the data for the codeword recognized by the codeword recognizer, e.g., the runlength of non-zeroes, the runlength of zeroes, the sign, etc.. In one embodiment, the decoder 804 includes a lookup device that looks up the appropriate decoding table stored in a memory 806. That table provides the event for at least some of the codewords of the set of codewords. Other codewords may include an escape code, so that decoding is by other than a table lookup method. In one embodiment, the bitstream is stored in a buffer 808, and the output of the buffer is coupled to the codeword recognizer.

While in the embodiment shown in FIG. 8, the memory is shown separate from the lookup device, those in the art will understand that in other embodiments, the lookup device includes memory for the tables, and such other embodiments are included herein.

Note further that in FIG. 8, the codeword recognizer and also the lookup device may be each implemented on a computer as a set of instructions stored in a memory, e.g., the memory 806, that instruct one or more processors to carry out the operations of the recognition and of the lookup.

Another aspect of the invention is a memory (such as memory 806 in FIG. 8) that stores a decoding data structure that provides the data for any set of codewords recognized in a bitstream of compressed image data. The bitstream is coded by any one of the novel coding methods described herein. In one embodiment, the data structure is in the form of one or more tables.

*Coding and decoding apparatus including a processor*

Another aspect of the invention is an apparatus for coding a series of digital signals, e.g., an ordered series of quantized coefficients of a transformed block of image data, with an apparatus that includes a processing system. FIG. 9 shows an apparatus 900 that includes a processing system 902 that includes one or more processors 904 and a memory 906. A single processor is shown in FIG. 9 and those in the art will appreciate that this may represent several processors. Similarly, a single memory subsystem 906 is shown, and those in the art will appreciate that the memory subsystem may include different elements such as RAM, ROM, and so forth. In addition, the memory subsystem is meant to include any non-volatile memory storage such as a magnetic or optical storage component. A computer program 908 is included and is loaded into the memory 906. Note that at any time, some of the program may be in different parts of the memory subsystem, as will be understood by those in the art. The program 908 includes instructions to instruct the processor to implement, in different versions, different hybrid coding methods that include the processor accepting as data the ordered coefficients, determining a breakpoint along the ordering of the coefficients to define a first and a second region, and respectively determining and generating the codewords for the coefficients in the first and second region according to a first region coding method and a second region coding method. The determining of the breakpoint can be, e.g., according to one or more aspects of the Adaptive Breakpoint Method invention. The apparatus 900 further includes in the memory subsystem 906 a coding data structure 910 that provides the codewords for sets of one or more coefficients as described in any one of the first region and second region coding methods described in any of the hybrid VLC methods described herein. In one embodiment, the data structure is in the form of one or more tables, e.g., in the form of the coding tables for the position codes and for the amplitude codes, and for the joint coding functions of the position codes and the amplitude codes.

Another aspect of the invention is a memory (such as memory 906 in FIG. 9) that stores a coding data structure that provides the codewords for sets of one or more coefficients as described in any one of the novel coding methods described herein. In one embodiment, the data structure is in the form of one or more tables.

Yet another apparatus embodiment is shown in FIG. 10 as decoding apparatus 1000 that includes processing system 1002 that includes one or more processors 1004 and a memory 1006. A single processor is shown in FIG. 10 and those in the art will appreciate that this may represent several processors. Similarly, a single memory subsystem 1006 is shown, and those in the art will appreciate that the memory subsystem may include different elements such as RAM, ROM, and so forth. In addition, the memory subsystem is meant to include any non-volatile memory storage such as a magnetic or optical storage component. A computer program 1008 is included and is loaded into the memory 1006. Note that at any time, some of the program may be in the different parts of the memory subsystem, as will be understood by those in the art. The program 1008 includes instructions to instruct the processor to implement, in different versions, the different decoding methods described above. The processor thus accepts as data the codewords that are generated by any of the coding methods described above, and generates the series of quantized transform coefficients. The apparatus 1000 further includes in the memory subsystem 1006 a coding data structure 1010 that provides the events of one or more coefficients for the different codewords as described in any one of the novel coding methods described herein. In one embodiment, the data structure is in the form of one or more tables.

Note that neither FIG. 9 nor FIG. 10 show details such as bus structures, I/O structures, etc., that may be included since the need for such structures would be known to those in the art and their inclusion would only obscure the inventive aspects of the apparatus. Furthermore, the processing system may be implemented using one or more a general purpose microprocessors, one or more microcontrollers that includes several memory and other elements, one or more DSP devices, or any other programmable processors. Furthermore, the processors may be standalone devices, or may be implemented as "cores" to be included in an ASIC, gate array, or other device.

Another aspect of the invention is a memory (such as memory 706 in FIG. 7 or memory 906 in FIG. 9) that stores a coding data structure that provides the codewords for sets of one or more coefficients as described in any one of the novel coding methods described herein. In one embodiment, the data structure is in the form of one or more tables.

Another aspect of the invention is a memory (such as memory 806 in FIG. 8 or memory 1006 in FIG. 10) that stores a decoding data structure that provides the data for any set of codewords recognized in a bitstream of compressed image data. The bitstream is coded by any one of the novel coding methods described herein. In one embodiment, the data structure is in the form of one or more tables.

Thus, a hybrid variable length coding method, an apparatus to so code, and a carrier medium carrying instructions to instruct a processor or processors to carry out the hybrid variable length coding method have been described suitable for encoding the quantized transform coefficients of blocks of images as occur in common image compression methods. Different versions use different coding methods suitable for the different regions.

Furthermore, a decoding method, an apparatus to so decode, and a carrier medium carrying instructions to instruct a processor or processors to carry out a decoding method have been described suitable for decoding codewords obtained using a hybrid coding method.

Furthermore, a breakpoint determining method and apparatus to so determine the breakpoint, and a carrier medium carrying instructions to instruct a processor or processors to carry out the method, have been described suitable for determining the breakpoint to define a first and second region in an ordered series of quantized transform coefficients of blocks of images as occur in common image compression methods, such that the coefficients in the first region can be encoded using a first region coding method, and the coefficients in the second region can be encoded using a second region coding method.

One embodiment of the Basic Hybrid VLC Method and Extended Hybrid VLC Method invention uses five independent tables: two runlength code tables for the first and second runlength coding methods, and a first amplitude code table for use in the first region, and another runlength code table for the third runlength coding method, and a second amplitude code table for use in the second region.

The methodologies described herein are, in one embodiment, performable by a processing system (a machine), which includes a one or more processors that accept code segments containing instructions. For any of the methods described herein, when the instructions are executed by the machine, the machine performs the method. Any machine capable of executing a set of instructions (sequential or otherwise) that specify actions to be taken by that machine are included. Thus, one a typical machine may be exemplified by a typical processing system that includes one or more processors. Each processor may include one or more of a CPU, a graphics processing unit, and a programmable DSP unit. The processing system further may include a memory subsystem including main RAM and/or a static RAM, and/or ROM. A bus subsystem may be included for communicating between the components. If the processing system requires a display, such a display may be included, e.g., an liquid crystal display (LCD) or a cathode ray tube (CRT) display. If manual data entry is required, the processing system also includes an input device such as one or more of an alphanumeric input unit such as a keyboard, a pointing control device such as a mouse, and so forth. The term memory unit as used herein also encompasses a storage system such as a disk drive unit. The processing system in some configurations may include a sounds output device, and a network interface device. The memory subsystem thus includes a carrier medium that carries machine-readable code segments (e.g., software) including instructions for performing, when executed by the processing system, one of more of the methods described herein. The software may reside in the hard disk, or may also reside, completely or at least partially, within the RAM and/or within the processor during execution thereof by the computer system. Thus, the memory and the processor also constitute carrier medium carrying machine-readable code.

In alternative embodiments, the machine operates as a standalone device or may be connected, e.g., networked to other machines, in a networked deployment, the machine may operate in the capacity of a server or a client machine in server-client network environment, or as a peer machine in a peer-to-peer or distributed network environment. The machine may be a personal computer (PC), a tablet PC, a set-top box (STB), a Personal Digital Assistant (PDA), a cellular telephone, a web appliance, a network router, switch or bridge, or any machine capable of executing a set of instructions (sequential or otherwise) that specify actions to be taken by that machine.

Note that while some diagram(s) only show(s) a single processor and a single memory that carries the code, those in the art will understand that many of the components described above are included, but not explicitly shown or described in order not to obscure the inventive aspect. For example, while only a single machine is illustrated, the term "machine" shall also be taken to include any collection of machines that individually or jointly execute a set (or multiple sets) of instructions to perform any one or more of the methodologies discussed herein.

One embodiment of each of the methods described herein is in the form of a computer program that executes on a processing system, e.g., a one or more processors that are part of an image coder or decoder, as appropriate. Thus, as will be appreciated by those skilled in the art, embodiments of the present invention may be embodied as a method, an apparatus such as a special purpose apparatus, an apparatus such as a data processing system, or a carrier medium, e.g., a computer program product. The carrier medium carries one or more computer readable code segments for controlling (instructing) a processing system to implement a method. Accordingly, aspects of the present invention may take the form of a method, an entirely hardware embodiment, an entirely software embodiment or an embodiment combining software and hardware aspects. Furthermore, the present invention may take the form of carrier medium (e.g., a computer program product on a computer-readable storage medium) carrying computer-readable program code segments embodied in the medium. Any suitable computer readable medium may be used including a magnetic storage device such as a diskette or a hard disk, or an optical storage device such as a CD-ROM.

The software may further be transmitted or received over a network via the network interface device. While the carrier medium is shown in an exemplary embodiment to be a single medium, the term "carrier medium" should be taken to include a single medium or multiple media (e.g., a centralized or distributed database, and/or associated caches and servers) that store the one or more sets of instructions. The term "carrier medium" shall also be taken to include any medium that is capable of storing, encoding or carrying a set of instructions for execution by the machine and that cause the machine to perform any one or more of the methodologies of the present invention. A carrier medium may take many forms, including but not limited to, non-volatile media, volatile media, and transmission media. Non-volatile media includes, for example, optical, magnetic disks, and magneto-optical disks. Volatile media includes dynamic memory, such as main memory. Transmission media includes coaxial cables, copper wire and fiber optics, including the wires that comprise a bus subsystem. Transmission media also may also take the form of acoustic or light waves, such as those generated during radio wave and infrared data communications. For example, the term " carrier medium" shall accordingly be taken to included, but not be limited to, solid-state memories, optical and magnetic media, and carrier wave signals.

It will be understood that the steps of methods discussed are performed in one embodiment by an appropriate processor (or processors) of a processing (i.e., computer) system executing instructions (code segments) stored in storage. It will also be understood that the invention is not limited to any particular implementation or programming technique and that the invention may be implemented using any appropriate techniques for implementing the functionality described herein. The invention is not limited to any particular programming language or operating system.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment. Furthermore, the particular features, structures or characteristics may be combined in any suitable manner, as would be apparent to one of ordinary skill in the art from this disclosure, in one or more embodiments.

Similarly, it should be appreciated that in the above description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the Detailed Description are hereby expressly incorporated into this Detailed Description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

It should further be appreciated that although the invention has been described in the context of transform encoding of images, the invention is not limited to such contexts and may be utilized in various other compression applications and systems. Furthermore, the invention is not limited to any one type of architecture or type of transform encoding. For example, the DCT is mentioned above as one transform. Other transforms may be used, e.g., the new H.264/MEG-4 AVC video coding standard/draft standard defines 4x4 blocks and a DCT-like 4x4 integer transform. The invention does not depend on any particular type of interframe coding if used, or of motion compensation if used for interframe coding, or any intra-estimation if used for estimating the pixels of a block using information from neighboring blocks.

Note that variable length coding is sometimes referred to as entropy coding or statistical coding.

Note that the terms coding and encoding are used interchangeably herein.

Note also that while the embodiments above included separate sign bits for the sign, the sign can be incorporated into any of the amplitude coding methods.

Note that in some of the above examples for amplitude encoding, 63 or 127 possible non-zero values are assumed for the coefficients, the invention is not restricted to any number of possible quantization values.

Note also that the term amplitude is irrespective of sign. Therefore, for example, coefficient of values +1 and -1 both have amplitude 1.

In some of the embodiments described above, no sign data was included. Most transforms produce positive and negative coefficients, and the forming of the codeword includes an indication of the sign of any non-zero-valued coefficients. In one version, the sign information for any runs of non-zero amplitudes in any region is added together with the information of each amplitude. In an alternate embodiment, the sign information for any runs of non-zero amplitudes in any region may be included in a different manner, e.g., as a code for the series of signs. Other alternate embodiments are also possible for encoding the sign.

In the embodiments described above, the forming of the codeword includes an indication of the sign of any non-zero coefficients. In one version, the sign information for any runs of non-zero amplitudes in the first region is added together with the information of each amplitude. In an alternate embodiment, the sign information for any runs of non-zero amplitudes in the first region may be included in a different manner, e.g., as a code for the series of signs. Other alternate embodiments are also possible for encoding the sign.

While one embodiment described herein includes a memory that stores coding tables, other embodiments store the coding information in the form of a data structure other than a table, e.g., a structure that includes a tree. Other data structures may also be used. Similarly, while one embodiment described herein includes a memory that stores a decoding, other embodiments store the decoding information in the form of a data structure other than a table for the decoding.

Note also that the present invention does not depend on the particular type of VLC used for any of the coding methods, e.g., the coding tables, and can work, for example, with Huffman coding and with arithmetic coding methods. Furthermore, while embodiments have been described that used fixed encoding for the events based on assumed or a priori likelihoods of occurrence of the events (also called the symbols), i.e., the likelihoods of occurrence of the events do not change, other embodiments use adaptive encoding, i.e., the encoding is changeable according to statistical data such as histograms collected from the actual coefficients.

In the claims below and the description herein, the term "comprising" or "comprised of" or "which comprises" is an "open" term that means including at least the elements/features that follow, but not excluding others. The term "including" or "which includes" or "that includes" as used herein is also an "open" term that also means including at least the elements/features that follow the term, but not excluding others. Thus, including is synonymous with and means comprising.

Thus, while there has been described what are believed to be the preferred embodiments of the invention, those skilled in the art will recognize that other and further modifications may be made thereto without departing from the scope of the invention, and it is intended to claim all such changes and modifications as fall within the scope of the invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method of encoding an ordered series of quantized coefficients of a transformed block of image data transformed by a transform and quantized by quantization, the series ordered according to an ordering, the quantized coefficients each having an amplitude from a finite set of amplitudes consisting of the most likely-to-occur amplitude and at least one other amplitude, the processing to reduce the amount of data used to represent the series and to form codewords such that on average, the more likely a quantized coefficient or sequence of quantized coefficients, the shorter the codeword used to represent the quantized coefficient or sequence of quantized coefficients, the method comprising:

   establishing at least one breakpoint along the ordering of the series to break the series into one or more contiguous regions according to the distribution of amplitudes of the quantized coefficients in each region, each region having a corresponding coding process that includes recognizing events and forming codewords for the series, including codewords for the events, the one or more contiguous regions including a first contiguous region such that clusters of consecutive quantized coefficients of any amplitude other than the most likely-to-occur amplitude are more likely to occur in the first contiguous region than in any other region, the corresponding coding processes including a first region coding method for the first region; and
   for each region of the series, applying the coding process corresponding to the region to form a set of codewords of the series, including applying the first region coding method,
   wherein the first region coding method includes:

identifying events, including:

i) events that each includes a run of consecutive coefficients of the most likely-to-occur amplitude, preceding a run of plural consecutive quantized coefficients having any amplitude other than the most likely-to-occur amplitude,
ii) events of no coefficients of the most likely-to-occur amplitude preceding a run of one or more consecutive coefficients having other than the most likely-to-occur amplitude, and
iii) events of a run of consecutive coefficients of the most likely-to-occur amplitude, preceding a run of one quantized coefficient having any amplitude other than the most likely-to-occur amplitude;

for each identified event, jointly encoding the run lengths of the preceding run of the most likely-to-occur amplitude and the following run of other than the most likely-to-occur amplitude with a codeword called a position codeword, such that for at least some events, relatively more likely-to-occur pairs of run lengths are encoded by a shorter position codeword than relatively less likely-to-occur run lengths; and
for each identified event, encoding those amplitudes in the run of consecutive quantized coefficients having other than the most likely-to-occur amplitude according to an amplitude coding method,

and/or wherein the establishing the at least one breakpoint establishes a breakpoint along the ordering of the series to define a first contiguous region and a second contiguous region, such that clusters of consecutive quantized coefficient of any amplitude other than the most likely-to-occur amplitude are more likely to occur in the first contiguous region than in any other region, and the coding process for the second region includes identifying events that include runs of consecutive quantized coefficients of the most likely-to-occur amplitude in the second region that end in a single quantized coefficient having other than the most likely-to-occur amplitude, and encoding said identified events in the second region using a third coding method, the encoding including indicating that the ending single quantized coefficient has an amplitude other than the next most likely-to-occur amplitude to the most likely-to-occur amplitude, such that, on average, relatively short codewords are formed to represent amplitudes or sequences of consecutive quantized coefficients that are relatively more likely to occur, and relatively long codewords are formed to represent amplitudes or sequences of quantized coefficients that are relatively less likely to occur.

**2.** A method as recited in claim 1,
wherein the applying the encoding for the first region includes:

identifying events that each includes a run of consecutive coefficients of the most likely-to-occur amplitude, preceding a run of one or more consecutive quantized coefficients having any amplitude other than the most likely-to-occur amplitude, including events of no coefficients of the most likely-to-occur amplitude preceding a run of one or more consecutive coefficients having other than the most likely-to-occur amplitude;
for each identified event, jointly encoding the run lengths of the preceding run of the most likely-to-occur amplitude and the following run of other than the most likely-to-occur amplitude with a codeword, such that for at least some events, relatively more likely-to-occur pairs of run lengths are encoded by a shorter codeword than relatively less likely-to-occur run lengths;
for each identified event, encoding each amplitude in the run of consecutive quantized coefficients having other than the most likely-to-occur amplitude, the encoding according to an amplitude coding method,

such that, on average, relatively short codewords are formed to represent amplitudes or sequences of quantized coefficients that are relatively more likely-to-occur, and relatively long codewords are formed to represent amplitudes or sequences of quantized coefficients that are relatively less likely-to-occur.

**3.** A method as recited in any preceding claim, wherein the establishing the at least one breakpoint establishes a breakpoint along the ordering of the series to define a first contiguous region and at least a second contiguous region, such that clusters of consecutive quantized coefficient of any amplitude other than the most likely-to-occur amplitude are more likely to occur in the first contiguous region than in any other region, and wherein applying the coding processes corresponding to the regions includes using three encoding methods to code the quantized coefficients in at least two regions.

**4.** A method as recited in any preceding claim,
wherein the establishing the at least one breakpoint establishes a breakpoint along the ordering of the series to define a first contiguous region and a second contiguous region, such that clusters of consecutive quantized coefficients of any amplitude other than the most likely-to-occur amplitude are most likely occur in the first contiguous region,
wherein the transform and quantization are such that the most likely-to-occur amplitude is 0, and the next most likely-to-occur amplitude is 1, and
wherein the coding method for the second region includes a two-dimensional variable-length coding method that encodes events consisting of a run of consecutive zero-valued coefficients followed by a single non-zero-valued coefficient.

**5.** A method as recited in any one of claims 1 to 3,
wherein the encoding the events that include runs of consecutive quantized coefficients of the most likely-to-occur amplitude in the second region that end in a single quantized coefficient having other than the most likely-to-occur amplitude, include indicating that the ending single quantized coefficient has an amplitude other than the next most likely-to-occur amplitude to the most likely-to-occur amplitude, and
wherein the encoding of events in the second region forms on average relatively short codewords to represent sequences of quantized coefficients that are relatively more likely to occur, and relatively long codewords to represent sequences of quantized coefficients that are relatively less likely to occur.

**6.** A method as recited in claim 5,
wherein the transform and quantization are such that the most likely-to-occur amplitude is 0, and the next most likely-to-occur amplitude is 1, and
wherein the encoding of events in the second region includes encoding run lengths of consecutive zero-valued coefficients that end in an amplitude-1 coefficient using a variable length run length coding method,
the method further comprising:

identifying events that include runs of consecutive amplitude-zero coefficients in the second region that end in a single coefficient having an amplitude greater than 1;
further using an exception code to encode the identifying events that end in a coefficient having an amplitude greater than 1;
encoding the signs of the non-zero-valued coefficients;
encoding the amplitudes of the non-zero-valued coefficients in the first region; and
encoding the amplitudes greater than 1 in the second region.

**7.** A method as recited in claim 6,
wherein the transform and quantization are such that the most likely-to-occur amplitude is 0, and the next most likely-to-occur amplitude is 1, and
wherein codewords are also generated for the amplitudes and signs of each of the non-zero-valued coefficients of amplitude greater than 1 in the second region.

**8.** A method as recited in any preceding claim,
wherein the encoding processes use coding tables.

**9.** A method as recited in any one of claims 6 and 7,
wherein a second region run length code table and a second region amplitude code table are provided for coding information in the second region,
wherein the second region run length code table is for storing a plurality of codewords for a set of run lengths of zero valued coefficients that end in an amplitude-one coefficient and that occur in the second region, the second region table organized such that the more likely-to-occur run lengths have shorter codewords than the less likely-to-occur run lengths,
wherein the second region amplitude code table is for storing a plurality of codewords for the amplitudes greater than 1 of non-zero coefficients that occur in the second region, and
wherein the step of forming a codeword for each run length of zero valued coefficients that ends in a non-zero-valued coefficient in the second region includes looking up the second region run length code table.

**10.** A method as recited in claim 2,
wherein, for the first region encoding method:

the recognizing of events includes recognizing events that each includes a run of consecutive quantized coefficients of amplitudes other than the most likely-to-occur amplitude;
the forming codewords for the recognized events in the first region includes for each event that includes a plurality of consecutive quantized coefficients, joint encoding a plurality of consecutive amplitudes in the run of consecutive quantized coefficients having other than the most likely-to-occur amplitude, the joint encoding according to an amplitude coding method.

**11.** A method as recited in claim 10, wherein the joint encoding jointly encodes a plurality of amplitudes, and separately encodes the signs of the coefficients whose amplitudes are jointly encoded.

**12.** A method as recited in claim 10, wherein the joint encoding jointly encodes a plurality of amplitudes including the signs of the of the coefficients whose amplitude is jointly encoded, such that no separate sign encoding is used for the coefficients whose amplitudes are jointly encoded.

**13.** A method as recited in claim 10,
wherein the transform and quantization are such that the most likely-to-occur amplitude is 0, and the next most likely-to-occur amplitude is 1, and
wherein the identifying events includes identifying events that each includes a run of consecutive zero-valued coefficients, preceding a run of one or more consecutive non-zero-valued coefficients, including events of no zero-valued coefficients preceding a run of one or more consecutive non-zero-valued coefficients; and wherein the jointly encoding includes jointly encoding the run lengths of the preceding run of zero-valued coefficients and the following run of non-zero-valued coefficients, such that for at least some events, relatively more likely-to-occur pairs of run lengths are encoded by a shorter codeword than relatively less likely-to-occur run lengths.

**14.** A method as recited in claim 13, further comprising:

providing a breakpoint to define the first contiguous region along the ordering of the series followed by a second continuous region; such that the coefficients of the first region are encoded by a first encoding method that includes the identifying of events, the jointly encoding the run lengths of the events, and the encoding the amplitudes of non-zero-valued coefficients of the events; and
encoding the coefficients in the second region using a second region encoding method, and

wherein a first region encoding method and the second region encoding method are such that the encoding of at least some of the coefficients or runs of coefficients in the first region is different than the encoding of at least some of the coefficients or runs of coefficients in the second region.

**15.** A method as recited in claim 13, wherein the joint encoding of the run lengths on an event uses a multidimensional coding table.

**16.** A method as recited in claim 13, wherein the number of events that are identified and whose run lengths jointly encoded is limited such that only events up to a maximum total number of coefficients are identified, and wherein the identifying also identifies events of all zeroes of the maximum length, and maximal length events that end in a non-zero-coefficient, such that escape codes may be avoided in coding the coefficients of the first region.

**17.** A method as recited in claim 10,
wherein the transform and quantization are such that the most likely-to-occur amplitude is 0, and the next most likely-to-occur amplitude is 1, and
wherein the identifying events includes identifying the run lengths of runs of any zero-valued coefficients preceding one or more consecutive non-zero-valued coefficients and identifying the run lengths of the one or more non-zero-valued coefficients that follow the run length runs of zero-valued coefficients; and
wherein the jointly encoding the run lengths includes encoding the run lengths of the runs of non-zero-valued coefficients using a first run length coding method, and encoding the run lengths of identified runs of zero-valued coefficients using a second run length coding method,
such that for at least some events, relatively more likely-to-occur pairs of run lengths are encoded by a shorter codeword than relatively less likely-to-occur run lengths.

**18.** A method as recited in any preceding claim,
wherein the transform and quantization are such that the most likely-to-occur amplitude is 0, and the next most likely-to-occur amplitude is 1, and
wherein the breakpoint value is pre-selected.

**19.** A method as recited in any preceding claim, wherein the series is formed from an interframe block of image data, and wherein a first pre-selected breakpoint value is used for interframe image data of a first kind, and a second pre-selected breakpoint value is used for interframe image data of a second kind.

**20.** A method as recited in claim 19, wherein the first kind of interframe coding is of a higher bit rate than the second kind of interframe coding.

**21.** A method as recited in any preceding claim, wherein the breakpoint value is selected from a finite set of pre-defined breakpoint values according to an image-dependent criterion.

**22.** A method as recited in claim 21, wherein the breakpoint value is selected from the finite set of pre-defined breakpoint values according to which of the breakpoints of the set produces the shortest number of bits.

**23.** A method as recited in any preceding claim, wherein the transformed block of image data after quantization includes a DC term, and wherein the DC term is separately encoded, such that the ordered series of quantized coefficients is a series of non-DC quantized coefficients.

**24.** A method as recited in any preceding claim, wherein the breakpoint defines a hard boundary between the first and second regions.

**25.** A method as recited in any one of claims 1 to 23, wherein the breakpoint defines a soft boundary between the first and second regions, such that for an event that starts prior to the breakpoint and that crosses the breakpoint, the boundary between the first and second region is at the end of the event such that the whole event is in the first region.

**26.** A method as recited in any preceding claim, further comprising:

classifying the series into a particular class of a plurality of classes according to the distribution of amplitudes of the quantized coefficients, each class having a corresponding coding process of forming the codewords for the series;
for the particular class of the series, applying the coding process corresponding to the class to form a set of codewords of the series; and
adding an indication to the formed codewords to indicate the particular class,

such that, on average, relatively short codewords are formed to represent quantized coefficients or sequences of quantized coefficients that are relatively more likely to occur, and relatively long codewords are formed to represent quantized coefficients or sequences of quantized coefficients that are relatively less likely to occur.

**27.** A method as recited in claim 26, wherein the transform and quantization are such that the most likely-to-occur amplitude is 0, and the next most likely-to-occur amplitude is 1, and wherein there are two classes for any type of image.

**28.** A method as recited in claim 26, wherein there are at least four classes for any type of image.

**29.** A method as recited in claim 28, wherein the transform and quantization are such that the most likely-to-occur amplitude is 0, and the next most likely-to-occur amplitude is 1, and wherein the classes include:

a first class of series wherein non-zero-valued coefficients along the ordering of the coefficients are of non-zero amplitudes, including a significant number that are not $\pm 1$, and wherein the non-zero valued coefficients are clustered throughout the ordering such that there is no clear breakpoint along the path of the ordering of the coefficients to identify a first region in which non-zero-valued coefficients are clustered and a second region in which the non-zero-valued coefficients are scattered;
a second class of series wherein a significant number of non-zero-valued coefficients along the ordering of the coefficients are of non-zero-valued amplitudes, including a significant number that are not ±1, and wherein there is a breakpoint along the path of the ordering of the coefficients to identify a first region in which the non-zero valued coefficients are substantially clustered and a second in which the non-zero valued coefficients are scattered;
a third class of series wherein any non-zero-valued coefficients along the ordering of the coefficients are essentially dominated by coefficients that are ±1, and wherein there is a breakpoint along the path of the ordering of the coefficients to identify a first region in which these non-zero valued coefficients are substantially clustered and a second region in which these non-zero valued coefficients are scattered; and
a fourth class of series wherein any non-zero-valued coefficients along the ordering of the coefficients are essentially dominated by coefficients that are ±1 and wherein the non-zero valued coefficients are scattered throughout the ordering such that there is no clear breakpoint along the path of the ordering of the coefficients to identify a first region in which non-zero-valued coefficients are clustered and a second region in which these non-zero valued coefficients are scattered.

**30.** A method as recited in any one of claims 26 to 29,
wherein the plurality of classes depends on at least one of the group consisting of:

whether the image block is an intraframe/still image block, or an interframe image block;
whether the image block is a standard definition television image block or HDTV image block;
whether the method is for high bit rate coding or relatively low bit rate coding; and
whether the transform is a DCT or a non-DCT transform.

**31.** A method as recited in claim 26,
wherein the classifying uses the series of coefficients.

**32.** A method as recited in claim 31,
wherein the transform and quantization are such that the most likely-to-occur amplitude is 0, and the next most likely-to-occur amplitude is 1, and
wherein the classifying includes determining the statistics of the coefficients according to at least one of the group of statistical criteria consisting of:

whether or not there exists a breakpoint defining a first region where the non-zero coefficients are clustered and a second region where the non-zero-valued coefficients are mostly scattered;
whether or not the non-zero-valued coefficients are mostly clustered or mostly scattered; and
whether or not the non-zero-valued coefficients in a region or the whole block are almost all of amplitude 1.

**33.** A method as recited in claim 31, wherein the classifying selects the class according to which corresponding method produces the most compressed bitstream.

**34.** A method as recited in claim 33, wherein the classifying includes applying each of the corresponding coding processes sequentially and selecting the particular class according to the compression produced by the coding process corresponding to the particular class.

**35.** A method as recited in claim 33, wherein the classifying includes applying each of the corresponding coding processes in parallel and selecting the particular class according to the compression produced by the coding process corresponding to the particular class.

**36.** A method as recited in any preceding claim,
wherein the transform and quantization are such that the most likely-to-occur amplitude is 0, and the next most likely-to-occur amplitude is 1, and
wherein the method further comprises the step of:

forming fixed length codewords for at least some of the recognized events.

**37.** A method as recited in claim36, wherein the first region coding method includes forming fixed length codewords for at least some of the recognized events in the first region.

**38.** A method as recited in claim36, wherein the second region coding method includes forming fixed length codewords for at least some of the recognized events in the second region.

**39.** A method as recited in claim 36, wherein the recognized events for which the fixed codewords are formed are less likely to occur than the recognized events for which a variable length codeword is used, and wherein the fixed length codewords are at least as long as any variable length codeword.

**40.** A method as recited in claim 36, wherein each fixed length codeword includes an escape code.

**41.** A method as recited in any preceding claim,
wherein the transform and quantization are such that the most likely-to-occur amplitude is 0, and the next most likely-to-occur amplitude is 1, and
wherein the method further comprises:

forming an indication to indicate that all the remaining quantized coefficients in the second region of the series have the most likely-to-occur amplitude.

**42.** A method as recited in any preceding claim,
wherein the transform and quantization are such that the most likely-to-occur amplitude is 0, and the next most likely-to-occur amplitude is 1, and
wherein the series is divided into more than two regions by the breakpoint and an additional breakpoint for each region in addition to a second region, the method further comprising:

encoding the quantized coefficients occurring in each additional regions defined by the corresponding additional breakpoint, the encoding using a coding method different from the coding methods used in other regions.

**43.** A method as recited in any preceding claim,
wherein the transform and quantization are such that the most likely-to-occur amplitude is 0, and the next most likely-to-occur amplitude is 1.

**44.** A method as recited in any preceding claim,
wherein the transform and quantization such that the most likely-to-occur amplitude is 0, and the next most likely-to-occur amplitude is 1, and
wherein the forming of codewords for each run length is fixed based on assumed a priori likelihoods of occurrences of the events.

**45.** A method as recited in any preceding claim,
wherein the transform and quantization are such that the most likely-to-occur amplitude is 0, and the next most likely-to-occur amplitude is 1, and
wherein the forming of codewords for each event is changeable according to actual statistical data collected from ordered series of quantized coefficients.

**46.** A method to decode a bitstream in order to form a series of quantized coefficients of a transform of a block of image data transformed by a transform and quantized by quantization, the quantized coefficients each having an amplitude including a most likely-to-occur amplitude and at least a next most likely-to-occur amplitude,
the decoding method comprising:

recognizing a codeword;
determining the event represented by the recognized codeword; and
determining the coefficients of each determined event,

until all coefficients in the series are determined,
wherein the codewords in the bitstream are determined using a method of encoding as recited in any one of claims 1 to 45.

**47.** An apparatus including a processing system, the apparatus to accept an ordered series of quantized coefficients that each have an amplitude from a finite set of amplitudes consisting of the most likely-to-occur amplitude and at least one other amplitude, the apparatus to perform a coding method as recited in any preceding method claim for a method of encoding as recited in any one of claims 1 to 45.

**48.** An apparatus including a processing system, the apparatus to accept and decode a bitstream in order to form an ordered series of quantized coefficients of a transform of a block of image data transformed by a transform and quantized by quantization, the quantized coefficients each having an amplitude from a finite set of amplitudes consisting of a most likely-to-occur amplitude and at least one other amplitude, the bitstream encoded by a method of encoding as recited in any one of claims 1 to 45, the processing system being arranged to implement a decoding method comprising:

recognizing a codeword;
determining the event represented by the recognized codeword; and
determining the quantized coefficients of each determined event,

until the amplitudes of all quantized coefficients in the series are determined.

**49.** A computer-readable carrier medium carrying computer readable instructions that when executed by one or more processors of a processing system carry out a method of encoding as recited in any one of claims 1 to 45.

**50.** A computer-readable carrier medium carrying computer readable instructions that when executed by one or more processors of a processing system carry out a decoding method, the decoding method to accept and decode a bitstream in order to form an ordered series of quantized coefficients of a transform of a block of image data transformed by a transform and quantized by quantization, the quantized coefficients each having an amplitude from a finite set of amplitudes consisting of the most likely-to-occur amplitude and at least one other amplitude, the bitstream encoded by a method of encoding as recited in any one of claims 1 to 45,
the decoding method comprising:

recognizing a codeword;
determining the event represented by the recognized codeword; and
determining the quantized coefficients of each determined event,

until the amplitudes of all quantized coefficients in the series are determined.

**Patentansprüche**

**1.** Verfahren zur Codierung einer geordneten Serie von quantisierten Koeffizienten eines transformierten Blocks von Bilddaten, die durch Transformation umgewandelt und durch Quantisierung quantisiert wurden, wobei die Serie gemäß einer Reihenfolge geordnet ist, wobei die quantisierten Koeffizienten jeweils eine Amplitude aus einem endlichen Satz von Amplituden aufweisen, die aus der am wahrscheinlichsten auftretenden Amplitude und mindestens einer anderen Amplitude besteht, wobei die Verarbeitung dazu dient, die Datenmenge zu reduzieren, die verwendet wird, um die Serie darzustellen und Codewörter zu bilden, so dass im Durchschnitt Folgendes gilt: je wahrscheinlicher ein quantisierter Koeffizient oder eine Sequenz von quantisierten Koeffizienten ist, desto kürzer ist das Codewort, das zur Darstellung des quantisierten Koeffizienten oder der Sequenz von quantisierten Koeffizienten verwendet wird, wobei das Verfahren Folgendes umfasst:

Festlegen mindestens eines Haltepunkts entlang der Reihenfolge der Serie, um die Serie in einen oder mehrere aufeinanderfolgende Bereiche entsprechend der Amplitudenverteilung der quantisierten Koeffizienten in jedem Bereich aufzuteilen, wobei jeder Bereich ein entsprechendes Codierverfahren aufweist, das die Erkennung von Ereignissen umfasst und Codewörter für die Serie, einschließlich Codewörter für die Ereignisse, bildet, wobei der eine oder die mehreren aufeinanderfolgende Bereiche einen ersten aufeinanderfolgenden Bereich umfassen, so dass Gruppen von aufeinanderfolgenden quantisierten Koeffizienten einer beliebigen Amplitude, die sich von der am wahrscheinlichsten auftretenden Amplitude unterscheidet, in dem ersten aufeinanderfolgenden Bereich wahrscheinlicher auftreten als in jedem anderen Bereich, wobei das entsprechende Codierverfahren ein Erstbereichscodierverfahren für den ersten Bereich umfasst; und
für jeden Bereich der Serie, Anwenden des Codierverfahrens, das dem Bereich entspricht, um einen Satz von Codewörtern der Serie zu bilden, einschließlich der Anwendung des Erstbereichscodierverfahrens,
wobei das Erstbereichscodierverfahren Folgendes umfasst:

das Identifizieren von Ereignissen, darunter:

i) Ereignisse, die jeweils eine Folge von aufeinanderfolgenden Koeffizienten der am wahrscheinlichsten auftretenden Amplitude umfassen, die vor einer Folge von mehreren aufeinanderfolgenden quantisierten Koeffizienten stattfindet, die eine beliebige Amplitude aufweisen, die sich von der am wahrscheinlichsten auftretenden Amplitude unterscheidet,
ii) Ereignisse ohne Koeffizienten der wahrscheinlichsten auftretenden Amplitude, die vor einer Folge eines oder mehrerer aufeinanderfolgender Koeffizienten auftreten, die eine Amplitude aufweisen, die sich von der am wahrscheinlichsten auftretenden Amplitude unterscheidet, und
iii) Ereignisse einer Folge von aufeinanderfolgenden Koeffizienten der am wahrscheinlichsten auftretenden Amplitude, die vor einer Folge eines einzelnen quantisierten Koeffizienten stattfinden, der eine beliegibe Amplitude aufweist, die sich von der am wahrscheinlichsten auftretenden Amplitude unterscheidet;

für jedes identifizierte Ereignis, gemeinsame Codierung der Folgelängen der vorangegangenen Folge der am wahrscheinlichsten auftretenden Amplitude und der nachfolgenden Folge einer Amplitude, die sich von der am wahrscheinlichsten auftretenden Amplitude unterscheidet, mit einem Codewort, das als Positionscodewort bezeichnet wird, so dass mindestens für einige Ereignisse relativ mehr wahrscheinlich auftretende Paare von Folgelängen durch ein kürzeres Positioncodewort codiert werden als relativ weniger wahrscheinlich auftretende Folgelängen; und
für jedes identifizierte Ereignis Codieren dieser Amplituden in der Folge von aufeinanderfolgenden quantisierten Koeffizienten, die eine Amplitude aufweisen, die sich von der am wahrscheinlichsten auftretenden Amplitude unterscheidet, gemäß einem Amplitudencodierverfahren,
und/oder wobei durch das Festlegen des mindestens einen Haltepunkts ein Haltepunkt entlang der Reihenfolge der Serie festgelegt wird, um einen ersten aufeinanderfolgenden Bereich und einen zweiten aufeinanderfolgenden Bereich zu bilden, so dass Gruppen von aufeinanderfolgenden quantisierten Koeffizienten einer beliebigen Amplitude, die sich von der am wahrscheinlichsten auftretenden Amplitude unterscheidet, in dem ersten aufeinanderfolgenden Bereich wahrscheinlicher auftreten als in jedem anderen Bereich, und wobei das Codierverfahren für den zweiten Bereich das Identifizieren von Ereignissen umfasst, die Durchläufe von aufeinanderfolgenden quantisierten Koeffizienten der am wahrscheinlichsten auftretenden Amplitude in dem zweiten Bereich umfassen, die in einem einzigen quantisierten Koeffizienten enden, der eine Amplitude aufweist, die sich von der am wahrscheinlichsten auftretenden Amplitude unterscheidet, und Codieren der identifizierten Ereignisse in dem zweiten Bereich unter Verwendung eines dritten Codierverfahrens, wobei das Codieren das Anzeigen umfasst, dass der endende einzelne quantisierte Koeffizient eine Amplitude aufweist, die sich von der nächsten am wahrscheinlichsten auftretenden Amplitude zur am wahrscheinlichsten auftretenden Amplitude unterscheidet,
so dass im Durchschnitt relativ kurze Codewörter gebildet werden, um Amplituden oder Sequenzen von aufeinanderfolgenden quantisierten Koeffizienten darzustellen, die relativ wahrscheinlicher auftreten, und relativ lange Codewörter gebildet werden, um Amplituden oder Sequenzen von quantisierten Koeffizienten darzustellen, die relativ weniger wahrscheinlich auftreten.

**2.** Verfahren nach Anspruch 1,
wobei das Anwenden der Codierung für den ersten Bereich Folgendes umfasst:

Identifizieren von Ereignissen, die jeweils eine Folge von aufeinanderfolgenden Koeffizienten der am wahrscheinlichsten auftretenden Amplitude umfassen, die vor einer Folge von einem oder mehreren aufeinanderfolgenden quantisierten Koeffizienten stattfindet, die eine beliebige Amplitude aufweisen, die sich von der am wahrscheinlichsten auftretenden Amplitude unterscheidet, einschließlich Ereignisse ohne Koeffizienten der wahrscheinlichsten auftretenden Amplitude, die vor einer Folge eines oder mehrerer aufeinanderfolgender Koeffizienten auftreten, die eine Amplitude aufweisen, die sich von der am wahrscheinlichsten auftretenden Amplitude unterscheidet;
für jedes identifizierte Ereignis, gemeinsame Codierung der Folgelängen der vorangegangenen Folge der am wahrscheinlichsten auftretenden Amplitude und der nachfolgenden Folge einer Amplitude, die sich von der am wahrscheinlichsten auftretenden Amplitude unterscheidet, mit einem Codewort, so dass mindestens für einige Ereignisse relativ mehr wahrscheinlich auftretende Paare von Folgelängen durch ein kürzeres Codewort codiert werden als relativ weniger wahrscheinlich auftretende Folgelängen;
für jedes identifizierte Ereignis Codieren jeder Amplitude in der Folge von aufeinanderfolgenden quantisierten Koeffizienten, die eine Amplitude aufweisen, die sich von der am wahrscheinlichsten auftretenden Amplitude unterscheidet, wobei das Codieren gemäß einem Amplitudencodierverfahren erfolgt,
so dass im Durchschnitt relativ kurze Codewörter gebildet werden, um Amplituden oder Sequenzen von quantisierten Koeffizienten darzustellen, die relativ wahrscheinlicher auftreten, und relativ lange Codewörter gebildet werden, um Amplituden oder Sequenzen von quantisierten Koeffizienten darzustellen, die relativ weniger wahrscheinlich auftreten.

**3.** Verfahren nach einem der vorhergehenden Ansprüche, wobei durch das Festlegen des mindestens einen Haltepunkts ein Haltepunkt entlang der Reihenfolge der Serie festgelegt wird, um einen ersten aufeinanderfolgenden Bereich und mindestens einen zweiten aufeinanderfolgenden Bereich zu bilden, so dass Gruppen von aufeinanderfolgenden quantisierten Koeffizienten einer beliebigen Amplitude, die sich von der am wahrscheinlichsten auftretenden Amplitude unterscheidet, in dem ersten aufeinanderfolgenden Bereich wahrscheinlicher auftreten als in jedem anderen Bereich, und wobei das Anwenden des Codierverfahrens, das den Bereichen entspricht, die Verwendung von drei Codierverfahren umfasst, um die quantisierten Koeffizienten in mindestens zwei Bereichen zu codieren.

**4.** Verfahren nach einem der vorhergehenden Ansprüche,
wobei durch das Festlegen des mindestens einen Haltepunkts ein Haltepunkt entlang der Reihenfolge der Serie festgelegt wird, um einen ersten aufeinanderfolgenden Bereich und einen zweiten aufeinanderfolgenden Bereich zu bilden, so dass Gruppen von aufeinanderfolgenden quantisierten Koeffizienten einer beliebigen Amplitude, die sich von der am wahrscheinlichsten auftretenden Amplitude unterscheidet, in dem ersten aufeinanderfolgenden Bereich am wahrscheinlichsten auftreten,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei das Codierverfahren für den zweiten Bereich ein zweidimensionales Codierverfahren variabler Länge umfasst, das Ereignisse codiert, die aus einer Folge von aufeinanderfolgenden nullwertigen Koeffizienten gefolgt von einem einzelnen nicht-nullwertigen Koeffizienten besteht.

**5.** Verfahren nach einem der Ansprüche 1 bis 3,
wobei das Codieren der Ereignisse, die Durchläufe von aufeinanderfolgenden quantisierten Koeffizienten der am wahrscheinlichsten auftretenden Amplitude in dem zweiten Bereich umfassen, die in einem einzigen quantisierten Koeffizienten enden, der eine Amplitude aufweist, die sich von der am wahrscheinlichsten auftretenden Amplitude unterscheidet, das Anzeigen umfasst, dass der endende einzelne quantisierte Koeffizient eine Amplitude aufweist, die sich von der nächsten am wahrscheinlichsten auftretenden Amplitude zur am wahrscheinlichsten auftretenden Amplitude unterscheidet, und
wobei durch das Codieren der Ereignisse in dem zweiten Bereich durchschnittlich Folgendes gebildet wird: relativ kurze Codewörter, um Sequenzen von quantisierten Koeffizienten darzustellen, die relativ wahrscheinlicher auftreten, und relativ lange Codewörter, um Sequenzen von quantisierten Koeffizienten darzustellen, die relativ weniger wahrscheinlich auftreten.

**6.** Verfahren nach Anspruch 5,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei das Codieren der Ereignisse in dem zweiten Bereich das Codierung von Folgelängen von aufeinanderfolgenden nullwertigen Koeffizienten, die in einem Amplitude-1-Koeffizienten enden, unter Verwendung eines Folgelängencodierverfahrens variabler Länge umfasst,
wobei das Verfahren ferner Folgendes umfasst:

Identifizieren von Ereignissen, die Durchläufe von aufeinanderfolgenden Amplitude-Null-Koeffizienten in dem zweiten Bereich umfassen, die in einem einzigen Koeffizienten enden, der eine Amplitude von mehr als 1 aufweist;
ferner Verwenden eines Ausnahmecodes, um die identifizierenden Ereignisse zu codieren, die in einem Koeffizienten enden, der eine Amplitude von mehr als 1 aufweist;
Codieren der Vorzeichen der nicht-nullwertigen Koeffizienten;
Codieren der Amplituden der nicht-nullwertigen Koeffizienten in dem ersten Bereich; und
Codieren der Amplituden, die in dem zweiten Bereich größer als 1 sind.

**7.** Verfahren nach Anspruch 6,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei Codewörter darüber hinaus für die Amplituden und Vorzeichen jedes der nicht-nullwertigen Koeffizienten einer Amplitude erzeugt werden, die in dem zweiten Bereich größer als 1 ist.

**8.** Verfahren nach einem der vorhergehenden Ansprüche, wobei für die Codierverfahren Codiertabellen verwendet werden.

**9.** Verfahren nach einem der Ansprüche 6 und 7,
wobei eine Folgelängencodiertabelle des zweiten Bereichs und eine Amplitudencodiertabelle des zweiten Bereichs für Codierinformationen in dem zweiten Bereich bereitgestellt sind,
wobei die Folgelängencodiertabelle des zweiten Bereichs zum Speichern einer Vielzahl von Codewörtern für einen Satz von Folgelängen von nullwertigen Koeffizienten dient, die in einem Amplitude-1-Koeffizienten enden und in dem zweiten Bereich auftreten, wobei die Tabelle des zweiten Bereichs so organisiert ist, dass die wahrscheinlicher auftretenden Folgelängen kürzere Codewörter als die weniger wahrscheinlich auftretenden Folgelängen aufweisen,
wobei die Amplitudencodetabelle des zweiten Bereichs zum Speichern einer Vielzahl von Codewörtern für die Amplituden von mehr als 1 von Nicht-Null-Koeffizienten dient, die in dem zweiten Bereich auftreten, und
wobei der Schritt des Bildens eines Codeworts für jede Folgelänge von nullwertigen Koeffizienten, die in einem nicht-nullwertigen Koeffizienten in dem zweiten Bereich endet, das Nachschlagen der Folgelängencodetabelle des zweiten Bereichs umfasst.

**10.** Verfahren nach Anspruch 2,
wobei für das Codierverfahren des ersten Bereichs:

das Erkennen von Ereignissen das Erkennen von Ereignissen umfasst, die jeweils eine Folge von aufeinanderfolgenden quantisierten Koeffizienten von Amplituden umfassen, die sich von der am wahrscheinlichsten auftretenden Amplitude unterscheiden;
das Bilden von Codewörtern für die erkannten Ereignisse in dem ersten Bereich für jedes Ereignis, das eine Vielzahl von aufeinanderfolgenden quantisierten Koeffizienten umfasst, die gemeinsame Codierung einer Vielzahl von aufeinanderfolgenden Amplituden in der Folge von aufeinanderfolgenden quantisierten Koeffizienten umfasst, die eine Amplitude aufweisen, die sich von der am wahrscheinlichsten auftretenden Amplitude unterscheidet, wobei das gemeinsame Codieren gemäß einem Amplitudencodierverfahren erfolgt.

**11.** Verfahren nach Anspruch 10, wobei die gemeinsame Codierung eine Vielzahl von Amplituden gemeinsam codiert und die Vorzeichen der Koeffizienten, deren Amplituden gemeinsam codiert sind, getrennt codiert.

**12.** Verfahren nach Anspruch 10, wobei die gemeinsame Codierung eine Vielzahl von Amplituden gemeinsam codiert, die die Vorzeichen der Koeffizienten umfassen, deren Amplitude gemeinsam codiert wird, so dass keine separate Vorzeichencodierung für die Koeffizienten verwendet wird, deren Amplituden gemeinsam codiert werden.

**13.** Verfahren nach Anspruch 10,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei die identifizierenden Ereignisse identifizierende Ereignisse umfassen, die jeweils eine Folge von aufeinanderfolgenden nullwertigen Koeffizienten umfassen, die vor einer Folge von einem oder mehreren aufeinanderfolgenden nicht-nullwertigen Koeffizienten auftreten, die Ereignisse von nicht nullwertigen Koeffizienten umfassen, die vor einer Folge von einem oder mehreren aufeinanderfolgenden nicht-nullwertigen Koeffizienten auftreten; und
wobei die gemeinsame Codierung die gemeinsame Codierung der Folgelängen der vorangehenden Folge von nullwertigen Koeffizienten und der nachfolgenden Folge von nicht-nullwertigen Koeffizienten umfasst, so dass mindestens für einige Ereignisse relativ mehr wahrscheinlich auftretende Paare von Folgelängen durch ein kürzeres Codewort codiert werden als relativ weniger wahrscheinlich auftretende Folgelängen.

**14.** Verfahren nach Anspruch 13, das ferner Folgendes umfasst:

Bereitstellen eines Haltepunkts, um den ersten aufeinanderfolgenden Bereich entlang der Reihenfolge der Serie gefolgt von einem zweiten kontinuierlichen Bereich zu definieren; so dass die Koeffizienten des ersten Bereichs durch ein erstes Codierverfahren codiert werden, das Folgendes umfasst: das Identifizieren von Ereignissen, die gemeinsame Codierung der Folgelängen der Ereignisse und die Codierung der Amplituden von nicht-nullwertigen Koeffizienten der Ereignisse; und

Codierung der Koeffizienten in dem zweiten Bereich mit Hilfe eines Codierverfahrens des zweiten Bereichs und wobei ein Codierverfahren des ersten Bereichs und das Codierverfahren des zweiten Bereichs derart beschaffen sind, dass sich die Codierung von mindestens einigen der Koeffizienten oder Folgen von Koeffizienten in dem ersten Bereich von der Codierung von mindestens einigen der Koeffizienten oder Folgen von Koeffizienten in dem zweiten Bereich unterscheidet.

**15.** Verfahren nach Anspruch 13, wobei die gemeinsame Codierung der Folgelängen bei einem Ereignis eine multidimensionale Codiertabelle verwendet.

**16.** Verfahren nach Anspruch 13, wobei die Anzahl der Ereignisse, die identifiziert und deren Folgelängen gemeinsam codiert werden, begrenzt ist, so dass nur Ereignisse bis zu einer maximalen Gesamtanzahl von Koeffizienten identifiziert werden und wobei durch die Identifizierung darüber hinaus Ereignisse von allen Nullen der maximalen Länge und Ereignisse mit maximaler Länge, die in einem Nicht-Null-Koeffizienten enden, identifiziert werden, so dass Escape-Codes bei der Codierung der Koeffizienten des ersten Bereichs vermieden werden können.

**17.** Verfahren nach Anspruch 10,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei die identifizierenden Ereignisse Folgendes umfassen: Identifizieren der Folgelängen von Folgen nullwertiger Koeffizienten, die vor einem oder mehreren aufeinanderfolgenden nicht-nullwertigen Koeffizienten auftreten, und Identifizieren der Folgelängen des einen oder der mehreren nicht-nullwertigen Koeffizienten, die nach den Folgelängefolgen von nullwertigen Koeffizienten auftreten; und
wobei die gemeinsame Codierung der Folgelängen Folgendes umfasst: Codieren der Folgelängen der Folgen von nicht-nullwertigen Koeffizienten unter Verwendung eines ersten Folgelängenkodierungsverfahrens und Codieren der Folgelängen von identifizierten Folgen von nullwertigen Koeffizienten unter Verwendung eines zweiten Folgelängenkodierungsverfahrens,
so dass mindestens für einige Ereignisse relativ mehr wahrscheinlich auftretende Paare von Folgelängen durch ein kürzeres Codewort codiert werden als relativ weniger wahrscheinlich auftretende Folgelängen.

**18.** Verfahren nach einem der vorhergehenden Ansprüche,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei der Haltepunktwert vorgewählt ist.

**19.** Verfahren nach einem der vorhergehenden Ansprüche,
wobei die Serie von einem Zwischenrahmenblock von Bilddaten gebildet wird und wobei ein erster vorgewählter Haltepunktwert für Zwischenrahmenbilddaten einer ersten Art verwendet wird und ein zweiter vorgewählter Haltepunktwert für Zwischenrahmenbilddaten einer zweiten Art verwendet wird.

**20.** Verfahren nach Anspruch 19, wobei die erste Art von Zwischenrahmencodierung eine höhere Bitrate aufweist als die zweite Art von Zwischenrahmencodierung.

**21.** Verfahren nach einem der vorhergehenden Ansprüche,
wobei der Haltepunktwert aus einem endlichen Satz von vordefinierten Haltepunktwerten gemäß einem bildabhängigen Kriterium ausgewählt wird.

**22.** Verfahren nach Anspruch 21, wobei der Haltepunktwert aus einer endlichen Menge von vordefinierten Haltepunktwerten danach ausgewählt wird, welcher der Haltepunkte des Satzes die geringste Anzahl von Bits erzeugt.

**23.** Verfahren nach einem der vorhergehenden Ansprüche,
wobei der transformierte Bilddatenblock nach der Quantisierung einen DC-Term umfasst und wobei der DC-Term getrennt codiert wird, so dass die geordnete Serie von quantisierten Koeffizienten ist eine Serie von Nicht-DCquantisierten Koeffizienten ist.

**24.** Verfahren nach einem der vorhergehenden Ansprüche,
wobei der Haltepunkt eine harte Grenzfläche zwischen dem ersten und zweiten Bereich definiert.

**25.** Verfahren nach einem der Ansprüche 1 bis 23,

wobei der Haltepunkt eine weiche Grenzfläche zwischen dem ersten und zweiten Bereich definiert, so dass sich die Grenze für ein Ereignis, das vor dem Haltepunkt beginnt und den Haltepunkt kreuzt, zwischen dem ersten und zweiten Bereich am Ende des Ereignisses befindet, so dass sich das gesamte Ereignis in dem ersten Bereich befindet.

**26.** Verfahren nach einem der vorhergehenden Ansprüche, das ferner Folgendes umfasst:

Klassifizieren der Serie in eine bestimmte Klasse einer Vielzahl von Klassen entsprechend der Amplitudenverteilung der quantisierten Koeffizienten, wobei jede Klasse ein entsprechendes Codierverfahren der Bildung der Codewörter für die Serie aufweist;
für die jeweilige Klasse der Serie, Anwenden des Codierverfahrens, das der Klasse entspricht, um einen Satz von Codewörtern der Serie zu bilden,
Hinzufügen einer Anzeige zu den gebildeten Codewörtern, um die jeweilige Klasse anzuzeigen, so dass im Durchschnitt Folgendes gebildet wird: relativ kurze Codewörter, um quantisierte Koeffizienten oder Sequenzen von quantisierten Koeffizienten darzustellen, die relativ wahrscheinlicher auftreten, und relativ lange Codewörter, um quantisierte Koeffizienten oder Sequenzen von quantisierten Koeffizienten darzustellen, die relativ weniger wahrscheinlich auftreten.

**27.** Verfahren nach Anspruch 26,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei es für jede Art von Bild zwei Klassen gibt.

**28.** Verfahren nach Anspruch 26,
wobei es für jede Art von Bild mindestens vier Klassen gibt.

**29.** Verfahren nach Anspruch 28,
wobei die Transformation und Quantisierung derart beschaffen sind, dass die am wahrscheinlichsten auftretende Amplitude 0 ist und die nächste am wahrscheinlichsten auftretende Amplitude 1 ist,
und wobei die Klassen Folgendes umfassen:

eine erste Klasse von Serien, wobei nicht-nullwertige Koeffizienten entlang der Reihenfolge der Koeffizienten aus Nicht-Null-Amplituden bestehen, die eine bedeutende Zahl umfassen, die nicht $\pm$ 1 ist, und wobei die nicht-nullwertigen Koeffizienten in der Reihenfolge gruppiert werden, so dass kein klarer Haltepunkt auf dem Weg der Reihenfolge der Koeffizienten vorliegt, um Folgendes zu identifizieren: einen ersten Bereich, in dem nicht-nullwertige Koeffizienten gruppiert sind, und einen zweiten Bereich, in dem die nicht-nullwertigen Koeffizienten gestreut sind;
eine zweite Klasse von Serien, wobei eine bedeutende Zahl von nicht-nullwertigen Koeffizienten entlang der Reihenfolge der Koeffizienten aus nicht-nullwertigen Amplituden bestehen, die eine bedeutende Zahl umfassen, die nicht $\pm$ 1 ist, und wobei ein Haltepunkt auf dem Weg der Reihenfolge der Koeffizienten vorliegt, um Folgendes zu identifizieren: einen ersten Bereich, in dem die nicht-nullwertigen Koeffizienten im Wesentlichen gruppiert sind, und einen zweiten Bereich, in dem die nicht-nullwertigen Koeffizienten gestreut sind;
eine dritte Klasse von Serien, wobei alle nicht-nullwertigen Koeffizienten entlang der Reihenfolge der Koeffizienten im Wesentlichen von Koeffizienten beherrscht werden, die $\pm$ 1 sind, und wobei ein Haltepunkt auf dem Weg der Reihenfolge der Koeffizienten vorliegt, um Folgendes zu identifizieren: einen ersten Bereich, in dem diese nicht-nullwertige Koeffizienten im Wesentlichen gruppiert sind, und einen zweiten Bereich, in dem diese nicht-nullwertigen Koeffizienten gestreut sind;
eine vierte Klasse von Serien, wobei alle nicht-nullwertigen Koeffizienten entlang der Reihenfolge der Koeffizienten im Wesentlichen von Koeffizienten beherrscht werden, die $\pm$ 1 sind, und wobei die nicht-nullwertigen Koeffizienten in der Reihenfolge gestreut sind, so dass kein klarer Haltepunkt auf dem Weg der Reihenfolge der Koeffizienten vorliegt, um Folgendes zu identifizieren: einen ersten Bereich, in dem nicht-nullwertige Koeffizienten gruppiert sind, und einen zweiten Bereich, in dem diese nicht-nullwertigen Koeffizienten gestreut sind.

**30.** Verfahren nach einem der Ansprüche 26 bis 29, wobei die Vielzahl der Klassen von dem Inhalt von mindestens einer der Gruppen abhängt:

ob der Bildblock ein Zwischenrahmenstillbildblock oder ein Zwischenrahmenbildblock ist;
ob der Bildblock ein Standarddefinitionsfernsehe-Bildblock oder HDTV-Bildblock ist;

ob das Verfahren für eine Codierung mit hoher Bitrate oder eine Codierung mit relativ niedriger Bitrate dient; und ob die Transformation eine DCT- oder eine Nicht-DCT-Transformation ist.

**31.** Verfahren nach Anspruch 26,
wobei für die Klassifizierung die Serie von Koeffizienten verwendet wird.

**32.** Verfahren nach Anspruch 31,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei die Klassifizierung das Bestimmen der Statistik der Koeffizienten gemäß dem Inhalt von mindestens einer der Gruppen der statistischen Kriterien umfasst:

ob ein Haltepunkt vorliegt, der Folgendes definiert: einen ersten Bereich, in dem die Nicht-Null-Koeffizienten gruppiert sind, und einen zweiten Bereich, in dem die nicht-nullwertigen Koeffizienten meist gestreut sind;
ob die nicht-nullwertigen Koeffizienten meist gruppiert oder meist gestreut sind; und
ob die nicht-nullwertigen Koeffizienten in einem Bereich oder in dem gesamten Block fast alle die Amplitude 1 aufweisen.

**33.** Verfahren nach Anspruch 31, wobei durch die Klassifizierung die Klasse danach ausgewählt wird, welches entsprechende Verfahren den komprimiertesten Bitstrom erzeugt.

**34.** Verfahren nach Anspruch 33, wobei die Klassifizierung Folgendes umfasst: sequentielles Anwenden der einzelnen entsprechenden Codierverfahren und Auswählen der jeweiligen Klasse gemäß der Kompression, die durch das Codierverfahren erzeugt wird, das der jeweiligen Klasse entspricht.

**35.** Verfahren nach Anspruch 33, wobei die Klassifizierung Folgendes umfasst: paralleles Anwenden der einzelnen entsprechenden Codierverfahren und Auswählen der jeweiligen Klasse gemäß der Kompression, die durch das Codierverfahren erzeugt wird, das der jeweiligen Klasse entspricht.

**36.** Verfahren nach einem der vorhergehenden Ansprüche,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei das Verfahren ferner folgenden Schritt umfasst:

Bilden von Codewörtern fester Länge für mindestens einige der erkannten Ereignisse.

**37.** Verfahren nach Anspruch 36, wobei das Codierverfahren des ersten Bereichs das Bilden von Codewörtern fester Länge für mindestens einige der erkannten Ereignisse in dem ersten Bereich umfasst.

**38.** Verfahren nach Anspruch 36, wobei das Codierverfahren des zweiten Bereichs das Bilden von Codewörtern fester Länge für mindestens einige der erkannten Ereignisse in dem zweiten Bereich umfasst.

**39.** Verfahren nach Anspruch 36, wobei die erkannten Ereignisse, für die die festen Codewörter gebildet werden, weniger wahrscheinlich auftreten als die erkannten Ereignisse, für die ein Codewort variabler Länge verwendet wird, und wobei die Codewörter fester Länge mindestens so lang sind wie alle Codewörter variabler Länge.

**40.** Verfahren nach Anspruch 36, wobei jedes Codewort fester Länge einen Escape-Code umfasst.

**41.** Verfahren nach einem der vorhergehenden Ansprüche,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei das Verfahren ferner Folgendes umfasst:

Bilden einer Anzeige, die anzeigt, dass alle verbleibenden quantisierten Koeffizienten in dem zweiten Bereich der Serie die am wahrscheinlichsten auftretende Amplitude aufweisen.

**42.** Verfahren nach einem der vorhergehenden Ansprüche, wobei die Transformation und Quantisierung derart beschaffen sind, dass die am wahrscheinlichsten auftretende Amplitude 0 ist und die nächste am wahrscheinlichsten auftretende Amplitude 1 ist, und
wobei die Serie durch den Haltepunkt und einem zusätzlichen Haltepunkt für jeden Bereich zusätzlich zu einem zweiten Bereich in mehr als zwei Bereiche unterteilt ist, wobei das Verfahren ferner Folgendes umfasst:

Codierung der quantisierten Koeffizienten, die in den einzelnen zusätzlichen Bereichen auftreten, die durch den entsprechenden zusätzlichen Haltepunkt definiert sind, wobei für die Codierung ein Codierungsverfahren verwendet wird, das sich von den Codierverfahrenn, die in anderen Bereichen verwendet werden, unterscheidet.

**43.** Verfahren nach einem der vorhergehenden Ansprüche,
wobei die Transformation und Quantisierung derart beschaffen sind, dass die am wahrscheinlichsten auftretende Amplitude 0 ist und die nächste am wahrscheinlichsten auftretende Amplitude 1 ist.

**44.** Verfahren nach einem der vorhergehenden Ansprüche,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei das Bilden von Codewörtern für jede Folgelänge basierend auf angenommenen mutmaßlichen Wahrscheinlichkeiten des Auftretens der Ereignisse festgelegt ist.

**45.** Verfahren nach einem der vorhergehenden Ansprüche,
wobei die Transformation und Quantisierung derart beschaffen sind, dass die am wahrscheinlichsten auftretende Amplitude 0 ist und die nächste am wahrscheinlichsten auftretende Amplitude 1 ist, und
wobei das Bilden von Codewörtern für jedes Ereignis entsprechend den tatsächlichen statistischen Daten veränderbar ist, die aus geordneten Serien von quantisierten Koeffizienten gesammelt wurden.

**46.** Verfahren zum Decodieren eines Bitstroms, um eine Serie von quantisierten Koeffizienten einer Transformation eines Blocks von Bilddaten zu bilden, die durch Transformation umgewandelt und durch Quantisierung quantisiert wurden, wobei die quantisierten Koeffizienten jeweils eine Amplitude aufweisen, die eine am wahrscheinlichsten auftretende Amplitude und mindestens eine nächste am wahrscheinlichsten auftretenden Amplitude aufweisen, wobei das Decodierverfahren Folgendes umfasst:

Erkennen eines Codeworts;
Bestimmung des Ereignisses, das von dem erkannten Codewort dargestellt wird; und
Bestimmen der Koeffizienten jedes bestimmten Ereignisses,
bis alle Koeffizienten in der Serie bestimmt sind,
wobei die Codewörter in dem Bitstrom unter Verwendung eines Codierverfahrens nach einem der Ansprüche 1 bis 45 bestimmt werden.

**47.** Vorrichtung, die ein Verarbeitungssystem umfasst, wobei die Vorrichtung eine geordnete Serie von quantisierten Koeffizienten akzeptiert, die jeweils eine Amplitude aus einem endlichen Satz von Amplituden aufweisen, die aus der am wahrscheinlichsten auftretenden Amplitude und mindestens einer anderen Amplitude besteht, wobei die Vorrichtung ein Codierverfahren nach einem der vorhergehenden Verfahrensansprüche für ein Codierverfahren nach einem der Ansprüche 1 bis 45 ausführt.

**48.** Vorrichtung, die ein Verarbeitungssystem umfasst, wobei die Vorrichtung einen Bitstrom akzeptiert und decodiert, um eine geordnete Serie von quantisierten Koeffizienten einer Transformation eines Blocks von Bilddaten zu bilden, die durch Transformation umgewandelt und durch Quantisierung quantisiert wurden, wobei die quantisierten Koeffizienten jeweils eine Amplitude aus einem endlichen Satz von Amplituden aufweisen, die aus einer am wahrscheinlichsten auftretenden Amplitude und mindestens einer anderen Amplitude besteht, wobei der Bitstrom durch ein Codierverfahren nach einem der Ansprüche 1 bis 45 codiert wird, wobei das Verarbeitungssystem dafür ausgelegt ist, ein Decodierverfahren durchzuführen, das Folgendes umfasst:

Erkennen eines Codeworts;
Bestimmung des Ereignisses, das von dem erkannten Codewort dargestellt wird; und
Bestimmen der quantisierten Koeffizienten jedes bestimmten Ereignisses,
bis die Amplituden aller quantisierten Koeffizienten in der Serie bestimmt sind.

**49.** Computerlesbares Trägermedium, auf dem computerlesbare Anweisungen gespeichert sind, die, wenn sie durch einen oder mehrere Prozessoren eines Verarbeitungssystem ausgeführt werden, ein Codierverfahren nach einem der Ansprüche 1 bis 45 durchführen.

**50.** Computerlesbares Trägermedium, auf dem computerlesbare Anweisungen gespeichert sind, die, wenn sie durch einen oder mehrere Prozessoren eines Verarbeitungssystem ausgeführt werden, ein Decodierverfahren durchführen, wobei das Decodierverfahren einen Bitstrom akzeptiert und decodiert, um eine geordnete Serie von quantisierten Koeffizienten einer Transformation eines Blocks von Bilddaten zu bilden, die durch Transformation umgewandelt und durch Quantisierung quantisiert wurden, wobei die quantisierten Koeffizienten jeweils eine Amplitude aus einem endlichen Satz von Amplituden aufweisen, die aus der am wahrscheinlichsten auftretenden Amplitude und mindestens einer anderen Amplitude besteht, wobei der Bitstrom durch ein Codierverfahren nach einem der Ansprüche 1 bis 45 codiert wird,
wobei das Decodierverfahren Folgendes umfasst:

Erkennen eines Codeworts;
Bestimmung des Ereignisses, das von dem erkannten Codewort dargestellt wird; und
Bestimmen der quantisierten Koeffizienten jedes bestimmten Ereignisses,
bis die Amplituden aller quantisierten Koeffizienten in der Serie bestimmt sind.

## Revendications

**1.** Procédé de codage d'une série ordonnée de coefficients quantifiés d'un bloc transformé de données d'image transformé par une transformée et quantifié par quantification, la série étant ordonnée selon une mise en ordre, les coefficients quantifiés ayant chacun une amplitude parmi un ensemble fini d'amplitudes consistant en l'amplitude la plus susceptible de se produire et au moins une autre amplitude, le traitement servant à réduire la quantité de données utilisées pour représenter la série et à former des mots de code de telle sorte que, en moyenne, plus un coefficient quantifié ou une séquence de coefficients quantifiés est susceptible de se produire, plus le mot de code utilisé pour représenter le coefficient quantifié ou la séquence de coefficients quantifiés soit court, le procédé comprenant :

l'établissement d'au moins un point de rupture dans la mise en ordre de la série pour rompre la série en une ou plusieurs régions contiguës en fonction de la distribution des amplitudes des coefficients quantifiés dans chaque région, chaque région ayant un processus de codage correspondant qui comporte la reconnaissance d'événements et la formation de mots de code pour la série, dont des mots de code pour les événements, les une ou plusieurs régions contiguës comportant une première région contiguë de telle sorte que des groupes de coefficients quantifiés consécutifs de n'importe quelle amplitude autre que l'amplitude la plus susceptible de se produire soient plus susceptibles de se produire dans la première région contiguë que dans n'importe quelle autre région, les processus de codage correspondants comportant un procédé de codage de première région, et
pour chaque région de la série, l'application du processus de codage correspondant à la région pour former un ensemble de mots de code de la série, dont l'application du procédé de codage de première région,
dans lequel le procédé de codage de première région comporte :

l'identification d'événements, notamment :

i) des événements qui comportent chacun une plage de coefficients consécutifs de l'amplitude la plus susceptible de se produire, précédant une plage de plusieurs coefficients quantifiés consécutifs ayant n'importe quelle amplitude autre que l'amplitude la plus susceptible de se produire,
ii) des événements d'aucun coefficient de l'amplitude la plus susceptible de se produire précédant une plage d'un ou plusieurs coefficients consécutifs ayant une amplitude autre que l'amplitude la plus susceptible de se produire, et
iii) des événements d'une plage de coefficients consécutifs de l'amplitude la plus susceptible de se produire, précédant une plage d'un seul coefficient quantifié ayant n'importe quelle amplitude autre que l'amplitude la plus susceptible de se produire ;

pour chaque événement identifié, le codage conjoint des longueurs de plage de la plage précédente de l'amplitude la plus susceptible de se produire et de la plage suivante d'une amplitude autre que l'amplitude la plus susceptible de se produire avec un mot de code appelé mot de code de position, de telle sorte que pour au moins certains événements, des paires de longueurs de plage davantage susceptibles de se produire soient codées par un mot de code de position plus court que celui des longueurs de plage relativement moins susceptibles de se produire ; et

pour chaque événement identifié, le codage des amplitudes dans la plage de coefficients quantifiés consécutifs ayant une amplitude autre que l'amplitude la plus susceptible de se produire selon un procédé de codage d'amplitude,

et/ou dans lequel l'établissement de l'au moins un point de rupture établit un point de rupture dans la mise en ordre de la série pour définir une première région contiguë et une seconde région contiguë, de telle sorte que des groupes de coefficients quantifiés consécutifs de n'importe quelle amplitude autre que l'amplitude la plus susceptible de se produire soient plus susceptibles de se produire dans la première région contiguë que dans n'importe quelle autre région, et le processus de codage de la seconde région comporte l'identification d'événements qui comporte des plages de coefficients quantifiés consécutifs de l'amplitude la plus susceptible de se produire dans la seconde région qui se terminent par un seul coefficient quantifié ayant une amplitude autre que l'amplitude la plus susceptible de se produire, et le codage desdits événements identifiés dans la seconde région en utilisant un troisième procédé de codage, le codage comportant l'indication que le seul coefficient quantifié de fin a une amplitude autre que l'amplitude la plus susceptible de se produire suivante après l'amplitude la plus susceptible de se produire,

de telle sorte que, en moyenne, des mots de code relativement courts soient formés pour représenter des amplitudes ou séquences de coefficients quantifiés consécutifs qui sont relativement plus susceptibles de se produire, et des mots de code relativement longs soient formés pour représenter des amplitudes ou séquences de coefficients quantifiés qui sont relativement moins susceptibles de se produire.

**2.** Procédé selon la revendication 1,
dans lequel l'application du codage pour la première région comporte :

l'identification d'événements qui comportent chacun une plage de coefficients consécutifs de l'amplitude la plus susceptible de se produire, précédant une plage d'un ou plusieurs coefficients quantifiés consécutifs ayant n'importe quelle amplitude autre que l'amplitude la plus susceptible de se produire, notamment des événements d'aucun coefficient de l'amplitude la plus susceptible de se produire précédant une plage d'un ou plusieurs coefficients consécutifs ayant une amplitude autre que l'amplitude la plus susceptible de se produire,

pour chaque événement identifié, le codage conjoint des longueurs de plage de la plage précédente de l'amplitude la plus susceptible de se produire et de la plage suivante d'une amplitude autre que l'amplitude la plus susceptible de se produire avec un mot de code, de telle sorte que pour au moins certains événements, des paires de longueurs de plage relativement plus susceptibles de se produire soient codées par un mot de code plus court que celui des longueurs de plage relativement moins susceptibles de se produire ;

pour chaque événement identifié, le codage de chaque amplitude dans la plage de coefficients quantifiés consécutifs ayant une amplitude autre que l'amplitude la plus susceptible de se produire, le codage étant effectué selon un procédé de codage d'amplitude,

de telle sorte que, en moyenne, des mots de code relativement courts soient formés pour représenter des amplitudes ou séquences de coefficients quantifiés qui sont relativement plus susceptibles de se produire, et des mots de code relativement longs soient formés pour représenter des amplitudes ou séquences de coefficients quantifiés qui sont relativement moins susceptibles de se produire.

**3.** Procédé selon l'une quelconque des revendications précédentes, dans lequel l'établissement de l'au moins un point de rupture établit un point de rupture dans la mise en ordre de la série pour définir une première région contiguë et au moins une deuxième région contiguë, de telle sorte que des groupes de coefficients quantifiés consécutifs de n'importe quelle amplitude autre que l'amplitude la plus susceptible de se produire soient plus susceptibles de se produire dans la première région contiguë que dans n'importe quelle autre région, et dans lequel l'application des processus de codage correspondant aux régions comprend l'utilisation de trois procédés de codage pour coder les coefficients quantifiés dans au moins deux régions.

**4.** Procédé selon l'une quelconque des revendications précédentes,
dans lequel l'établissement de l'au moins un point de rupture établit un point de rupture dans la mise en ordre de la série pour définir une première région contiguë et une seconde région contiguë, de telle sorte que des groupes de coefficients quantifiés consécutifs de n'importe quelle amplitude autre que l'amplitude la plus susceptible de se produire soient plus susceptibles de se produire dans la première région contiguë,
dans lequel la transformée et la quantification sont telles que l'amplitude la plus susceptible de se produire est 0, et l'amplitude la plus susceptible de se produire suivante est 1, et
dans lequel le procédé de codage pour la seconde région comporte un procédé de codage à longueur variable bidimensionnel qui code les événements consistant en une plage de coefficients consécutifs de valeur nulle suivie d'un seul coefficient de valeur non nulle.

**5.** Procédé selon l'une quelconque des revendications 1 à 3,
dans lequel le codage des événements qui comportent des plages de coefficients quantifiés consécutifs de l'amplitude la plus susceptible de se produire dans la seconde région qui se terminent par un seul coefficient quantifié ayant une amplitude autre que l'amplitude la plus susceptible de se produire comporte l'indication que le seul coefficient quantifié de fin a une amplitude autre que l'amplitude la plus susceptible de se produire suivant l'amplitude la plus susceptible de se produire, et
dans lequel le codage des événements dans la seconde région forme en moyenne des mots de code relativement courts pour représenter des séquences de coefficients quantifiés qui sont relativement plus susceptibles de se produire, et des mots de code relativement longs pour représenter des séquences de coefficients quantifiés qui sont relativement moins susceptibles de se produire.

**6.** Procédé selon la revendication 5,
dans lequel la transformée et la quantification sont telles que l'amplitude la plus susceptible de se produire est 0, et l'amplitude la plus susceptible de se produire suivante est 1, et
dans lequel le codage d'événements dans la seconde région comporte le codage de longueurs de plage de coefficients consécutifs de valeur nulle qui se terminent par un coefficient d'amplitude 1 en utilisant un procédé de codage de plage à longueur variable,
le procédé comprenant en outre :

l'identification d'événements qui comportent des plages de coefficients consécutifs d'amplitude zéro dans la seconde région qui se terminent par un seul coefficient d'une amplitude supérieure à 1 ;
l'utilisation en outre d'un code d'exception pour coder les événements d'identification qui se terminent par un coefficient d'une amplitude supérieure à 1 ;
le codage des signes des coefficients de valeur non nulle ;
le codage des amplitudes des coefficients de valeur non nulle dans la première région ; et
le codage des amplitudes supérieures à 1 dans la seconde région.

**7.** Procédé selon la revendication 6,
dans lequel la transformée et la quantification sont telles que l'amplitude la plus susceptible de se produire est 0, et l'amplitude la plus susceptible de se produire suivante est 1, et
dans lequel des mots de code sont également générés pour les amplitudes et signes de chacun des coefficients de valeur non nulle d'une amplitude supérieure à 1 dans la seconde région.

**8.** Procédé selon l'une quelconque des revendications précédentes,
dans lequel les processus de codage utilisent des tables de codage.

**9.** Procédé selon l'une quelconque des revendications 6 et 7,
dans lequel une table de codes de plage de seconde région et une table de codes d'amplitude de seconde région sont fournies pour coder les informations dans la seconde région,
dans lequel la table de codes de plage de seconde région sert à stocker une pluralité de mots de code pour un ensemble de longueurs de plage de coefficients de valeur nulle qui se terminent par un coefficient d'amplitude un et qui se produisent dans la seconde région, la seconde région étant organisée de telle sorte que les longueurs de plage les plus susceptibles de se produire aient des mots de code plus courts que ceux des longueurs de plage moins susceptibles de se produire,
dans lequel la table de codes d'amplitude de seconde région sert à stocker une pluralité de mots de code pour les amplitudes supérieures à 1 des coefficients non nuls qui se produisent dans la seconde région, et
dans lequel l'étape de formation d'un mot de code pour chaque plage de coefficients de valeur nulle qui se termine par un coefficient de valeur non nulle dans la seconde région comporte la consultation de la table de codes de longueur de plage de seconde région.

**10.** Procédé selon la revendication 2,
dans lequel, pour le procédé de codage de première région :

la reconnaissance d'événements comporte la reconnaissance d'événements qui comportent chacun une plage de coefficients quantifiés consécutifs d'amplitudes autres que l'amplitude la plus susceptible de se produire ;

la formation de mots de code pour les événements reconnus dans la première région comporte pour chaque événement qui comporte une pluralité de coefficients quantifiés consécutifs, le codage conjoint d'une pluralité d'amplitudes consécutives dans la plage de coefficients quantifiés consécutifs ayant une amplitude autre que l'amplitude la plus susceptible de se produire, le codage conjoint étant effectué selon un procédé de codage d'amplitude.

**11.** Procédé selon la revendication 10, dans lequel le codage conjoint code conjointement une pluralité d'amplitudes, et code séparément les signes des coefficients dont les amplitudes sont codées conjointement.

**12.** Procédé selon la revendication 10, dans lequel le codage conjoint code conjointement une pluralité d'amplitudes comportant les signes des coefficients dont les amplitudes sont codées conjointement, de telle sorte qu'aucun codage de signes séparé ne soit utilisé pour les coefficients dont les amplitudes sont codées conjointement.

**13.** Procédé selon la revendication 10,
dans lequel la transformée et la quantification sont telles que l'amplitude la plus susceptible de se produire est 0, et l'amplitude la plus susceptible de se produire suivante est 1, et
dans lequel l'identification d'événements comporte l'identification d'événements qui comportent chacun une plage de coefficients consécutifs de valeur nulle, précédant une plage d'un ou plusieurs coefficients de valeur non nulle, notamment des événements d'aucun coefficient de valeur nulle précédant une plage d'un ou plusieurs coefficients consécutifs de valeur non nulle ; et
dans lequel le codage conjoint comporte le codage conjoint des longueurs de plage de la plage précédente de coefficients de valeur nulle et de la plage suivante de coefficients de valeur non nulle, de telle sorte que pour au moins certains événements, des paires de longueurs de plage relativement plus susceptibles de se produire soient codées par un mot de code plus court que celui des longueurs de plage relativement moins susceptibles de se produire.

**14.** Procédé selon la revendication 13, comprenant en outre :

la fourniture d'un premier point de rupture pour définir la première région contiguë dans la mise en ordre de la série suivie par une seconde région continue, de telle sorte que les coefficients de la première région soient codés par un premier procédé de codage qui comporte l'identification d'événements, le code conjoint des longueurs de plage de événements, et le codage des amplitudes des coefficients de valeur non nulle des événements ; et
le codage des coefficients dans la seconde région en utilisant un procédé de codage de seconde région ; et
dans lequel un procédé de codage de première région et un procédé de codage de seconde région sont tels que le codage d'au moins certains des coefficients ou plages de coefficients dans la première région soit différent du codage d'au moins certains des coefficients ou plages de coefficients dans la seconde région.

**15.** Procédé selon la revendication 13, dans lequel le codage conjoint des longueurs de plage lors d'un événement utilise une table de codage multidimensionnelle.

**16.** Procédé selon la revendication 13, dans lequel le nombre d'événements qui sont identifiés et dont les longueurs de plage sont codées conjointement est limité de telle sorte que seuls les événements jusqu'à un nombre total maximum de coefficients soient identifiés, et dans lequel l'identification identifie également des événements entièrement de zéros de la longueur maximum, et des événements de longueur maximum qui se terminent par un coefficient non nul, de telle sorte que des codes d'échappement puissent être évités dans le codage des coefficients de la première région.

**17.** Procédé selon la revendication 10,
dans lequel la transformée et la quantification sont telles que l'amplitude la plus susceptible de se produire est 0 et l'amplitude la plus susceptible de se produire suivante est 1, et
dans lequel l'identification d'événements comporte l'identification des longueurs de plage de plages de n'importe quels coefficients de valeur nulle précédant un ou plusieurs coefficients consécutifs de valeur non nulle, et l'identification des longueurs de plage des un ou plusieurs coefficients de valeur non nulle qui suivent les plages de longueurs de plage de coefficients de valeur nulle ; et
dans lequel le codage conjoint des longueurs de plage comporte le codage des longueurs de plage des plages de coefficients de valeur non nulle en utilisant un premier procédé de codage de longueur de plage et le codage des longueurs de plage de plages identifiées de coefficients de valeur nulle en utilisant un second procédé de codage de longueur de plage,
de telle sorte que pour au moins certains événements, des paires de longueurs de plage relativement plus susceptibles de se produire soient codées par un mot de code plus court que celui des longueurs de plage relativement moins susceptibles de se produire.

**18.** Procédé selon l'une quelconque des revendications précédentes,
dans lequel la transformée et la quantification sont telles que l'amplitude la plus susceptible de se produire est 0 et l'amplitude la plus susceptible de se produire suivante est 1, et
dans lequel la valeur de point de rupture est présélectionnée.

**19.** Procédé selon l'une quelconque des revendications précédentes,
dans lequel la série est formée à partir d'un bloc inter-trames de données d'image, et dans lequel une première valeur de point de rupture présélectionnée est utilisée pour les données d'image inter-trames d'un premier type, et une seconde valeur de point de rupture présélectionnée est utilisée pour les données d'image inter-trames d'un second type.

**20.** Procédé selon la revendication 19, dans lequel le premier type de codage inter-trames est d'un débit binaire supérieur à celui du second type de codage inter-trames.

**21.** Procédé selon l'une quelconque des revendications précédentes,
dans lequel la valeur de point de rupture est sélectionnée dans un ensemble fini de valeurs de point de rupture prédéfinies en fonction d'un critère dépendant de l'image.

**22.** Procédé selon la revendication 21, dans lequel la valeur de point de rupture est sélectionnée dans l'ensemble fini de valeurs de points de rupture prédéfinies en fonction de celui des points de rupture de l'ensemble qui produit le nombre de bits le plus court.

**23.** Procédé selon l'une quelconque des revendications précédentes,
dans lequel le bloc transformé de données d'image après quantification comporte un terme de cosinus discret (DC), et dans lequel le terme DC est codé séparément, de telle sorte que la série ordonnée de coefficients quantifiés soit une série de coefficients non quantifiés en cosinus discret.

**24.** Procédé selon l'une quelconque des revendications précédentes,
dans lequel le point de rupture définit une frontière rigide entre les première et seconde régions.

**25.** Procédé selon l'une quelconque des revendications 1 à 23,
dans lequel le point de rupture définit une frontière souple entre les première et seconde régions, de telle sorte que pour un événement qui commence avant le point de rupture et qui franchit le point de rupture, la frontière entre la première région et la seconde région se trouve à la fin de l'événement de telle sorte que tout l'événement se trouve dans la première région.

**26.** Procédé selon l'une quelconque des revendications précédentes, comprenant en outre :

la classification de la série en une classe particulière d'une pluralité de classes en fonction de la distribution d'amplitudes des coefficients quantifiés, chaque classe ayant un processus de codage correspondant de formation des mots de code pour la série ;
pour la classe particulière de la série, l'application du processus de codage correspondant à la classe pour former un ensemble de mots de code de la série ; et
l'ajout d'une indication aux mots de code formés pour indiquer la classe particulière,
de telle sorte que, en moyenne, des mots de code relativement courts soient formés pour représenter des coefficients quantifiés ou des séquences de coefficients quantifiés qui sont relativement plus susceptibles de se produire, et des mots de code relativement longs soient formés pour représenter des coefficients quantifiés ou des séquences de coefficients quantifiés qui sont relativement moins susceptibles de se produire.

**27.** Procédé selon la revendication 26,
dans lequel la transformée et la quantification sont telles que l'amplitude la plus susceptible de se produire est 0 et l'amplitude la plus susceptible de se produire suivante est 1, et
dans lequel il existe deux classes pour n'importe quel type d'image.

**28.** Procédé selon la revendication 26,
dans lequel il existe au moins quatre classes pour n'importe quel type d'image.

**29.** Procédé selon la revendication 28,
dans lequel la transformée et la quantification sont telles que l'amplitude la plus susceptible de se produire est 0 et l'amplitude la plus susceptible de se produire suivante est 1,
et dans lequel les classes comportent :

une première classe de série dans laquelle des coefficients de valeur non nulle dans la mise en ordre des coefficients sont d'amplitudes non nulles, notamment un nombre important qui ne sont pas $\pm 1$, et dans lequel les coefficients de valeur non nulle sont regroupés dans toute la mise en ordre de telle sorte qu'il n'existe pas de point de rupture net le long du chemin de la mise en ordre des coefficients pour identifier une première région dans laquelle les coefficients de valeur non nulle sont regroupés et une seconde région dans laquelle les coefficients de valeur non nulle sont disséminés ;
une deuxième classe de série dans laquelle un nombre important de coefficients de valeur non nulle dans la mise en ordre des coefficients sont d'amplitudes de valeur non nulle, notamment un nombre important qui ne sont pas $\pm 1$, et dans lequel il existe un point de rupture le long du chemin de la mise en ordre des coefficients pour identifier une première région dans laquelle les coefficients de valeur non nulle sont sensiblement regroupés et une seconde région dans laquelle les coefficients de valeur non nulle sont disséminés ;
une troisième classe de série dans laquelle n'importe quels coefficients de valeur non nulle dans la mise en ordre des coefficients sont essentiellement dominés par des coefficients qui sont $\pm 1$, et dans lequel il existe un point de rupture le long du chemin de la mise en ordre des coefficients pour identifier une première région dans laquelle ces coefficients de valeur non nulle sont sensiblement regroupés et une seconde région dans laquelle ces coefficients de valeur non nulle sont disséminés ; et
une quatrième classe de série dans laquelle n'importe quels coefficients de valeur non nulle dans la mise en ordre des coefficients sont essentiellement dominés par des coefficients qui sont $\pm 1$, et dans lequel les coefficients de valeur non nulle sont sensiblement disséminés durant toute la mise en ordre de telle sorte qu'il n'existe pas de point de rupture net le long du chemin de la mise en ordre des coefficients pour identifier une première région dans laquelle des coefficients de valeur non nulle sont regroupés et une seconde région dans laquelle ces coefficients de valeur non nulle sont disséminés.

**30.** Procédé selon l'une quelconque des revendications 26 à 29,
dans lequel la pluralité de classes dépend d'au moins l'un des critères du groupe suivant :

le bloc d'image est un bloc intra-trame/d'image fixe, ou un bloc d'image inter-trames ;
le bloc d'image est un bloc d'image de télévision de définition standard ou un bloc d'image TVHD ;
le procédé est un procédé de codage à haut débit binaire, ou un codage à débit binaire relativement faible ; et
la transformée est une transformée DCT ou non DCT.

**31.** Procédé selon la revendication 26,
dans lequel la classification utilise la série de coefficients.

**32.** Procédé selon la revendication 31,
dans lequel la transformée et la quantification sont telles que l'amplitude la plus susceptible de se produire est 0 et l'amplitude la plus susceptible de se produire suivante est 1, et
dans lequel la classification comporte la détermination des statistiques des coefficients en fonction d'au moins un critère du groupe de critères statistiques suivant :

il existe ou non un point de rupture définissant une première région où les coefficients non nuls sont regroupés et une seconde région où les coefficients de valeur non nulle sont principalement disséminés ;
les coefficients de valeur non nulle sont principalement regroupés ou principalement disséminés ; et
les coefficients de valeur non nulle se trouvant dans une région ou tout le bloc sont ou non presque tous d'amplitude 1.

**33.** Procédé selon la revendication 31, dans lequel la classification sélectionne la classe en fonction de laquelle le procédé correspondant produit le flux binaire le plus compressé.

**34.** Procédé selon la revendication 33, dans lequel la classification comporte l'application de chacun des processus de codage correspondants séquentiellement et la sélection de la classe particulière en fonction de la compression produite par le processus de codage correspondant à la classe particulière.

**35.** Procédé selon la revendication 33, dans lequel la classification comporte l'application de chacun des processus de codage correspondants parallèlement et la sélection de la classe particulière en fonction de la compression produite par le processus de codage correspondant à la classe particulière.

**36.** Procédé selon l'une quelconque des revendications précédentes,
dans lequel la transformée et la quantification sont telles que l'amplitude la plus susceptible de se produire est 0 et l'amplitude la plus susceptible de se produire suivante est 1, et
le procédé comprenant en outre l'étape consistant à :

former des mots de code de longueur fixe pour au moins certains des événements reconnus.

**37.** Procédé selon la revendication 36, dans lequel le procédé de codage de première région comporte la formation de mots de code de longueur fixe pour au moins certains des événements reconnus dans la première région.

**38.** Procédé selon la revendication 36, dans lequel le procédé de codage de seconde région comporte la formation de mots de code de longueur fixe pour au moins certains des événements reconnus dans la seconde région.

**39.** Procédé selon la revendication 36, dans lequel les événements reconnus pour lesquels les mots de code fixes sont formés sont moins susceptibles de se produire que les événements reconnus pour lesquels un mot de code de longueur variable est utilisé, et dans lequel les mots de code de longueur fixe sont au moins aussi longs que n'importe quel mot de code de longueur variable.

**40.** Procédé selon la revendication 36, dans lequel chaque mot de code de longueur fixe comporte un code d'échappement.

**41.** Procédé selon l'une quelconque des revendications précédentes,
dans lequel la transformée et la quantification sont telles que l'amplitude la plus susceptible de se produire est 0 et l'amplitude la plus susceptible de se produire suivante est 1, et
le procédé comprenant en outre l'étape consistant à :

former une indication pour indiquer que tous les coefficients quantifiés restants dans la seconde région de la série ont l'amplitude la plus susceptible de se produire.

**42.** Procédé selon l'une quelconque des revendications précédentes,
dans lequel la transformée et la quantification sont telles que l'amplitude la plus susceptible de se produire est 0 et l'amplitude la plus susceptible de se produire suivante est 1, et
dans lequel la série est divisée en plus de deux régions par le point de rupture et un point de rupture supplémentaire pour chaque région en plus d'une deuxième région, le procédé comprenant en outre :

le codage des coefficients quantifiés se trouvant dans chaque région supplémentaire définie par le point de rupture supplémentaire correspondant, le codage utilisant un procédé de codage différent des procédés de codage utilisés dans d'autres régions.

**43.** Procédé selon l'une quelconque des revendications précédentes,
dans lequel la transformée et la quantification sont telles que l'amplitude la plus susceptible de se produire est 0 et l'amplitude la plus susceptible de se produire suivante est 1.

**44.** Procédé selon l'une quelconque des revendications précédentes,
dans lequel la transformée et la quantification sont telles que l'amplitude la plus susceptible de se produire est 0 et l'amplitude la plus susceptible de se produire suivante est 1, et
dans lequel la formation de mots de code pour chaque longueur de plage est fixée d'après des probabilités supposées à priori d'occurrences des événements.

**45.** Procédé selon l'une quelconque des revendications précédentes,
dans lequel la transformée et la quantification sont telles que l'amplitude la plus susceptible de se produire est 0 et l'amplitude la plus susceptible de se produire suivante est 1, et
dans lequel la formation de mots de code pour chaque événement est variable en fonction de données statistiques réelles collectées à partir de séries ordonnées de coefficients quantifiés.

**46.** Procédé de décodage d'un flux binaire afin de former une série de coefficients quantifiés d'une transformée d'un bloc de données d'image transformé par une transformée et quantifié par quantification, les coefficients quantifiés ayant chacun une amplitude comportant une amplitude la plus susceptible de se produire et au moins une amplitude la plus susceptible de se produire suivante,
le procédé de décodage comprenant :

la reconnaissance d'un mot de code ;
la détermination de l'événement représenté par le mot de code reconnu ; et
la détermination des coefficients de chaque événement déterminé,
jusqu'à la détermination de tous les coefficients dans la série,
dans lequel les mots de code dans le flux binaire sont déterminés en utilisant un procédé de codage selon l'une quelconque des revendications 1 à 45.

**47.** Appareil comportant un système de traitement, l'appareil servant à accepter une série ordonnée de coefficients quantifiés qui ont chacun une amplitude parmi un ensemble fini d'amplitudes consistant en l'amplitude la plus susceptible de se produire et au moins une autre amplitude, l'appareil servant à exécuter un procédé de codage selon l'une quelconque des revendications précédentes pour un procédé de codage selon l'une quelconque des revendications 1 à 45.

**48.** Appareil comportant un système de traitement, l'appareil servant à accepte et décoder un flux binaire afin de former une série ordonnée de coefficients quantifiés d'une transformée d'un bloc de données d'image transformé par une transformé et quantifié par quantification, les coefficients quantifiés ayant chacun une amplitude parmi un ensemble fini d'amplitudes consistant en une amplitude la plus susceptible de se produire et au moins une autre amplitude, le flux binaire étant codé par un procédé de codage selon l'une quelconque des revendications 1 à 45, le système de traitement étant agencé pour mettre en oeuvre un procédé de décodage comprenant :

la reconnaissance d'un mot de code ;
la détermination de l'événement représenté par le mot de code reconnu ; et
la détermination des coefficients quantifiés de chaque événement déterminé,
jusqu'à la détermination des amplitudes de tous les coefficients quantifiés dans la série.

**49.** Support lisible par ordinateur comportant des instructions lisibles par ordinateur qui lorsqu'elles sont exécutées par un ou plusieurs processeurs d'un système de traitement exécutent un procédé de codage selon l'une quelconque des revendications 1 à 45.

**50.** Support lisible par ordinateur comportant des instructions lisibles par ordinateur qui lorsqu'elles sont exécutées par un ou plusieurs processeurs d'un système de traitement exécutent un procédé de décodage, le procédé de décodage consistant à accepter et à décoder un flux binaire afin de former une série ordonnée de coefficients quantifiés d'une transformée d'un bloc de données d'image transformé par une transformé et quantifié par quantification, les coefficients quantifiés ayant chacun une amplitude parmi un ensemble fini d'amplitudes consistant en l'amplitude la plus susceptible de se produire et au moins une autre amplitude, le flux binaire étant codé par un procédé de codage selon l'une quelconque des revendications 1 à 45,
le procédé de décodage comprenant :

la reconnaissance d'un mot de code ;
la détermination de l'événement représenté par le mot de code reconnu ; et
la détermination des coefficients de chaque événement déterminé,
jusqu'à la détermination des amplitudes de tous les coefficients dans la série.

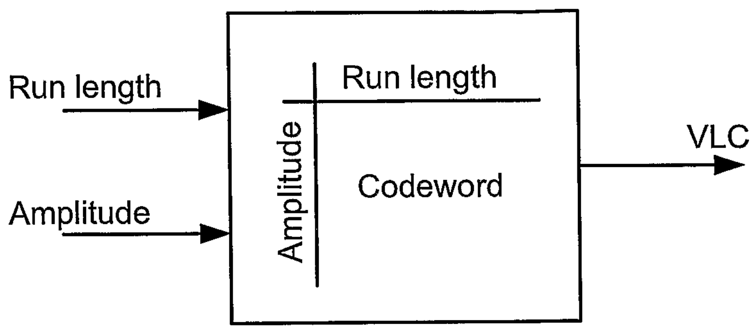


FIG. 1 (Prior Art)

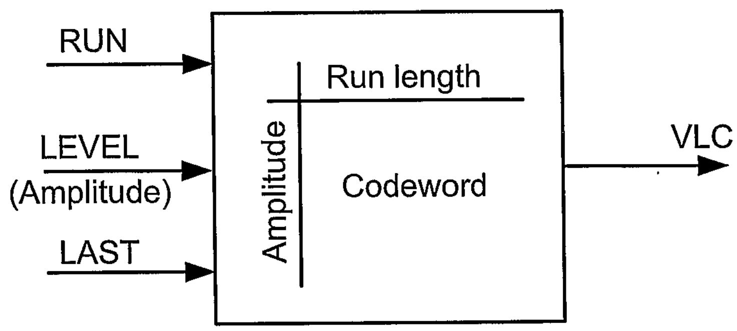


FIG. 2 (Prior Art)

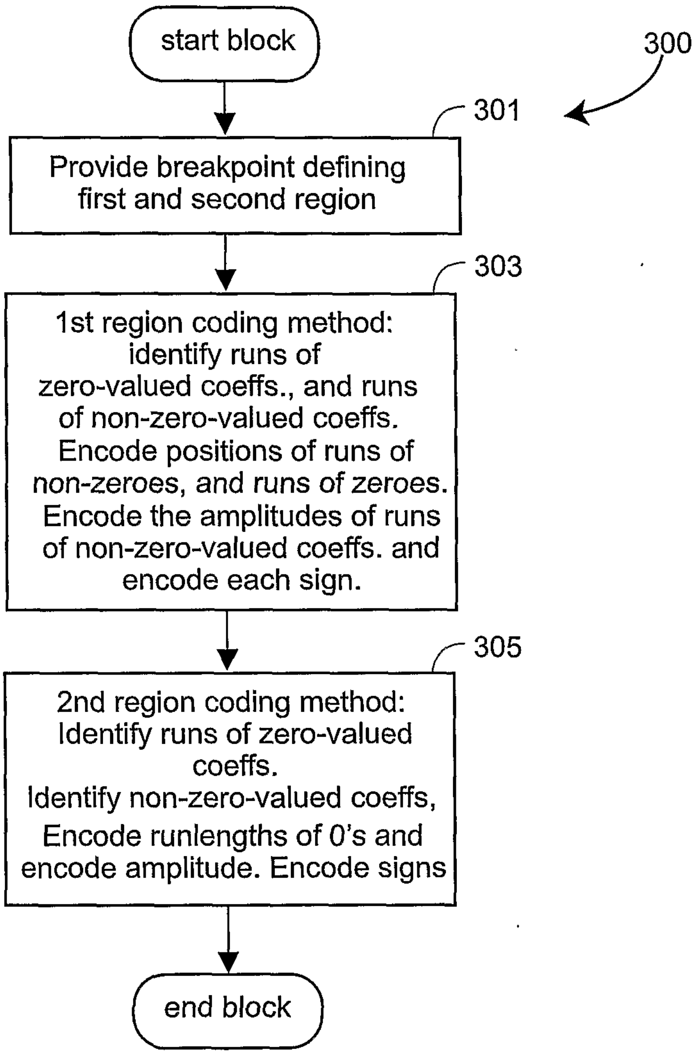
start block
300
301
Provide breakpoint defining first and second region
303
1st region coding method: identify runs of zero-valued coeffs., and runs of non-zero-valued coeffs. Encode positions of runs of non-zeroes, and runs of zeroes. Encode the amplitudes of runs of non-zero-valued coeffs. and encode each sign.
305
2nd region coding method: Identify runs of zero-valued coeffs. Identify non-zero-valued coeffs, Encode runlengths of 0's and encode amplitude. Encode signs
end block

FIG. 3

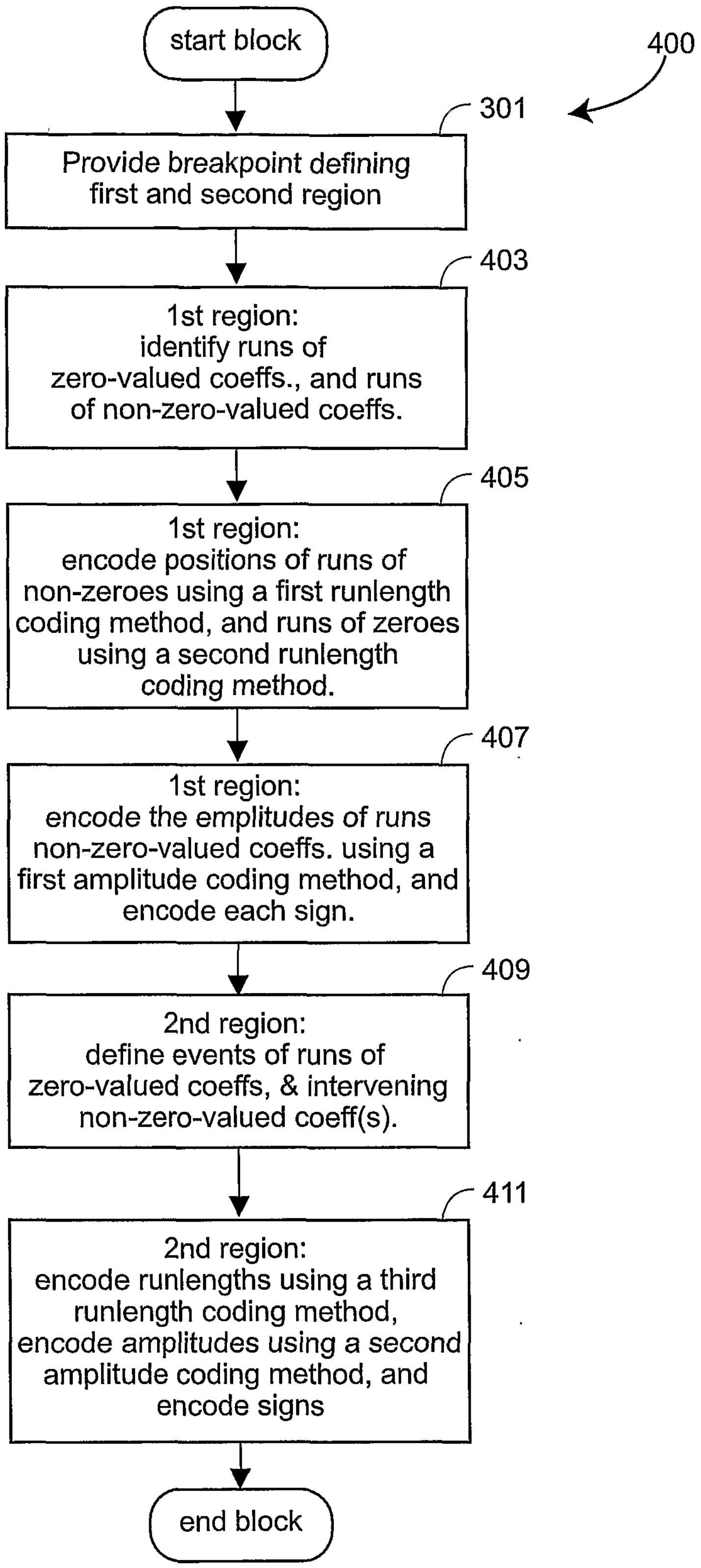
400
start block
301
Provide breakpoint defining first and second region
403
1st region: identify runs of zero-valued coeffs., and runs of non-zero-valued coeffs.
405
1st region: encode positions of runs of non-zeroes using a first runlength coding method, and runs of zeroes using a second runlength coding method.
407
1st region: encode the emplitudes of runs non-zero-valued coeffs. using a first amplitude coding method, and encode each sign.
409
2nd region: define events of runs of zero-valued coeffs, & intervening non-zero-valued coeff(s).
411
2nd region: encode runlengths using a third runlength coding method, encode amplitudes using a second amplitude coding method, and encode signs
end block

FIG. 4

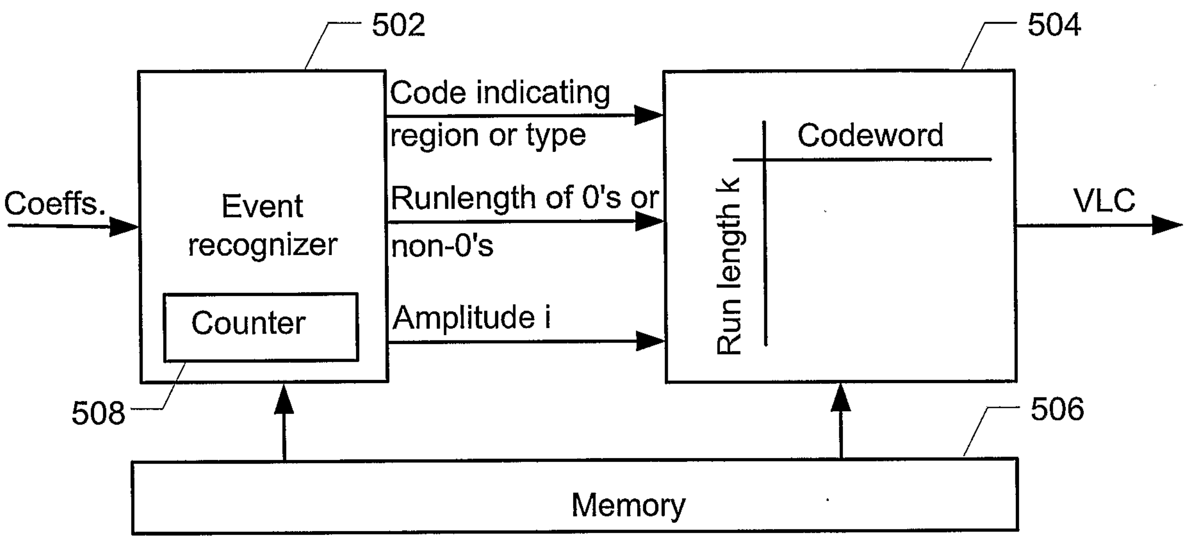
502
504
Coeffs.
Event
recognizer
Counter
Code indicating
region or type
Runlength of 0's or
non-0's
Amplitude i
Codeword
Run length k
VLC
508
506
Memory

FIG. 5

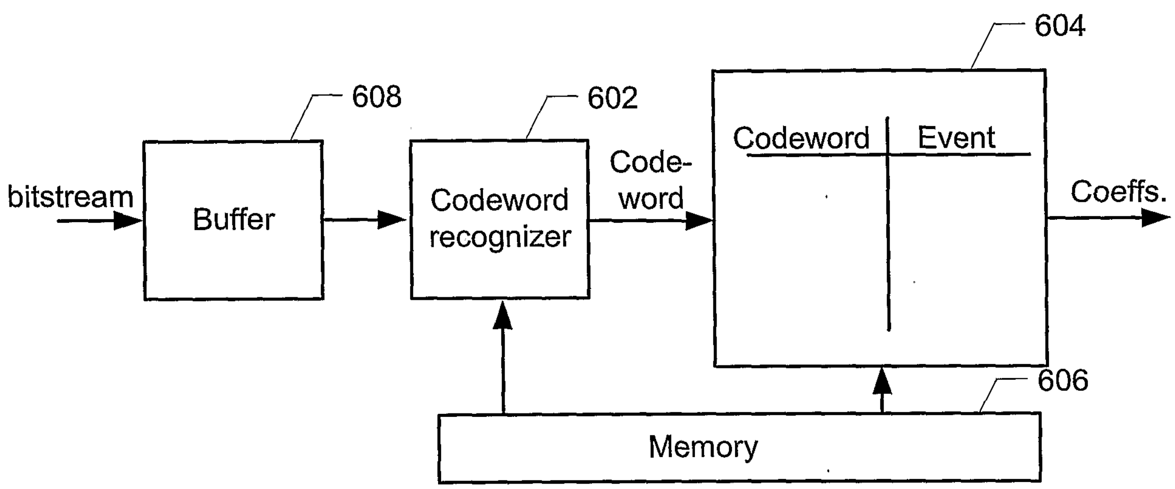
604
608
602
bitstream
Buffer
Codeword
recognizer
Code-
word
Codeword
Event
Coeffs.
606
Memory

FIG. 6

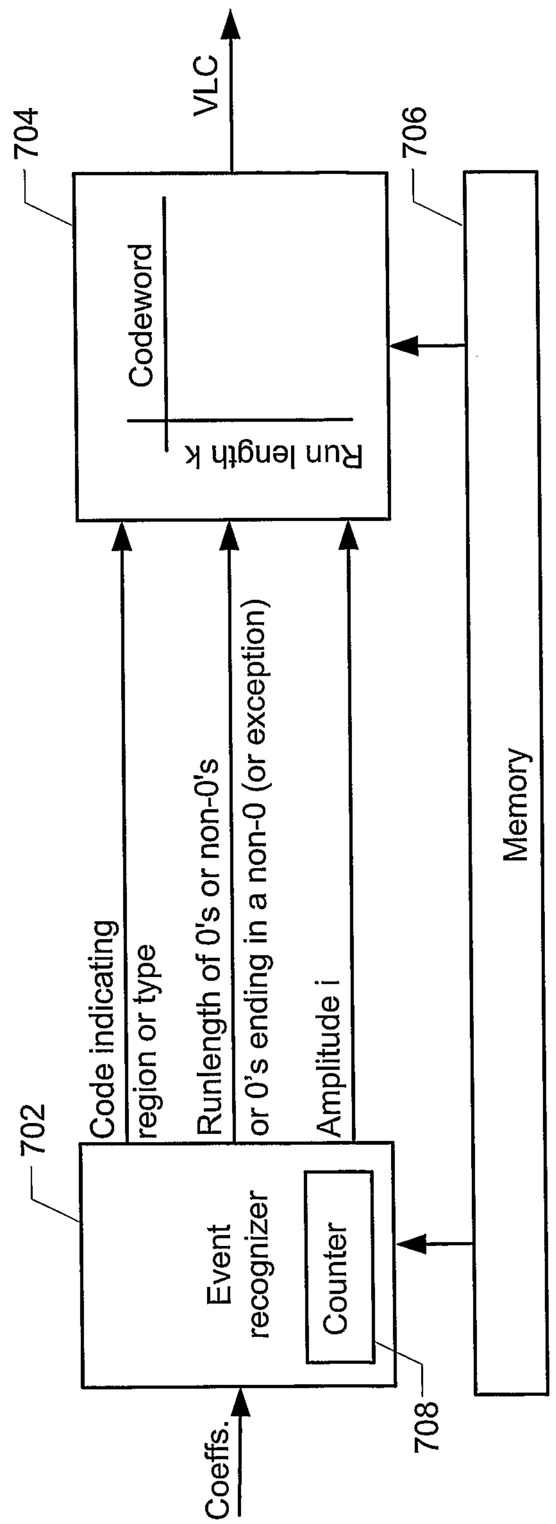

704
VLC
706
Codeword
Run length k
Code indicating
region or type
Runlength of 0's or non-0's
or 0's ending in a non-0 (or exception)
Amplitude i
702
Event
recognizer
Counter
Coeffs.
708
Memory


FIG. 7

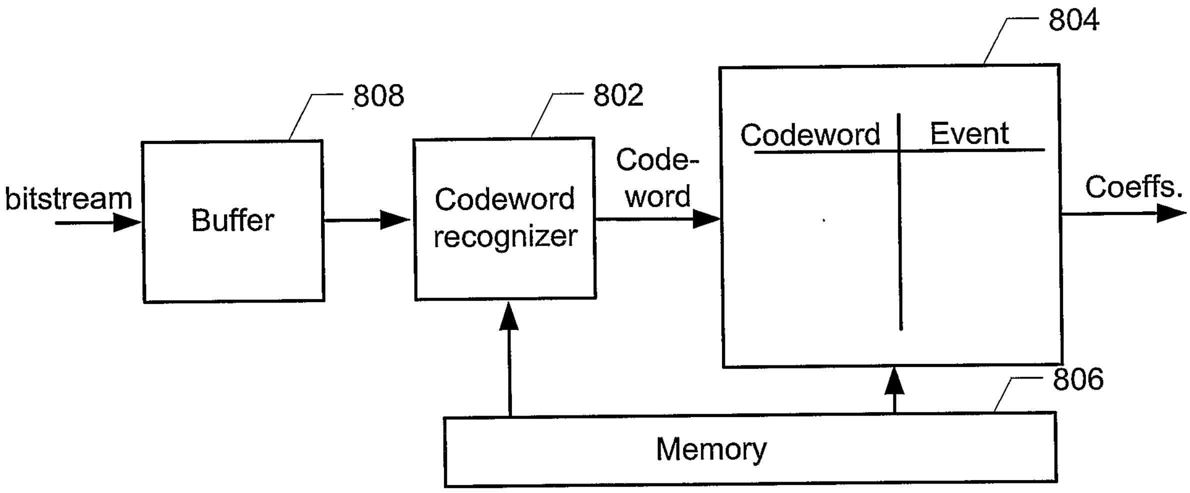
804
808
802
Code-
word
Codeword
Event
Coeffs.
bitstream
Buffer
Codeword
recognizer
806
Memory

FIG. 8

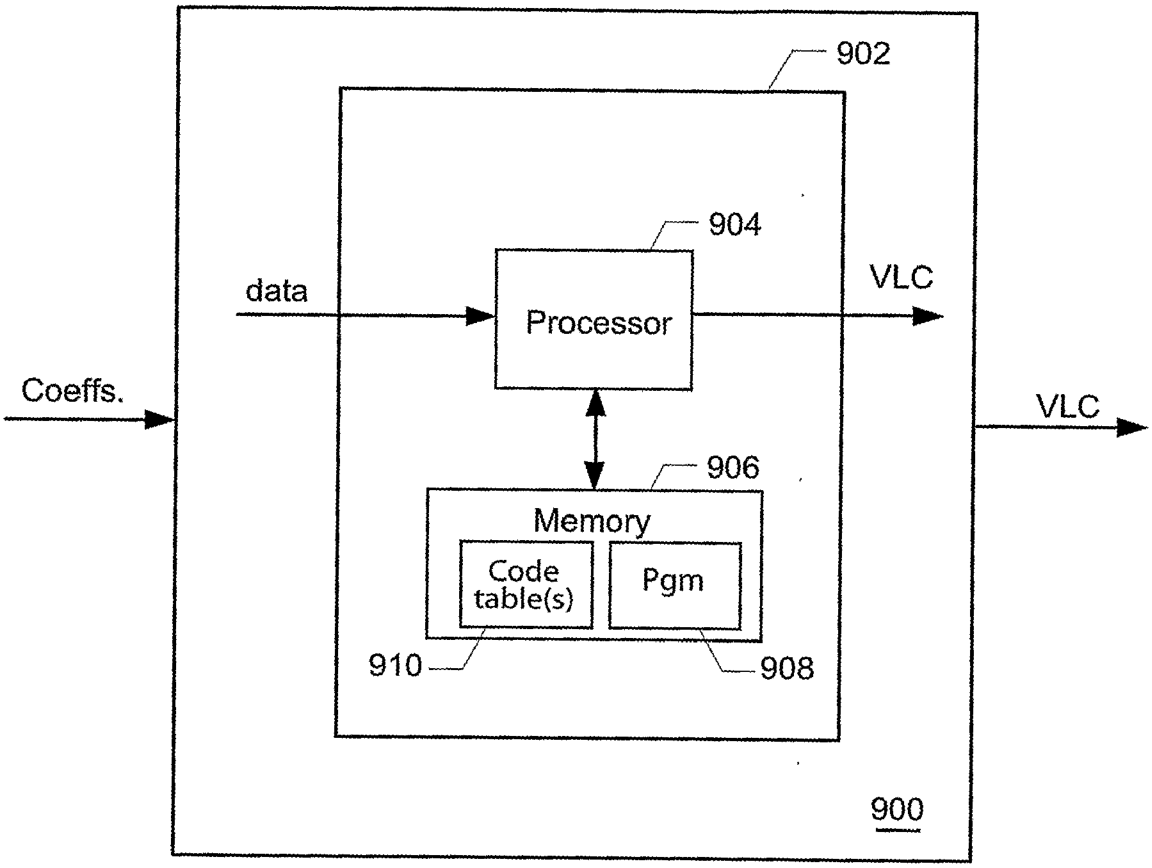
902
904
data
Processor
VLC
Coeffs.
VLC
906
Memory
Code
table(s)
Pgm
910
908
900

FIG. 9

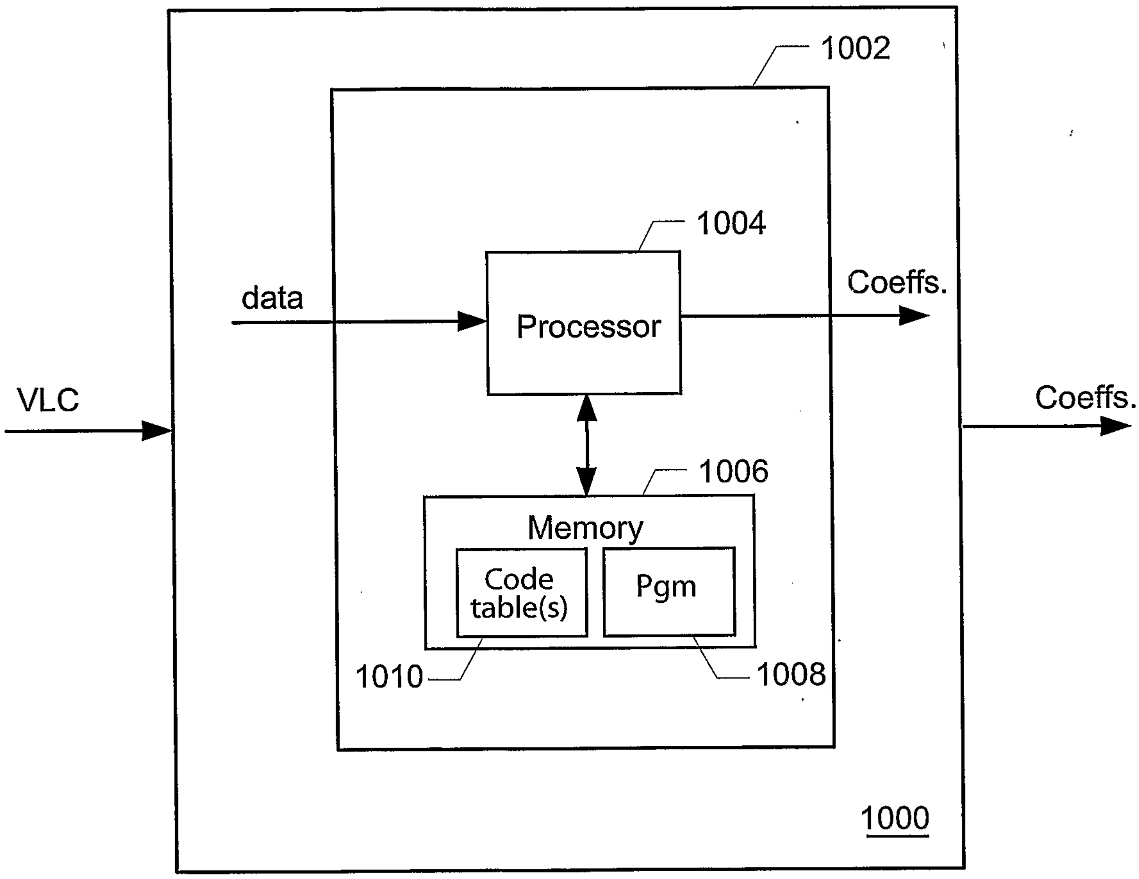
1002
1004
data
Processor
Coeffs.
VLC
Coeffs.
1006
Memory
Code table(s)
Pgm
1010
1008
1000

FIG. 10

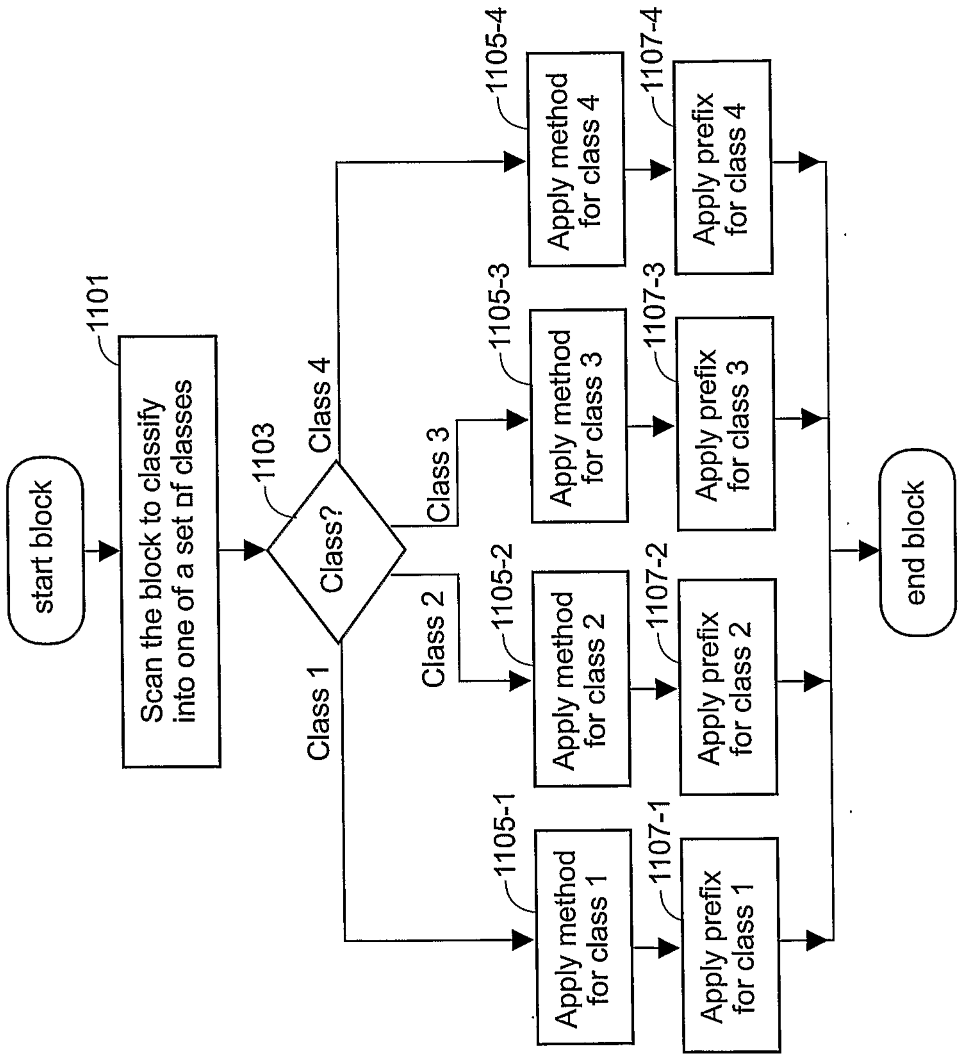
start block
Scan the block to classify into one of a set of classes
1101
Class?
1103
Class 1
Class 2
Class 3
Class 4
Apply method for class 1
1105-1
Apply method for class 2
1105-2
Apply method for class 3
1105-3
Apply method for class 4
1105-4
Apply prefix for class 1
1107-1
Apply prefix for class 2
1107-2
Apply prefix for class 3
1107-3
Apply prefix for class 4
1107-4
end block

FIG. 11

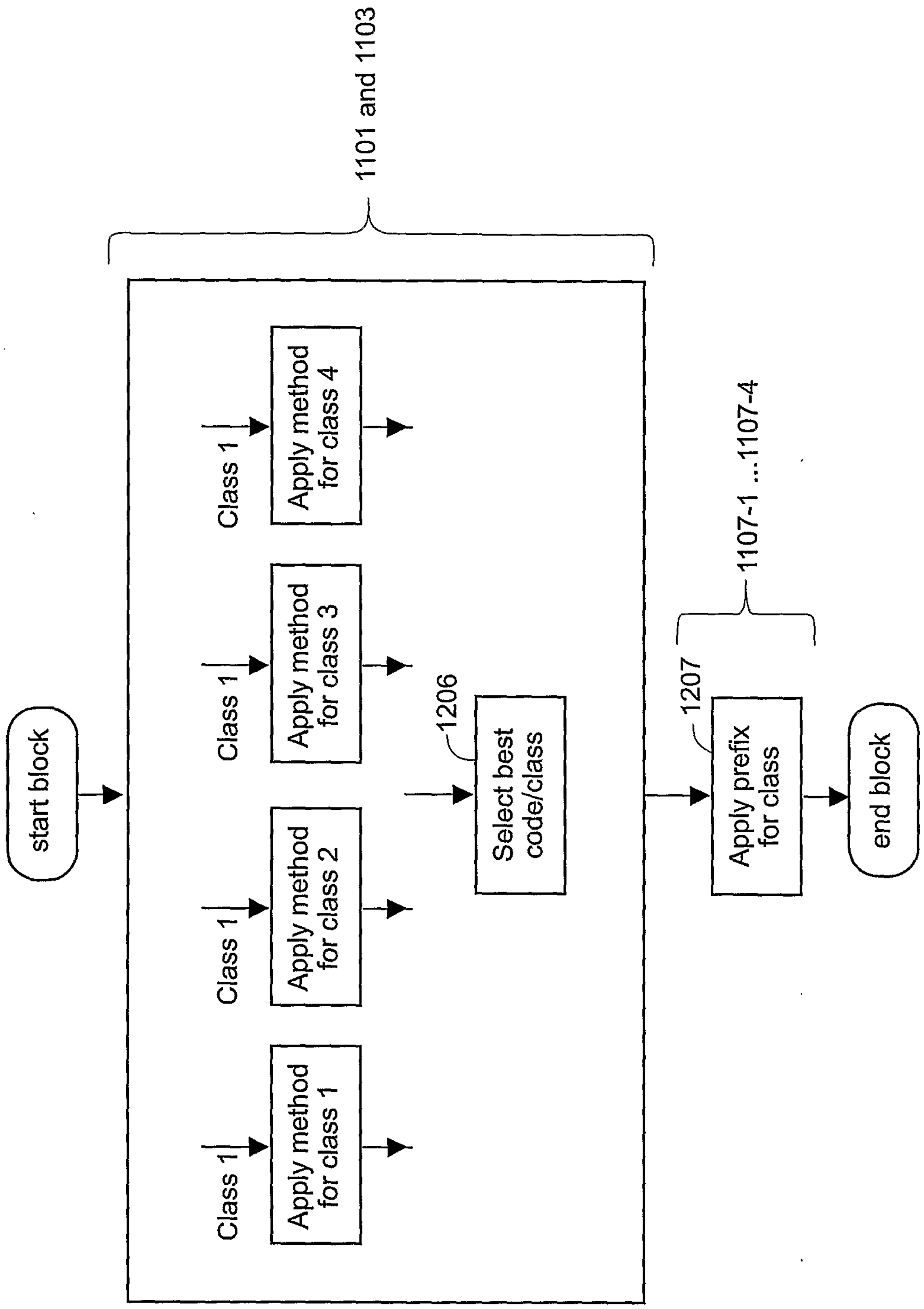
start block
1101 and 1103
Class 1
Apply method for class 1
Class 1
Apply method for class 2
Class 1
Apply method for class 3
Class 1
Apply method for class 4
1206
Select best code/class
1207
Apply prefix for class
1107-1 ...1107-4
end block

FIG. 12

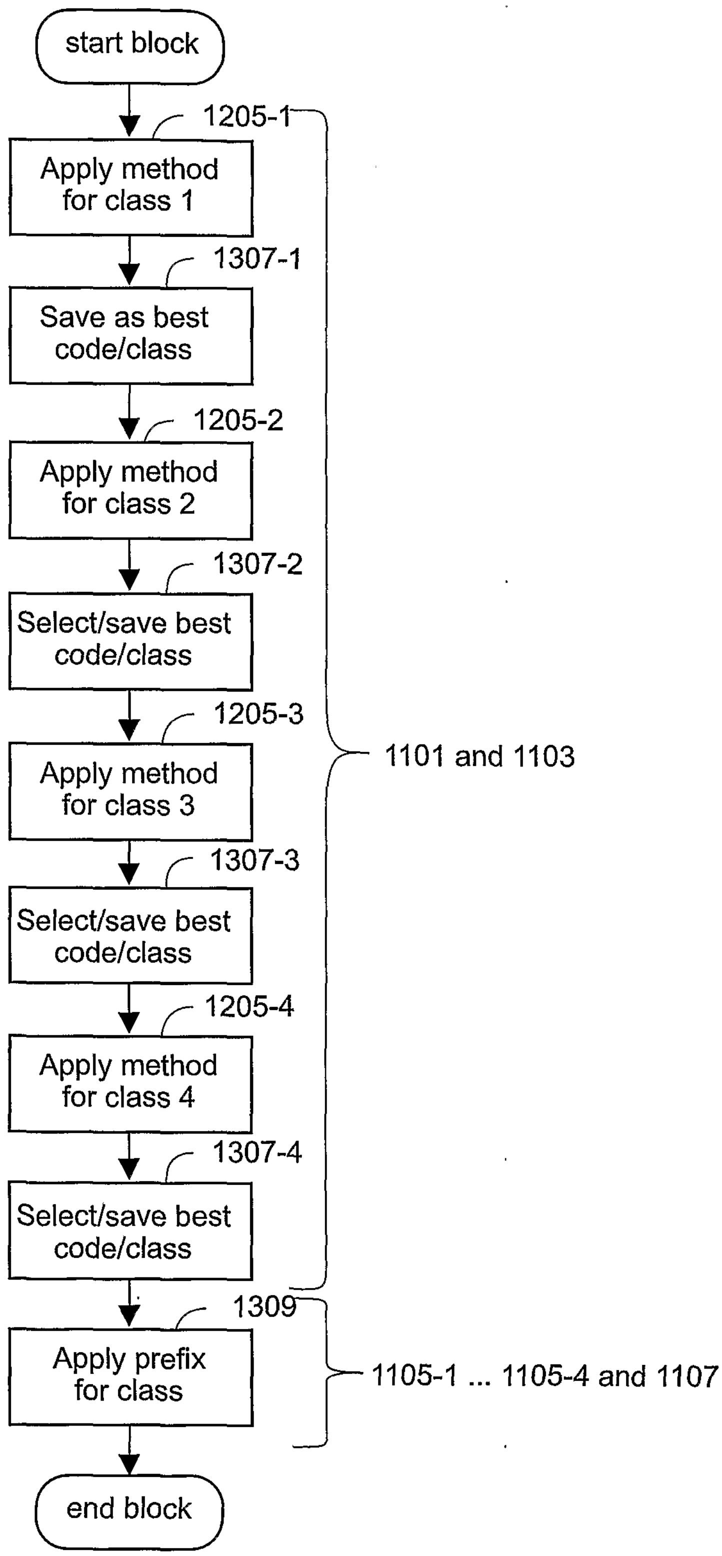
start block
1205-1
Apply method for class 1
1307-1
Save as best code/class
1205-2
Apply method for class 2
1307-2
Select/save best code/class
1205-3
Apply method for class 3
1307-3
Select/save best code/class
1205-4
Apply method for class 4
1307-4
Select/save best code/class
1101 and 1103
1309
Apply prefix for class
1105-1 ... 1105-4 and 1107
end block

FIG. 13

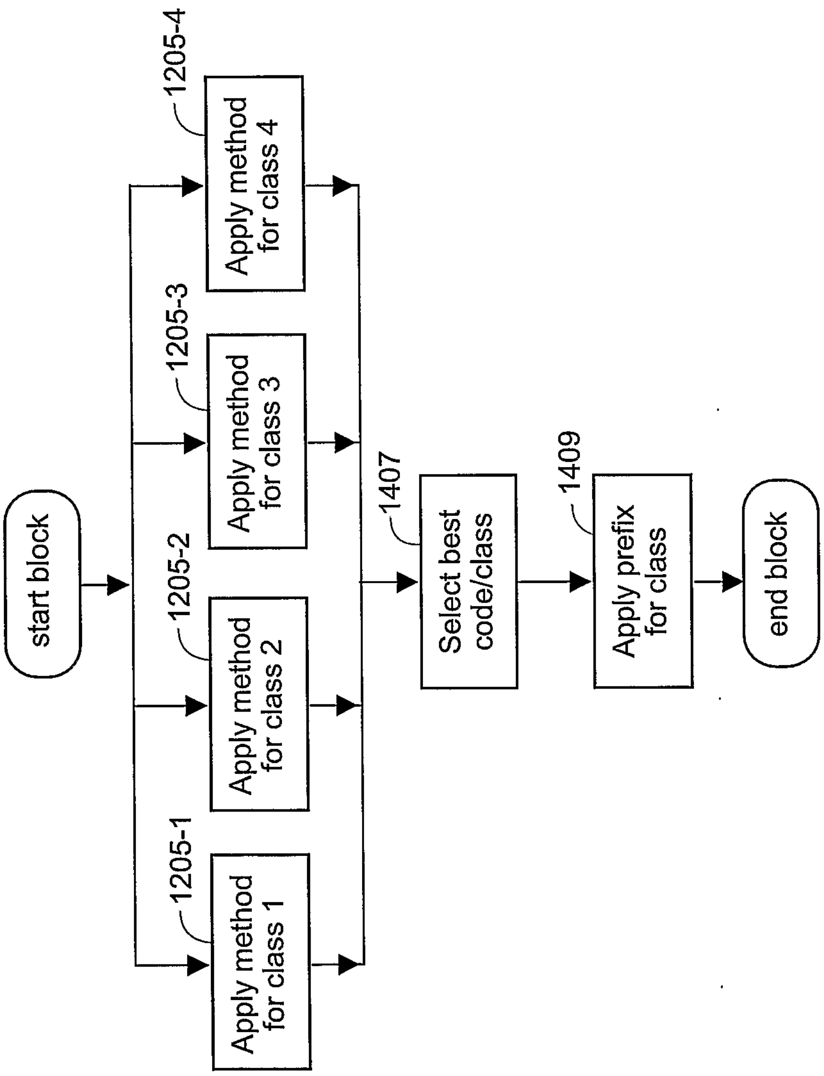
start block
Apply method for class 1
1205-1
Apply method for class 2
1205-2
Apply method for class 3
1205-3
Apply method for class 4
1205-4
Select best code/class
1407
Apply prefix for class
1409
end block

FIG. 14

**Table 1: Event statistics for 2D-VLC coding**

| | | Coeff. Amplitude | | | | | | | | |
|---|---|---|---|---|---|---|---|---|---|---|
| | | 1 | 2 | 3 | 4 | 5 | 6 | 7 | . | . |
| Runlength of preceding 0s | 0 | $S_{2D}(0,1)$ | $S_{2D}(0,2)$ | $S_{2D}(0,3)$ | $S_{2D}(0,4)$ | $S_{2D}(0,5)$ | $S_{2D}(0,6)$ | $S_{2D}(0,7)$ | . | . |
| | 1 | $S_{2D}(1,1)$ | $S_{2D}(1,2)$ | $S_{2D}(1,3)$ | $S_{2D}(1,4)$ | $S_{2D}(1,5)$ | $S_{2D}(1,6)$ | $S_{2D}(1,7)$ | . | . |
| | 2 | $S_{2D}(2,1)$ | $S_{2D}(2,2)$ | $S_{2D}(2,3)$ | $S_{2D}(2,4)$ | $S_{2D}(2,5)$ | $S_{2D}(2,6)$ | $S_{2D}(2,7)$ | . | . |
| | 3 | $S_{2D}(3,1)$ | $S_{2D}(3,2)$ | $S_{2D}(3,3)$ | $S_{2D}(3,4)$ | $S_{2D}(3,5)$ | $S_{2D}(3,6)$ | $S_{2D}(3,7)$ | . | . |
| | 4 | $S_{2D}(4,1)$ | $S_{2D}(4,2)$ | $S_{2D}(4,3)$ | $S_{2D}(4,4)$ | $S_{2D}(4,5)$ | $S_{2D}(4,6)$ | $S_{2D}(4,7)$ | . | . |
| | 5 | $S_{2D}(5,1)$ | $S_{2D}(5,2)$ | $S_{2D}(5,3)$ | $S_{2D}(5,4)$ | $S_{2D}(5,5)$ | $S_{2D}(5,6)$ | $S_{2D}(5,7)$ | . | . |
| | 6 | $S_{2D}(6,1)$ | $S_{2D}(6,2)$ | $S_{2D}(6,3)$ | $S_{2D}(6,4)$ | $S_{2D}(6,5)$ | $S_{2D}(6,6)$ | $S_{2D}(6,7)$ | . | . |
| | 7 | $S_{2D}(7,1)$ | $S_{2D}(7,2)$ | $S_{2D}(7,3)$ | $S_{2D}(7,4)$ | $S_{2D}(7,5)$ | $S_{2D}(7,6)$ | $S_{2D}(7,7)$ | . | . |
| | 8 | $S_{2D}(8,1)$ | $S_{2D}(8,2)$ | $S_{2D}(8,3)$ | $S_{2D}(8,4)$ | $S_{2D}(8,5)$ | $S_{2D}(8,6)$ | $S_{2D}(8,7)$ | . | . |
| | 9 | $S_{2D}(9,1)$ | $S_{2D}(9,2)$ | $S_{2D}(9,3)$ | $S_{2D}(9,4)$ | $S_{2D}(9,5)$ | $S_{2D}(9,6)$ | $S_{2D}(9,7)$ | . | . |
| | . | . | . | . | . | . | . | . | . | . |
| | . | . | . | . | . | . | . | . | . | . |

FIG. 15 (Prior Art)

**Table 2: 2D-VLC Codes**

| | | Coeff. Amplitude | | | | | | | | |
|---|---|---|---|---|---|---|---|---|---|---|
| | | 1 | 2 | 3 | 4 | 5 | 6 | 7 | . | . |
| Runlength of preceding 0s | 0 | $C_{2D}(0,1)$ | $C_{2D}(0,2)$ | $C_{2D}(0,3)$ | $C_{2D}(0,4)$ | $C_{2D}(0,5)$ | $C_{2D}(0,6)$ | $C_{2D}(0,7)$ | . | . |
| | 1 | $C_{2D}(1,1)$ | $C_{2D}(1,2)$ | $C_{2D}(1,3)$ | $C_{2D}(1,4)$ | $C_{2D}(1,5)$ | $C_{2D}(1,6)$ | $C_{2D}(1,7)$ | . | . |
| | 2 | $C_{2D}(2,1)$ | $C_{2D}(2,2)$ | $C_{2D}(2,3)$ | $C_{2D}(2,4)$ | $C_{2D}(2,5)$ | $C_{2D}(2,6)$ | $C_{2D}(2,7)$ | . | . |
| | 3 | $C_{2D}(3,1)$ | $C_{2D}(3,2)$ | $C_{2D}(3,3)$ | $C_{2D}(3,4)$ | $C_{2D}(3,5)$ | $C_{2D}(3,6)$ | $C_{2D}(3,7)$ | . | . |
| | 4 | $C_{2D}(4,1)$ | $C_{2D}(4,2)$ | $C_{2D}(4,3)$ | $C_{2D}(4,4)$ | $C_{2D}(4,5)$ | $C_{2D}(4,6)$ | $C_{2D}(4,7)$ | . | . |
| | 5 | $C_{2D}(5,1)$ | $C_{2D}(5,2)$ | $C_{2D}(5,3)$ | $C_{2D}(5,4)$ | $C_{2D}(5,5)$ | $C_{2D}(5,6)$ | $C_{2D}(5,7)$ | . | . |
| | 6 | $C_{2D}(6,1)$ | $C_{2D}(6,2)$ | $C_{2D}(6,3)$ | $C_{2D}(6,4)$ | $C_{2D}(6,5)$ | $C_{2D}(6,6)$ | $C_{2D}(6,7)$ | . | . |
| | 7 | $C_{2D}(7,1)$ | $C_{2D}(7,2)$ | $C_{2D}(7,3)$ | $C_{2D}(7,4)$ | $C_{2D}(7,5)$ | $C_{2D}(7,6)$ | $C_{2D}(7,7)$ | . | . |
| | 8 | $C_{2D}(8,1)$ | $C_{2D}(8,2)$ | $C_{2D}(8,3)$ | $C_{2D}(8,4)$ | $C_{2D}(8,5)$ | $C_{2D}(8,6)$ | $C_{2D}(8,7)$ | . | . |
| | 9 | $C_{2D}(9,1)$ | $C_{2D}(9,2)$ | $C_{2D}(9,3)$ | $C_{2D}(9,4)$ | $C_{2D}(9,5)$ | $C_{2D}(9,6)$ | $C_{2D}(9,7)$ | . | . |
| | . | . | . | . | . | . | . | . | . | . |
| | . | . | . | . | . | . | . | . | . | . |

FIG. 16 (Prior Art)

Table 12A: Examples of 2 consecutive coefficients

| Notation | Pattern |
|---|---|
| R'(0,2) | xx |
| R'(1,1) | 0x |

FIG. 17A

Table 12B: Examples of 3 consecutive coefficients

| Notation | Pattern |
|---|---|
| R'(0,3) | xxx |
| R'(1,2) | 0xx |
| R'(2,1) | 00x |

FIG. 17B

Table 12C: Examples of 4 consecutive coefficients

| Notation | Pattern |
|---|---|
| R'(0,4) | xxxx |
| R'(1,3) | 0xxx |
| R'(2,2) | 00xx |
| R'(3,1) | 000x |

FIG. 17C

Table 12D: Examples of 5 consecutive coefficients

| Notation | Pattern |
|---|---|
| R'(0,5) | xxxxx |
| R'(1,4) | 0xxxx |
| R'(2,3) | 00xxx |
| R'(3,2) | 000xx |
| R'(4,1) | 0000x |

FIG. 17D

Table 13: Statistics for events of runs of zeroes and non-zeroes

| | | Length of non-zero-value cluster | | | | | | | | | |
|---|---|---|---|---|---|---|---|---|---|---|---|
| | | 1 | 2 | 3 | 4 | 5 | 6 | 7 | 8 | 9 | ... |
| Length of preceding zeroes | 0 | S'(0,1) | S'(0,2) | S'(0,3) | S'(0,4) | S'(0,5) | S'(0,6) | S'(0,7) | S'(0,8) | ... | ... |
| | 1 | S'(1,1) | S'(1,2) | S'(1,3) | ... | ... | ... | ... | ... | ... | ... |
| | 2 | S'(2,1) | S'(2,2) | S'(2,3) | ... | ... | ... | ... | ... | ... | ... |
| | 3 | S'(3,1) | S'(3,2) | S'(3,3) | ... | ... | ... | ... | ... | ... | ... |
| | 4 | S'(4,1) | S'(4,2) | S'(4,3) | ... | ... | ... | ... | ... | ... | ... |
| | 5 | S'(5,1) | S'(5,2) | S'(5,3) | ... | ... | ... | ... | ... | ... | ... |
| | 6 | S'(6,1) | S'(6,2) | S'(6,3) | ... | ... | ... | ... | ... | ... | ... |
| | 7 | S'(7,1) | S'(7,2) | S'(7,3) | ... | ... | ... | ... | ... | ... | ... |
| | 8 | S'(8,1) | S'(8,2) | S'(8,3) | ... | ... | ... | ... | ... | ... | ... |
| | 9 | ... | ... | ... | ... | ... | ... | ... | ... | ... | ... |
| | ... | ... | ... | ... | ... | ... | ... | ... | ... | ... | ... |
| | ... | ... | ... | ... | ... | ... | ... | ... | ... | ... | ... |
| | ... | ... | ... | ... | ... | ... | ... | ... | ... | ... | ... |

FIG. 18

Table 14: Codes for events of runs of zeroes and non-zeroes

| | | Length of non-zero-value cluster | | | | | | | | | |
|---|---|---|---|---|---|---|---|---|---|---|---|
| | | 1 | 2 | 3 | 4 | 5 | 6 | 7 | 8 | 9 | ... |
| Length of preceding zeroes | 0 | C'(0,1) | C'(0,2) | C'(0,3) | C'(0,4) | C'(0,5) | C'(0,6) | C'(0,7) | C'(0,8) | ... | ... |
| | 1 | C'(1,1) | C'(1,2) | C'(1,3) | ... | ... | ... | ... | ... | ... | ... |
| | 2 | C'(2,1) | C'(2,2) | C'(2,3) | ... | ... | ... | ... | ... | ... | ... |
| | 3 | C'(3,1) | C'(3,2) | C'(3,3) | ... | ... | ... | ... | ... | ... | ... |
| | 4 | C'(4,1) | C'(4,2) | C'(4,3) | ... | ... | ... | ... | ... | ... | ... |
| | 5 | C'(5,1) | C'(5,2) | C'(5,3) | ... | ... | ... | ... | ... | ... | ... |
| | 6 | C'(6,1) | C'(6,2) | C'(6,3) | ... | ... | ... | ... | ... | ... | ... |
| | 7 | C'(7,1) | C'(7,2) | C'(7,3) | ... | ... | ... | ... | ... | ... | ... |
| | 8 | C'(8,1) | C'(8,2) | C'(8,3) | ... | ... | ... | ... | ... | ... | ... |
| | 9 | ... | ... | ... | ... | ... | ... | ... | ... | ... | ... |
| | ... | ... | ... | ... | ... | ... | ... | ... | ... | ... | ... |
| | ... | ... | ... | ... | ... | ... | ... | ... | ... | ... | ... |
| | ... | ... | ... | ... | ... | ... | ... | ... | ... | ... | ... |

FIG. 19

**Table 15A: Examples of 2 consecutive coefficients**

| Notation | Pattern |
|---|---|
| R(0,1) | x0 |

FIG. 20A

**Table 15B: Examples of 3 consecutive coefficients**

| Notation | Pattern |
|---|---|
| R(0,2) | xx0 |
| R(1,1) | 0x0 |

FIG. 20B

**Table 15C: Examples of 4 consecutive coefficients**

| Notation | Pattern |
|---|---|
| R(0,3) | xxx0 |
| R(1,2) | 0xx0 |
| R(2,1) | 00x0 |

FIG. 20C

**Table 15D: Examples of 5 consecutive coefficients**

| Notation | Pattern |
|---|---|
| R(0,4) | xxxx0 |
| R(1,3) | 0xxx0 |
| R(2,2) | 00xx0 |
| R(3,1) | 000x0 |

FIG. 20D

**Table 15E: Examples of six consecutive coefficients**

| Notation | Pattern |
|---|---|
| R(0,5) | xxxxx0 |
| R(1,4) | 0xxxx0 |
| R(2,3) | 00xxx0 |
| R(3,2) | 000xx0 |
| R(4,1) | 0000x0 |

FIG. 20E

**Table 15F: Examples of 12 consecutive coefficients (the maximum)**

| Notation | Pattern | Comment |
|---|---|---|
| R(0,12) | xxxxxxxxxxxx | No zero at end; avoids escape |
| R(0,11) | xxxxxxxxxxx0 | |
| R(1,11) | 0xxxxxxxxxxx | No zero at end; avoids escape |
| R(1,10) | 0xxxxxxxxxx0 | |
| R(2,10) | 00xxxxxxxxxx | No zero at end; avoids escape |
| R(2,9) | 00xxxxxxxxx0 | |
| ... | | |
| R(6,6) | 000000xxxxxx | No zero at end; avoids escape |
| R(6,5) | 000000xxxxx0 | |
| ... | | |
| R(10,2) | 0000000000xx | No zero at end; avoids escape |
| R(10,1) | 0000000000x0 | |
| R(11,1) | 00000000000x | No zero at end; avoids escape |
| R(12,0) | 000000000000 | All zeroes |

FIG. 20F

Table 16: Statistics for events of runs of zeroes and non-zeroes follwed by a zero

| | | Length of non-zero-value cluster | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Length of preceding zeroes | 0 | S(0,1) | S(0,2) | S(0,3) | S(0,4) | S(0,5) | S(0,6) | S(0,7) | S(0,8) | S(0,9) | S(0,10) | S(0,11) | **S(0,12)** |
| | 1 | S(1,1) | S(1,2) | S(1,3) | S(1,4) | S(1,5) | S(1,6) | S(1,7) | S(1,8) | S(1,9) | S(1,10) | **S(1,11)** | |
| | 2 | S(2,1) | S(2,2) | S(2,3) | S(2,4) | S(2,5) | S(2,6) | S(2,7) | S(2,8) | S(2,9) | **S(2,10)** | | |
| | 3 | S(3,1) | S(3,2) | S(3,3) | S(3,4) | S(3,5) | S(3,6) | S(3,7) | S(3,8) | **S(3,9)** | | | |
| | 4 | S(4,1) | S(4,2) | S(4,3) | S(4,4) | S(4,5) | S(4,6) | S(4,7) | **S(4,8)** | | | | |
| | 5 | S(5,1) | S(5,2) | S(5,3) | S(5,4) | S(5,5) | S(5,6) | **S(5,7)** | | | | | |
| | 6 | S(6,1) | S(6,2) | S(6,3) | S(6,4) | S(6,5) | **S(6,6)** | | | | | | |
| | 7 | S(7,1) | S(7,2) | S(7,3) | S(7,4) | **S(7,5)** | | | | | | | |
| | 8 | S(8,1) | S(8,2) | S(8,3) | **S(8,4)** | | | | | | | | |
| | 9 | S(9,1) | S(9,2) | **S(9,3)** | | | | | | | | | |
| | 10 | S(10,1) | **S(10,2)** | | | | | | | | | | |
| | 11 | **S(11,1)** | | | | | | | | | | | |
| | 12 | **S(12,0)** | | | | | | | | | | | |

FIG. 21

Table 17: Codes for events of runs of zeroes and non-zeroes follwed by a zero

| | | Length of non-zero-value cluster | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Length of preceding zeroes | 0 | C(0,1) | C(0,2) | C(0,3) | C(0,4) | C(0,5) | C(0,6) | C(0,7) | C(0,8) | C(0,9) | C(0,10) | C(0,11) | **C(0,12)** |
| | 1 | C(1,1) | C(1,2) | C(1,3) | C(1,4) | C(1,5) | C(1,6) | C(1,7) | C(1,8) | C(1,9) | C(1,10) | **C(1,11)** | |
| | 2 | C(2,1) | C(2,2) | C(2,3) | C(2,4) | C(2,5) | C(2,6) | C(2,7) | C(2,8) | C(2,9) | **C(2,10)** | | |
| | 3 | C(3,1) | C(3,2) | C(3,3) | C(3,4) | C(3,5) | C(3,6) | C(3,7) | C(3,8) | **C(3,9)** | | | |
| | 4 | C(4,1) | C(4,2) | C(4,3) | C(4,4) | C(4,5) | C(4,6) | C(4,7) | **C(4,8)** | | | | |
| | 5 | C(5,1) | C(5,2) | C(5,3) | C(5,4) | C(5,5) | C(5,6) | **C(5,7)** | | | | | |
| | 6 | C(6,1) | C(6,2) | C(6,3) | C(6,4) | C(6,5) | **C(6,6)** | | | | | | |
| | 7 | C(7,1) | C(7,2) | C(7,3) | C(7,4) | **C(7,5)** | | | | | | | |
| | 8 | C(8,1) | C(8,2) | C(8,3) | **C(8,4)** | | | | | | | | |
| | 9 | C(9,1) | C(9,2) | **C(9,3)** | | | | | | | | | |
| | 10 | C(10,1) | **C(10,2)** | | | | | | | | | | |
| | 11 | **C(11,1)** | | | | | | | | | | | |
| | 12 | **C(12,0)** | | | | | | | | | | | |

FIG. 22

Table 18

| Pattern | Num. | Pattern | Num. | Pattern | Num. |
|---|---|---|---|---|---|
| xxxxxxxxxxxx | 460 | 0000xxxxxx0 | 0 | 0000xxx0 | 25 |
| 0xxxxxxxxxxx | 16 | 00000xxxxx0 | 0 | 00000xx0 | 71 |
| xxxxxxxxxxx0 | 119 | 000000xxxx0 | 0 | 000000x0 | 818 |
| 00xxxxxxxxxx | 0 | 0000000xxx0 | 9 | xxxxxx0 | 702 |
| 0xxxxxxxxxx0 | 6 | 00000000xx0 | 46 | 0xxxxx0 | 201 |
| 000xxxxxxxxx | 0 | 000000000x0 | 176 | 00xxxx0 | 100 |
| 00xxxxxxxxx0 | 1 | xxxxxxxxx0 | 378 | 000xxx0 | 80 |
| 0000xxxxxxxx | 0 | 0xxxxxxxx0 | 24 | 0000xx0 | 313 |
| 000xxxxxxxx0 | 0 | 00xxxxxxx0 | 4 | 00000x0 | 1322 |
| 00000xxxxxxx | 0 | 000xxxxxx0 | 4 | xxxxx0 | 2314 |
| 0000xxxxxxx0 | 0 | 0000xxxxx0 | 1 | 0xxxx0 | 583 |
| 000000xxxxxx | 0 | 00000xxxx0 | 3 | 00xxx0 | 314 |
| 00000xxxxxx0 | 0 | 000000xxx0 | 31 | 000xx0 | 545 |
| 0000000xxxxx | 0 | 0000000xx0 | 116 | 0000x0 | 2217 |
| 000000xxxxx0 | 1 | 00000000x0 | 841 | xxxx0 | 2848 |
| 00000000xxxx | 0 | xxxxxxxx0 | 231 | 0xxx0 | 1457 |
| 0000000xxxx0 | 1 | 0xxxxxxx0 | 41 | 00xx0 | 1033 |
| 000000000xxx | 0 | 00xxxxxx0 | 13 | 000x0 | 3108 |
| 00000000xxx0 | 2 | 000xxxxx0 | 6 | xxx0 | 4113 |
| 0000000000xx | 5 | 0000xxxx0 | 4 | 0xx0 | 4139 |
| 000000000xx0 | 5 | 00000xxx0 | 4 | 00x0 | 4662 |
| 00000000000x | 173 | 000000xx0 | 75 | xx0 | 7918 |
| 0000000000x0 | 76 | 0000000x0 | 784 | 0x0 | 13629 |
| xxxxxxxxxx0 | 203 | xxxxxxx0 | 351 | x0 | 12380 |
| 0xxxxxxxxx0 | 16 | 0xxxxxx0 | 84 | skip | 8363 |
| 00xxxxxxxx0 | 1 | 00xxxxx0 | 44 | E0B | 28001 |
| 000xxxxxxx0 | 0 | 000xxxx0 | 41 | | |

FIG. 23

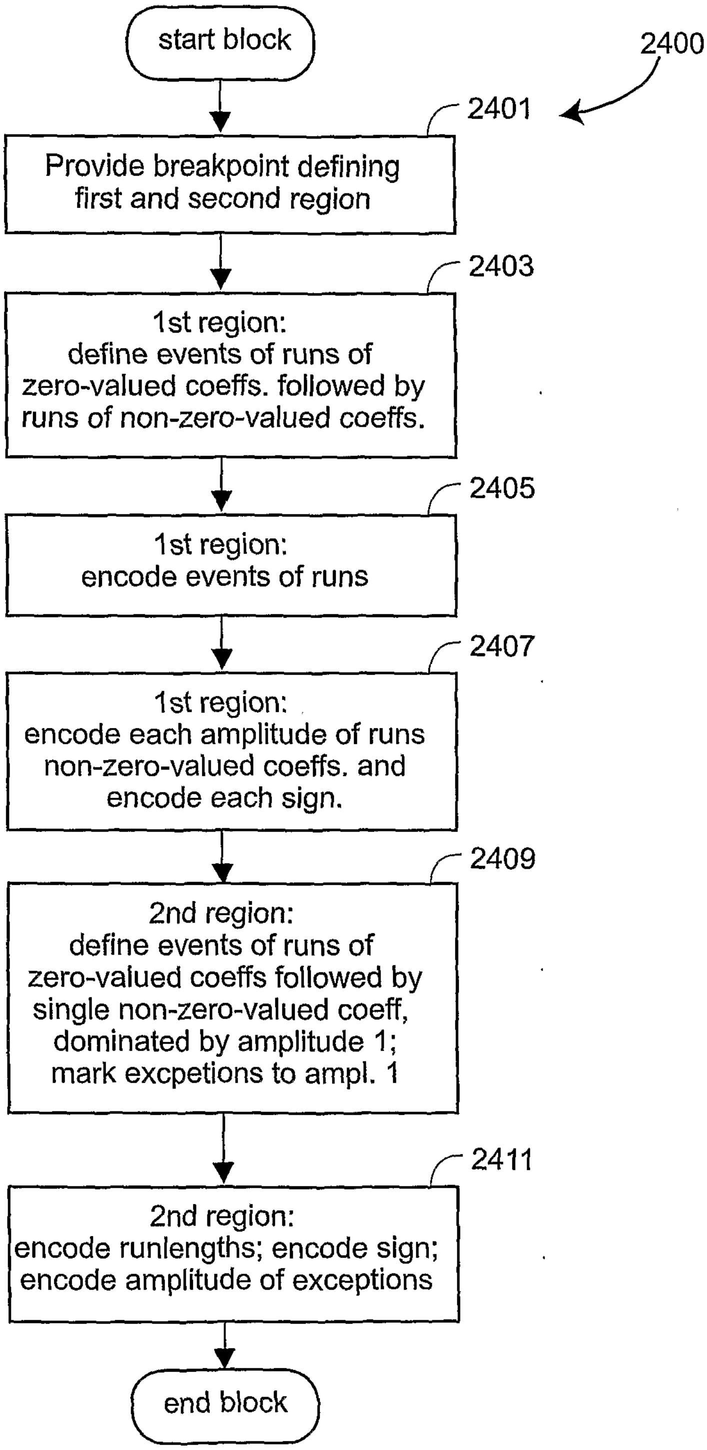
2400
start block
2401
Provide breakpoint defining first and second region
2403
1st region:
define events of runs of zero-valued coeffs. followed by runs of non-zero-valued coeffs.
2405
1st region:
encode events of runs
2407
1st region:
encode each amplitude of runs non-zero-valued coeffs. and encode each sign.
2409
2nd region:
define events of runs of zero-valued coeffs followed by single non-zero-valued coeff, dominated by amplitude 1; mark excpetions to ampl. 1
2411
2nd region:
encode runlengths; encode sign; encode amplitude of exceptions
end block

FIG. 24

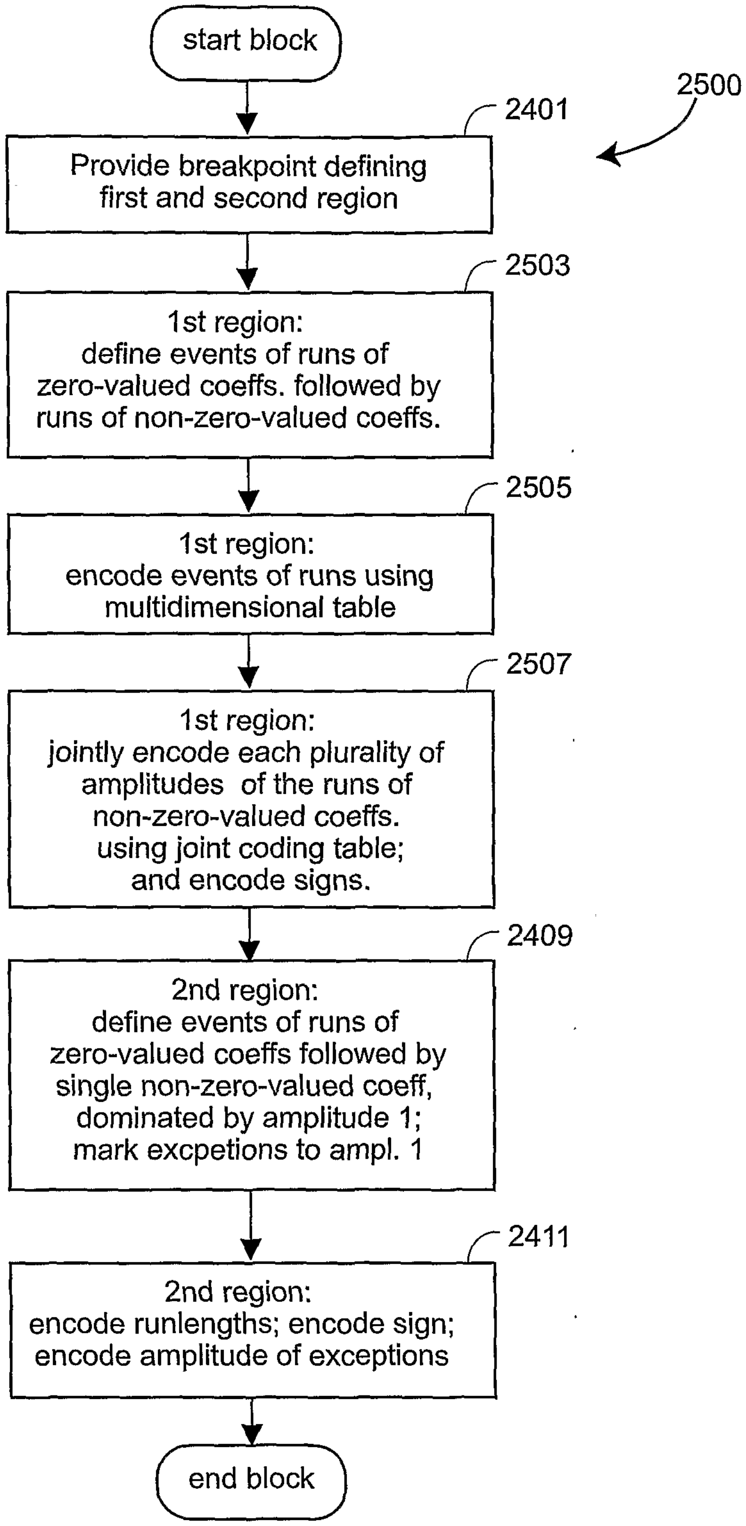
start block
2500
2401
Provide breakpoint defining first and second region
2503
1st region: define events of runs of zero-valued coeffs. followed by runs of non-zero-valued coeffs.
2505
1st region: encode events of runs using multidimensional table
2507
1st region: jointly encode each plurality of amplitudes of the runs of non-zero-valued coeffs. using joint coding table; and encode signs.
2409
2nd region: define events of runs of zero-valued coeffs followed by single non-zero-valued coeff, dominated by amplitude 1; mark excpetions to ampl. 1
2411
2nd region: encode runlengths; encode sign; encode amplitude of exceptions
end block

FIG. 25

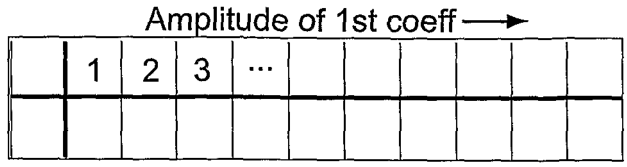


FIG. 26A

2601

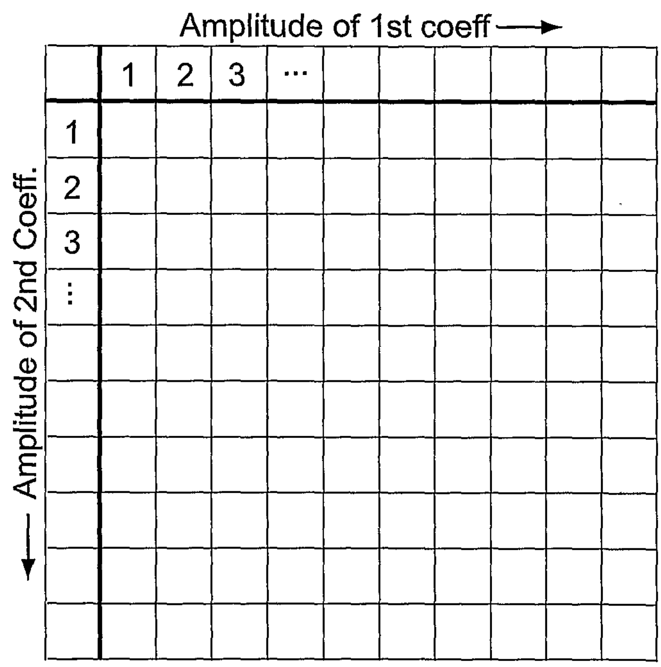


FIG. 26B

2603

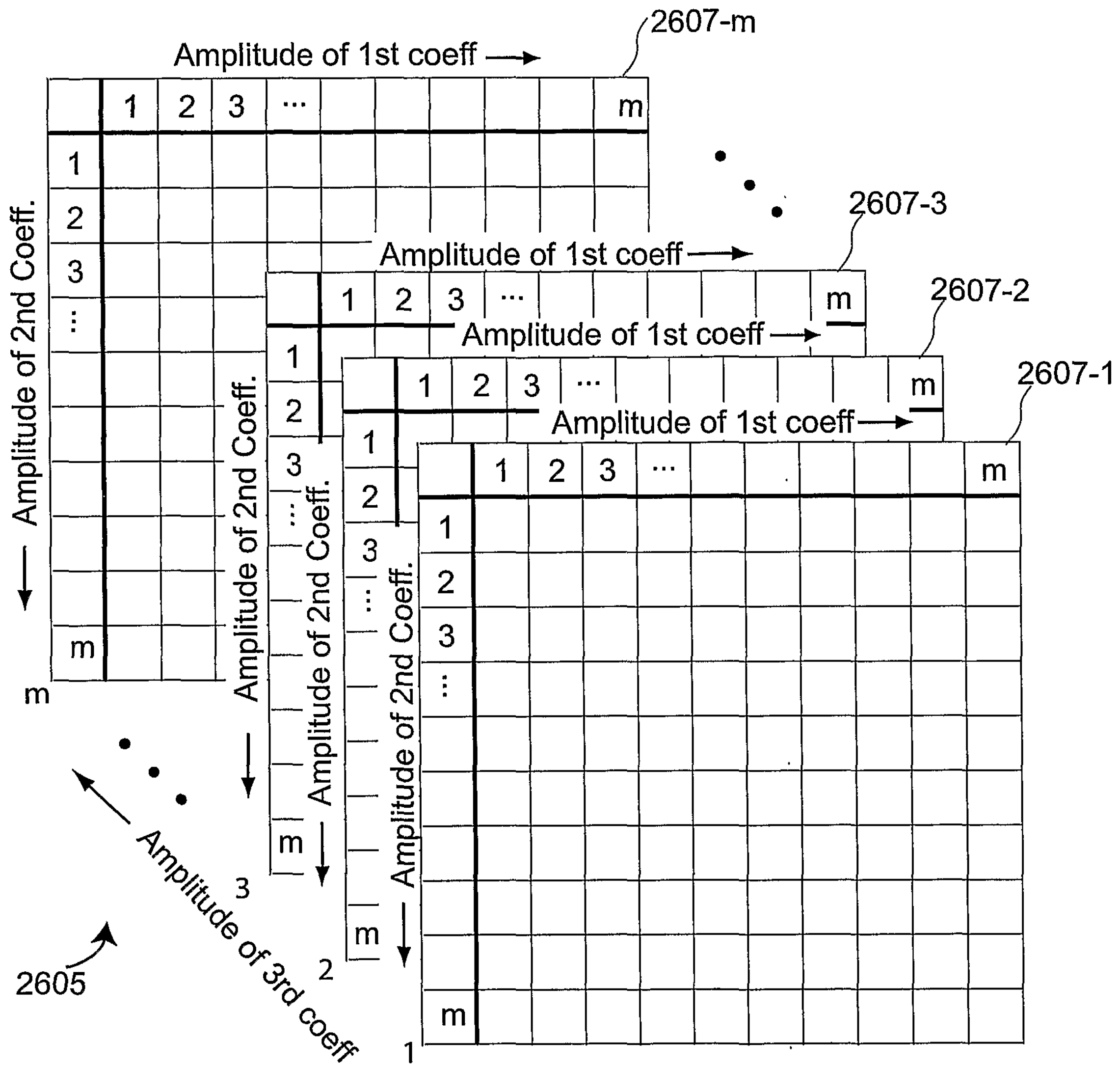
2607-m
Amplitude of 1st coeff
1 2 3 ··· m
1 2 3 ⋮ m
Amplitude of 2nd Coeff.
2607-3
2607-2
2607-1
m
3
2
1
Amplitude of 3rd coeff
2605

FIG. 26C

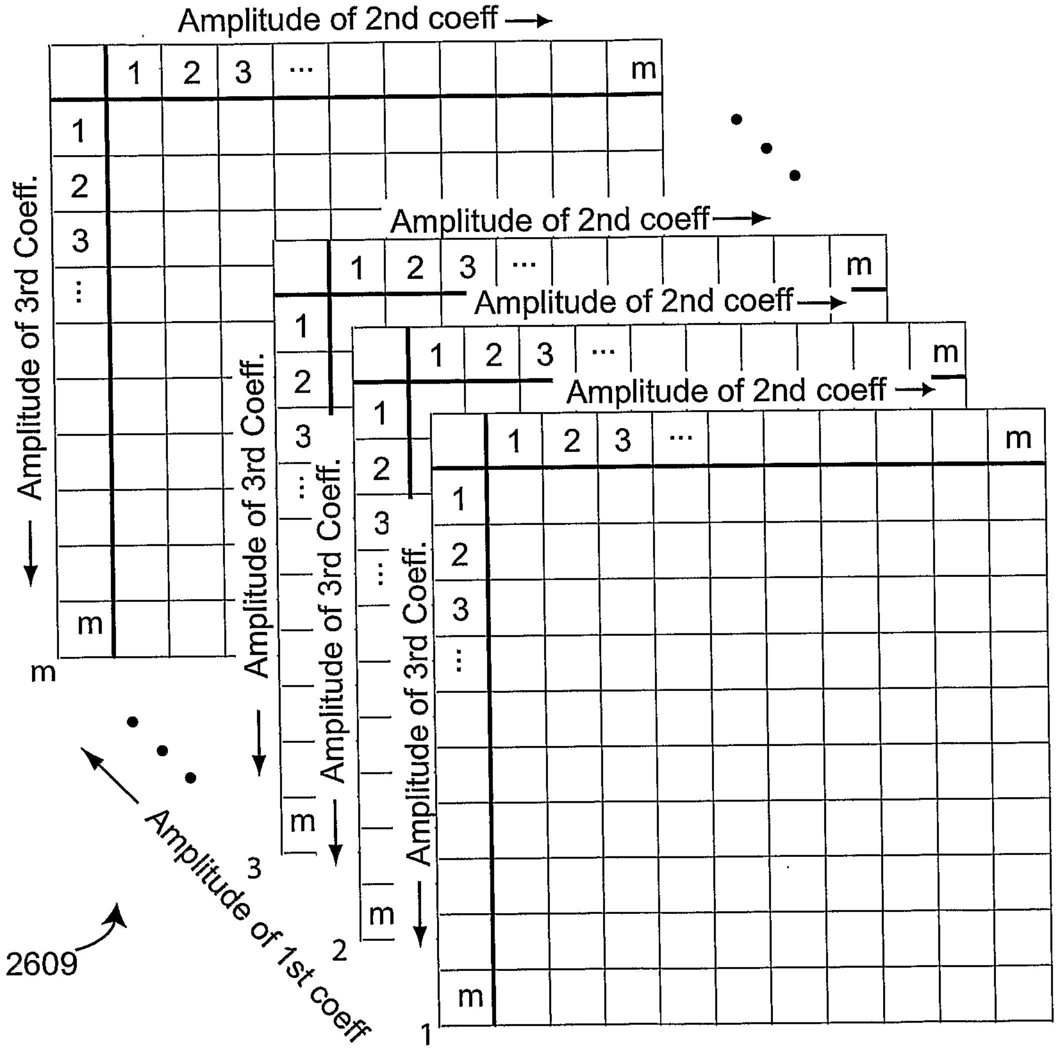
Amplitude of 2nd coeff
1
2
3
...
m
Amplitude of 3rd Coeff.
Amplitude of 1st coeff
1
2
3
m
2609

FIG. 26D

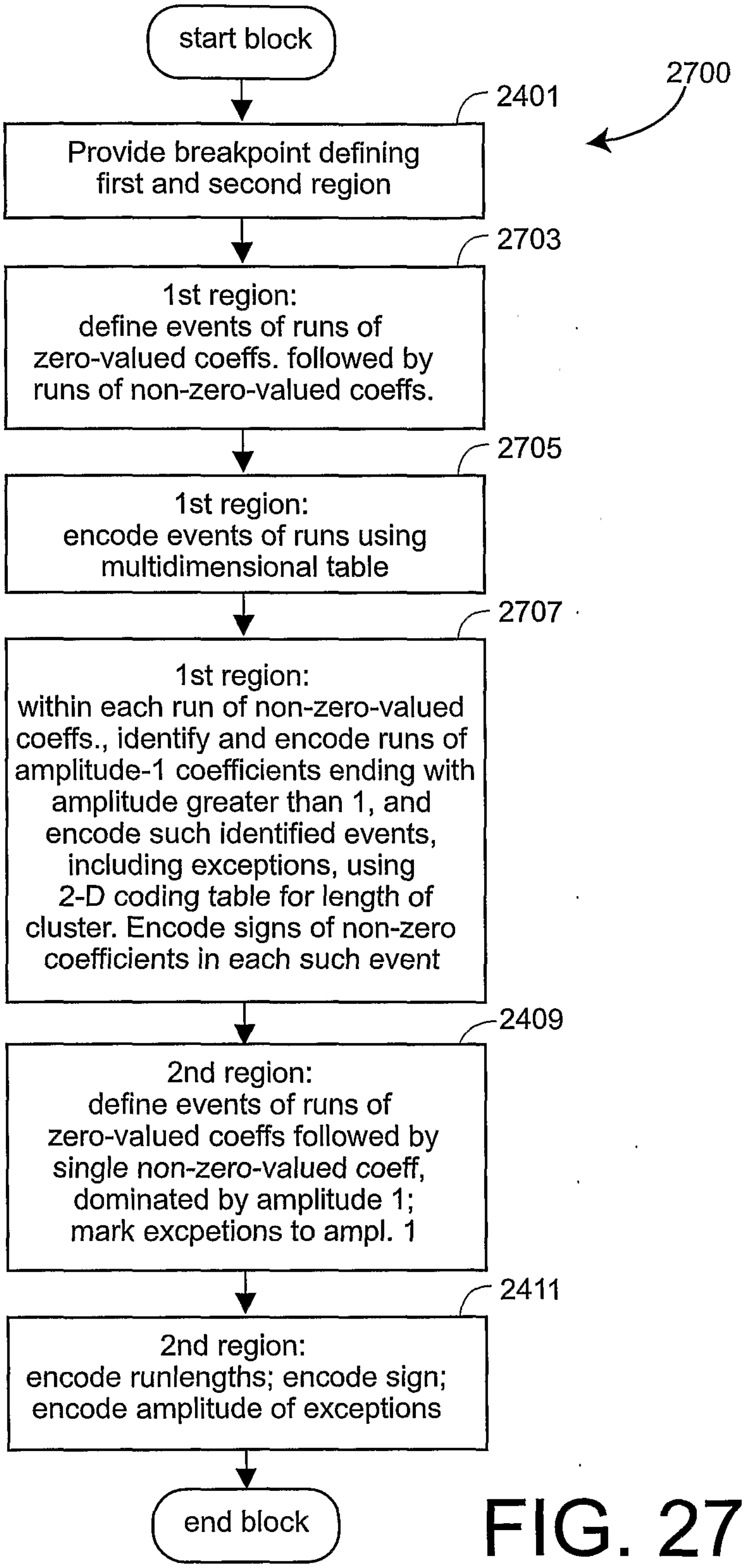
start block
2700
2401
Provide breakpoint defining first and second region
2703
1st region: define events of runs of zero-valued coeffs. followed by runs of non-zero-valued coeffs.
2705
1st region: encode events of runs using multidimensional table
2707
1st region: within each run of non-zero-valued coeffs., identify and encode runs of amplitude-1 coefficients ending with amplitude greater than 1, and encode such identified events, including exceptions, using 2-D coding table for length of cluster. Encode signs of non-zero coefficients in each such event
2409
2nd region: define events of runs of zero-valued coeffs followed by single non-zero-valued coeff, dominated by amplitude 1; mark excpetions to ampl. 1
2411
2nd region: encode runlengths; encode sign; encode amplitude of exceptions
end block

FIG. 27

| | | Coefficient values at the end of the run | | | | | | |
|---|---|---|---|---|---|---|---|---|
| | | 2 | 3 | 4 | 5 | 6 | . | . |
| Runlength of amplitude 1 | 0 | $P_n(0,2)$ | $P_n(0,3)$ | $P_n(0,4)$ | $P_n(0,5)$ | $P_n(0,6)$ | . | . |
| | 1 | $P_n(1,2)$ | $P_n(1,3)$ | $P_n(1,4)$ | $P_n(1,5)$ | $P_n(1,6)$ | . | . |
| | 2 | $P_n(2,2)$ | $P_n(2,3)$ | $P_n(2,4)$ | $P_n(2,5)$ | $P_n(2,6)$ | . | . |
| | . | . | . | . | . | . | . | . |
| | . | . | . | . | . | . | . | . |
| | . | . | . | . | . | . | . | . |
| | n–1 | $P_n(n-1,2)$ | $P_n(n-1,3)$ | $P_n(n-1,4)$ | $P_n(n-1,5)$ | $P_n(n-1,6)$ | . | . |
| | Exc | $P_n$ (Exc) | | | | | | |

FIG. 28

| | | Coefficient values at the end of the run | | | | | | |
|---|---|---|---|---|---|---|---|---|
| | | 2 | 3 | 4 | 5 | 6 | . | . |
| Runlength of amplitude 1 | 0 | $C_n(0,2)$ | $C_n(0,3)$ | $C_n(0,4)$ | $C_n(0,5)$ | $C_n(0,6)$ | . | . |
| | 1 | $C_n(1,2)$ | $C_n(1,3)$ | $C_n(1,4)$ | $C_n(1,5)$ | $C_n(1,6)$ | . | . |
| | 2 | $C_n(2,2)$ | $C_n(2,3)$ | $C_n(2,4)$ | $C_n(2,5)$ | $C_n(2,6)$ | . | . |
| | . | . | . | . | . | . | . | . |
| | . | . | . | . | . | . | . | . |
| | . | . | . | . | . | . | . | . |
| | n–1 | $C_n(n-1,2)$ | $C_n(n-1,3)$ | $C_n(n-1,4)$ | $C_n(n-1,5)$ | $C_n(n-1,6)$ | . | . |
| | Exc | $C_n$ (Exc) | | | | | | |

FIG. 29

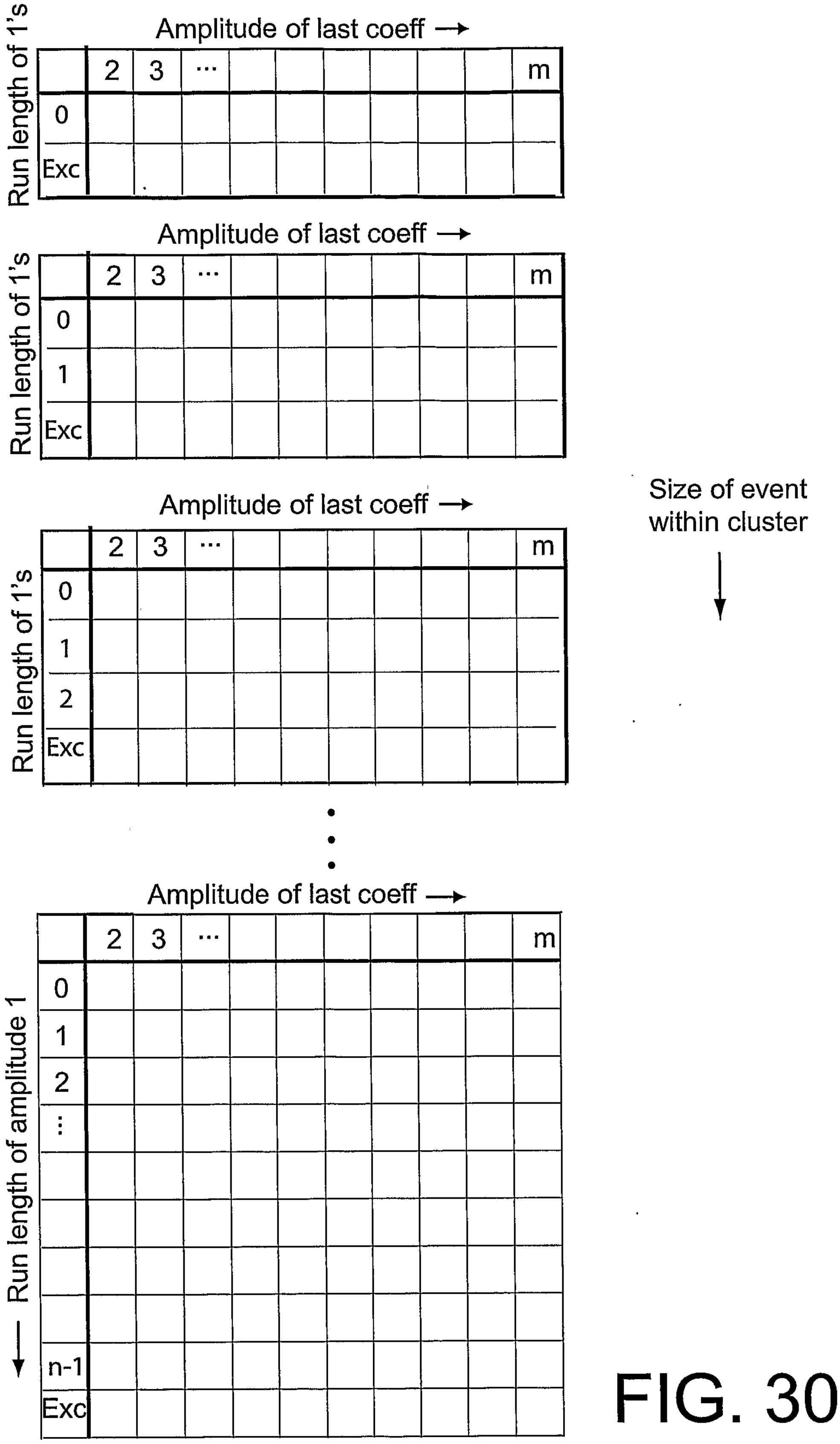
Amplitude of last coeff
Run length of 1's
2
3
...
m
0
Exc
Amplitude of last coeff
Run length of 1's
2
3
...
m
0
1
Exc
Amplitude of last coeff
Run length of 1's
2
3
...
m
0
1
2
Exc
Size of event within cluster
Amplitude of last coeff
Run length of amplitude 1
2
3
...
m
0
1
2
⋮
n-1
Exc

FIG. 30

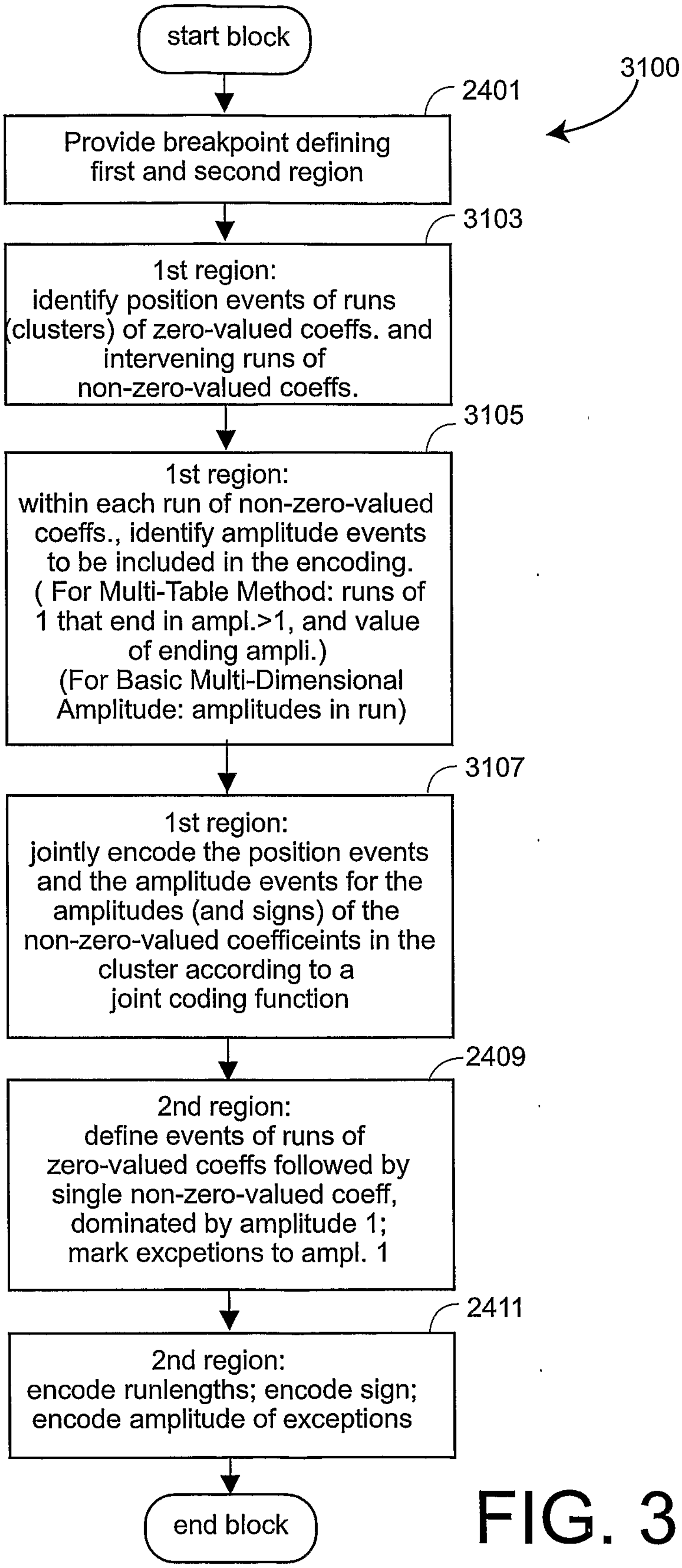
start block
3100
2401
Provide breakpoint defining first and second region
3103
1st region: identify position events of runs (clusters) of zero-valued coeffs. and intervening runs of non-zero-valued coeffs.
3105
1st region: within each run of non-zero-valued coeffs., identify amplitude events to be included in the encoding. ( For Multi-Table Method: runs of 1 that end in ampl.>1, and value of ending ampli.) (For Basic Multi-Dimensional Amplitude: amplitudes in run)
3107
1st region: jointly encode the position events and the amplitude events for the amplitudes (and signs) of the non-zero-valued coefficeints in the cluster according to a joint coding function
2409
2nd region: define events of runs of zero-valued coeffs followed by single non-zero-valued coeff, dominated by amplitude 1; mark excpetions to ampl. 1
2411
2nd region: encode runlengths; encode sign; encode amplitude of exceptions
end block

FIG. 31

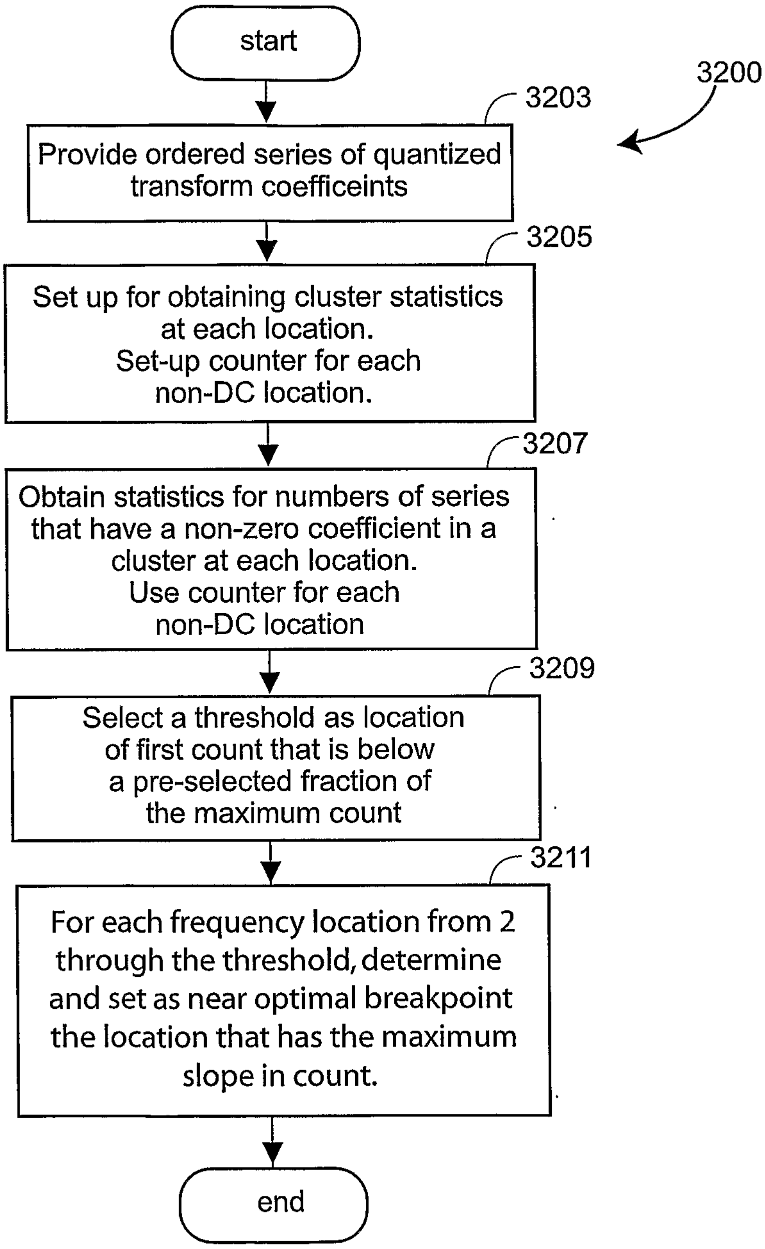
start
3200
3203
Provide ordered series of quantized transform coefficeints
3205
Set up for obtaining cluster statistics at each location.
Set-up counter for each non-DC location.
3207
Obtain statistics for numbers of series that have a non-zero coefficient in a cluster at each location.
Use counter for each non-DC location
3209
Select a threshold as location of first count that is below a pre-selected fraction of the maximum count
3211
For each frequency location from 2 through the threshold, determine and set as near optimal breakpoint the location that has the maximum slope in count.
end

FIG. 32

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4698672 A, Wen-hsiung Chen
- WO 9318616 A
- US 34253703 A, Chen
- US 5640420 A


### Non-patent literature cited in the description


- **HARTUNG.** Improved Encoding of DCT Coefficients for Low Bit-rate Video Coding Using Multiple VLC Tables. *IEEE*
- **APOSTOLOPOULOS J.** Position-dependent encoding. *IEEE*
- **REED.** Efficient coding of DCT coefficients by joint position-dependent encoding. *IEEE*
- **JEON.** Huffman coding of DCT coefficients using dynamic codeword assignment and adaptive codebook selection. *IEEE*